(19) Europäisches Patentamt
European Patent Office
Office européen des brevets

(11) **EP 3 238 210 B1**

(12) **FASCICULE DE BREVET EUROPEEN**

(45) Date de publication et mention de la délivrance du brevet:
**07.08.2019 Bulletin 2019/32**

(51) Int Cl.:
**G10L 25/84** (2013.01)  **G10L 25/18** (2013.01)
**G01R 23/16** (2006.01)  **G01R 23/167** (2006.01)

(21) Numéro de dépôt: **15832686.8**

(86) Numéro de dépôt international:
**PCT/EP2015/081128**

(22) Date de dépôt: **23.12.2015**

(87) Numéro de publication internationale:
**WO 2016/102651 (30.06.2016 Gazette 2016/26)**

(54) **PROCEDE DE TRAITEMENT ET D'ANALYSE D'UN SIGNAL, ET DISPOSITIF METTANT EN OEUVRE LEDIT PROCEDE**

VERFAHREN ZUR VERARBEITUNG UND ANALYSE EINES SIGNALS UND VORRICHTUNG ZUR IMPLEMENTIERUNG DIESES VERFAHRENS

METHOD FOR PROCESSING AND ANALYSING A SIGNAL, AND DEVICE IMPLEMENTING SAID METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.12.2014 BE 201405159**

(43) Date de publication de la demande:
**01.11.2017 Bulletin 2017/44**

(73) Titulaire: **Reza, Yves, Jean-Paul, Guy 2036 Cormondreche (CH)**

(72) Inventeur: **Reza, Yves, Jean-Paul, Guy 2036 Cormondreche (CH)**

(74) Mandataire: **Cabinet Plasseraud 66, rue de la Chaussée d'Antin 75440 Paris Cedex 09 (FR)**

(56) Documents cités:
**EP-A2- 2 603 862     US-A- 5 214 708**

- **LYONS R.G: "UNDERSTANDING DIGITAL SIGNAL PROCESSING - Third Edition", 2011, Prentice Hall, XP002742262, ISBN: 9780137027415 pages 462-464,479-498,749-753, cité dans la demande page 462, alinéa 8.9 - page 464 page 479, alinéa 9. - page 498 page 749, alinéa 13.19 - page 753**
- **G. EVANGELOPOULOS ET AL: "Multiband Modulation Energy Tracking for Noisy Speech Detection", IEEE TRANSACTIONS ON AUDIO, SPEECH AND LANGUAGE PROCESSING, vol. 14, no. 6, 1 novembre 2006 (2006-11-01), pages 2024-2038, XP055202267, ISSN: 1558-7916, DOI: 10.1109/TASL.2006.872625**
- **REILLY A ET AL: "An efficient algorithm for analytic signal generation for time-frequency distributions", PROCEEDINGS OF ICASSP '94. IEEE INTERNATIONAL CONFERENCE ON ACOUSTICS, SPEECH AND SIGNAL PROCESSING, vol. iii, 19 avril 1994 (1994-04-19), - 22 avril 1994 (1994-04-22), pages III/165-III/168, XP010134253, ADELAIDE, SA, AUSTRALIA, IEEE SERVICE CENTER, PISCATAWAY, NJ DOI: 10.1109/ICASSP.1994.390064 ISBN: 978-0-7803-1775-8**

**Description**

**DOMAINE TECHNIQUE**

La présente invention est relative à un procédé de traitement d'un signal initial pour fournir des signaux d'analyse, à un procédé d'analyse d'un signal initial pour fournir des paramètres de fréquences analysées, et à des dispositifs adaptés pour mettre en oeuvre l'un ou l'autre desdits procédés.

**ETAT DE LA TECHNIQUE ANTERIEURE**

Les procédés d'extractions d'informations à partir de signaux possédant une grande richesse d'information, tels que les signaux audio (signaux musicaux et signaux vocaux notamment) présentent une importance croissante. Ils sont notamment utilisés dans un nombre croissant d'applications telles que par exemple: reconnaissance vocale, analyse de signaux musicaux, détection en téléphonie de signaux de service en présence de signaux vocaux (DTMF dans la littérature anglo saxonne).

Plus précisément, ces applications comprennent une étape d'extraction d'informations de fréquence (typiquement: amplitude et évolution de l'amplitude pour des bandes étroites de fréquence extraites du signal), suivies d'étapes de reconnaissance ou d'identification faisant intervenir, souvent à titre principal, ces informations relatives aux fréquences contenues dans de tels signaux.

Cependant, on considère généralement qu'il y a nécessairement un compromis à réaliser entre détermination avec une bonne précision des fréquences contenues dans le signal d'une part, et d'autre part la détermination avec un bonne précision des instants d'apparition et de disparition des différentes fréquences contenues dans le signal à étudier.

D'autres signaux, de fréquence plus élevée, tels que les signaux ultrasonores ou les signaux radio à large bande peuvent aussi posséder une grande richesse d'information et bénéficier des mêmes principes techniques de reconnaissance de fréquence que les signaux de type vocal.

Dans ce contexte, la nature et la richesse des informations recueillies au cours de l'extraction des informations relatives aux fréquences contenues dans le signal à étudier jouent un rôle très significatif pour les étapes ultérieure de traitement du signal, qui sont souvent des étapes de reconnaissance ou d'identification de signaux déterminés par leur profil de fréquence et leur profil dans le temps (par exemple les phonèmes en reconnaissance vocale), et donc pour la performance de la totalité de la chaîne de traitement du signal pouvant exister dans de telles applications.

Par exemple, le traitement des signaux audio pour la reconnaissance vocale se fait actuellement principalement au moyen de banques de filtres audio opérant en parallèle (selon le principe du « vocoder » selon la terminologie anglo saxonne) ou, de manière équivalente, de transformées de Fourier à fenêtre (c'est-à-dire opérant sur des signaux préalablement multipliés par une fenêtre). Le signal audio peut avoir fait l'objet de filtrages visant à éliminer ou à rehausser des fréquences, afin d'opérer sur la partie de la bande de fréquences audio qui contient l'essentiel des informations permettant la reconnaissance vocale ou l'identification de la source, c'est-à-dire une bande de fréquences comprenant la bande de fréquence allant de 300 Hz à 3.200 Hz (bande passante pour la téléphonie).

Typiquement, les informations de fréquence obtenues le sont à partir de fenêtres de temps dont la durée est de l'ordre de 10 à 20 millisecondes, durée pendant laquelle les signaux audio sont supposés être stationnaires (ou quasi stationnaires).

Cette hypothèse de stationnarité ou de quasi-stationnarité est dans l'ensemble respectée, mais empêche de bien voir les transitions entre périodes durant lesquelles le signal est stationnaire (ou quasi stationnaire).

Dans le cas d'analyse de signal la Transformée de Fourier Glissante (TFG), mais aussi par d'autres techniques telles que l'analyse par Ondelettes, il est un fait connu qu'il n'est pas possible de disposer simultanément d'une bonne résolution en temps et d'une bonne résolution en fréquence. De plus, une bonne réjection du bruit est associé à une analyse aussi précise que possible en fréquence.

Il serait donc particulièrement avantageux de disposer d'informations qui soient à la fois précises en temps et en fréquence, et qui permettent aussi de rejeter au maximum le bruit.

**EXPOSE DE L'INVENTION**

L'objet de l'invention est résolu par l'objet des revendications indépendantes 1 et 14.
Des modes de réalisation préférés sont définis par l'objet des revendications dépendantes.

**REFERENCES RELATIVES A L'INVENTION**

Dans le domaine du traitement du signal, et en relation avec l'invention on peut citer les références suivantes:

Référence 1. Richard G. Lyons "Understanding Digital Signal Processing" Third édition, 2011, Prentice Hall éditeur,

Référence 2. Jae S. Lim et Allan V. Oppenheim Eitors "Advanced Topics in Signal Processing", Prentice Hall éditeur, 1988 et 1989, et en particulier le chapitre 6 «Short Time Fourier Transform», (auteurs: Nawab et Quatieri)

Référence 3. Demande PCT/BE2011/000052 du 12/08/2011 « Procédé d'Analyse de signaux fournissant des fréquences instantanées et des transformées de Fourier Glissantes et dispositif d'analyse de signaux »

Référence 4. Boualem Boashash "Estimating and Interpreting the Instantaneous Frequency of a Signal---Part 1: Fundamentals" Proceedings of the IEEE Vol 80, No 4, April 1992 Pages 520-538

Référence 5. Sylvain Marchand, Philippe Depaille "Generalization of the derivative analysis method to non stationary sinusoidal modeling" Proceedings of the 11th conférence of Digital Audio Effects (DAFx-08), Septembre 2008

Référence 6. Sylvain Marchand "The simplest analysis method for non stationary sinusoidal modeling" Proceedings of the 15th conférence of Digital Audio Effects (DAFx-12), Septembre 2012

Référence 7. François Auger, Eric Chassande Motin, Patrick Flandrin, "On Phase Magnitude Relationships in the Short Time Fourier Transform" IEEE Signal Processing Letters Vol 6, No 1, January 2012.

Référence 8. Lawrence Rabiner, Ronald Crochiere "A novel implementation for Narrow band FIR digital filters" IEEE Transactions on Acoustics, Speech and Signal Processing Vol ASSP-23, No 5, October 1975.

Référence 9. Article Wikipedia "Pitch Détection Algorithm", dernière mise à jour de la page le 24 février 2014.

Référence 10. Thomas F. Quatieri, "Discrete Time Speech Signal Processing", Prentice Hall éditeur, 2002. Référence 11. Frederic J. Harris "On the use of Windows for Harmonic Analysis with the Discrète Fourier Transform" Proceedings of the IEEE Vol 66, No 1, January 1978 Pages 51-83.

Référence 12. Boualem Boashash "Estimating and Interpreting the Instantaneous Frequency of a Signal---Part 2: Algorithns and Applications" Proceedings of the IEEE Vol 80, No 4, April 1992 Pages 540-568

Référence 13. James B. Tsui "Digital techniques for wideband receivers" 2004 édition, 2011, SciTech Publishing éditeur, en particulier les sections 10.6 et 10.7

## BREVE DESCRIPTION DES FIGURES

D'autres caractéristiques et avantages de l'invention apparaîtront au cours de la description qui va suivre, donnée à titre d'exemple non limitatif, en références aux figures annexées dans lesquelles:

La Figure 1 montre une vue d'ensemble de l'invention.

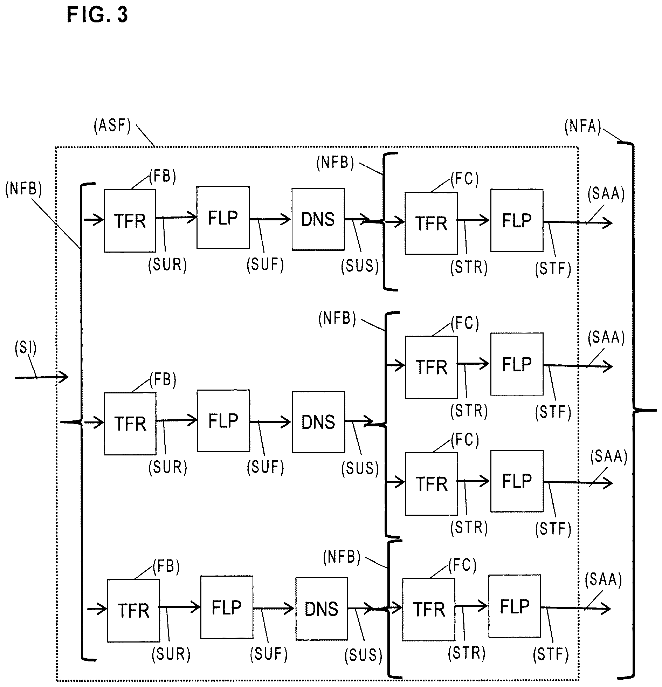

Les Figures 2 à 6 montrent des schémas blocs décrivant divers aspects du fonctionnement de l'invention.
La Figure 7 montre le signal étudié à titre d'exemple, avant toute opération de sous-échantillonnage.
La Figure 8 montre le signal étudié à titre d'exemple, sans bruit ajouté, après sous-échantillonnage.
La Figure 9 montre le signal étudié à titre d'exemple, avec bruit ajouté, après sous-échantillonnage.
La Figure 10 montre la disposition des signaux et paramètres étudiés, avec en regard la désignation des paramètres.
La Figure 11 montre les observations faites avec un signal d'amplitude constante et modulé linéairement en fréquence (chirp linéaire).
Les Figures 12 à 15 montrent des observations faites avec l'invention sur le signal présenté dans les Figures 7 et 8.
La Figure 16 indique la réponse fréquentielle d'une Transformée de Fourier importante pour l'invention, considérée comme un filtre fréquentiel
La Figure 17 indique la réponse fréquentielle d'un filtre différentiateur et d'un filtre intégrateur utilisés dans l'invention
La Figure 18 indique la réponse impulsionnelle du filtre décrit en Figure 16, et utilisé avec un avec un filtre différentiateur et un filtre intégrateur
La Figure 19 indique la réponse à une marche du filtre décrit en Figure 16, utilisé avec un filtre différentiateur et un filtre intégrateur
La Figure 20 montre les amplitudes comparées d'un signal sinusoïdal et d'un signal de bruit en entrée du procédé
Les Figures 21 à 30 montrent les réponses du procédé selon l'invention à divers signaux en entrée

## DESCRIPTION DES SIGNAUX UTILISES ET METHODES ANTERIEURES

En ce qui concerne les signaux électriques que l'invention peut traiter, on constate que les signaux audio sont un cas particulier de signaux électriques générés par un capteur (CA) et représentatifs d'ondes physiques se propageant dans un milieu physique. A titre d'exemple de telles ondes on peut citer : les ondes acoustiques, les ondes électromagnétiques, les ondes sismiques, les ondes ultra sonores, les ondes sonores dans un milieu autre que l'air (eau, corps humain ou animal).

### a) Limitations des méthodes actuelles (antérieures)

Les analyses temps-fréquence traditionnelles, telles que le spectrogramme traditionnellement associé à la transformée de Fourier à fenêtre, ou Transformée de Fourier Glissante (TFG) («Short Time Fourier Transform» dans la littérature anglo saxonne) se heurtent souvent à des limites dans le traitement des signaux non-stationnaires: ils permettent de bien modéliser les signaux stationnaires, mais se heurtent à des problèmes pour traiter les parties transitoires. Ces liéitations sont d'autant plus fortes que le rapport signal sur bruit (SNR « Signal to Noise Ratio » dans la littérature anglo saxonne) est défavorable et le niveau de bruit important.

La transformée de Fourier standard, en effet, introduit des limitations qui font qu'il n'est pas possible d'avoir simultanément une bonne résolution en temps et une bonne résolution en fréquence. Par exemple, avec une fenêtre de temps d'une durée de 3 à 4 millisecondes, la résolution en fréquence est au mieux de 300 Hz ou 250 Hz respectivement. On constate ainsi que les vues temps fréquence (appelées généralement «spectrogrammes») manquent de netteté et de précision.

D'une manière générale, avec les fenêtres temporelles usuelles, la résolution temporelle est d'autant meilleure que la durée de la fenêtre est courte et la résolution temporelle est d'autant meilleure que la durée de la fenêtre est longue.

La même limitation existe avec d'autres techniques, et notamment les ondelettes («wavelets» dans la littérature anglo saxonne).

A titre d'exemple, une fenêtre temporelle de l'ordre de 20 millisecondes est souvent utilisée pour l'étude des signaux vocaux car elle représente un compromis souvent acceptable entre les différentes contraintes d'analyse et de représentation du signal. Avec une fréquence d'échantillonnage de 8 Khz, correspondant à la voix téléphonée, on utilise donc une fenêtre temporelle de l'ordre de 160 échantillons et chaque canal de la Transformée de Fourier utilisée réalise donc une analyse en bande étroite du signal de parole.

### b) Les supports de calculs préférentiels pour l'invention

La présente invention a notamment pour but de permettre de réaliser sur des plates-formes de calcul (PC) particulièrement économiques des traitements du signal particulièrement performants qui nécessitaient jusqu'à présent des plates formes de calcul peu économiques.

Les plates-formes de calcul particulièrement visées par la présente invention sont les suivantes:

a) Composants logiques programmables (« FPGA » dans la littérature anglo saxonne), en particulier mais de manière non exclusive les FPGA à faible coût, qui travaillent avec des fréquences d'horloge de l'ordre de 100 Mhz
b) Circuits intégrés dédiés (« ASIC » dans la littérature anglo saxonne)

On remarquera que ces plates formes de calcul permettent de réaliser des systèmes autonomes et embarqués, par exemple alimentés par piles ou accumulateurs électriques.

Par ailleurs, ces plates formes ont des fréquences de travail très élevées (des fréquences d'horloge de plusieurs dizaines de Mhz ou plus), mais ne sont pas dotées en standard de possibilités de calculs en virgule flottante. Il est toujours possible de réaliser des calculs en virgule flottante sur ces plates-formes, mais ce type de calcul est très consommateurs en ressources (en temps ou en surface de circuit utilisée).

En conséquence, la solution habituellement utilisée est d'effectuer les calculs en virgule fixe. Toutefois, dans la plupart des cas, il s'ensuit une perte de précision numérique significative.

La liste précédente de plates-formes est donnée à titre indicatif et d'autres types de plates formes de calcul peuvent aussi être utilisés.

### c) Les principaux types de signaux concernés par l'invention

L'invention permet notamment de traiter d'une manière particulièrement avantageuse les signaux présentant divers types de modulation (modulations d'amplitude et de fréquence combinées) et des modulations variant dans le temps.

Ces signaux incluent donc les signaux vocaux ou audio (qui sont échantillonnés, suivant les applications, à des fréquences variant typiquement de 8 Khz (téléphonie) à 96 Kz (haute-fidélité professionnelle).

Des signaux de toutes natures, provenant par exemple de capteurs médicaux (sons relatifs au corps notamment) ou industriels, dont la fréquence est comparable ou inférieure à celle des signaux audio peuvent être traités avantageusement par l'invention, ainsi que des signaux dont la fréquence est supérieure à celle des signaux audio (signaux ultra sonores ou signaux radio notamment).

La liste précédente de types de signaux est donnée à titre d'exemple et d'autres types de signaux pourront faire l'objet de traitements dans le cadre de l'invention.

**DESCRIPTION DETAILLEE DE L'INVENTION**

Sur les différentes figures, on a conservé les mêmes références pour désigner des éléments identiques ou similaires.

### 1) Objectif général de l'invention

Le procédé selon l'invention a pour objectif d'utiliser un type particulier de signaux, les signaux d'analyse (SAA) ou les signaux d'analyse à bande large (SAL), pour détecter avec une probabilités significative, la présence ou l'absence d'un signal et de ses différents types de modulation (en amplitude et en fréquence), avec une bonne résolution temporelle, avec une bonne résolution fréquentielle et de manière résistante au bruit.

La détection d'informations dans un milieu significativement bruité pose classiquement les problèmes suivants:

P1) Meilleure séparation possible du signal utile d'une part et du bruit ajouté d'autre part
P2) Meilleure estimation possible du niveau de bruit présent
P3) Évitement maximum des faux positifs (signal détecté alors qu'il est absent), avec si possible des indicateurs représentatifs à chaque instant de la probabilité d'existence d'un faux positif
P4) Même problème que P3 pour les faux négatifs (absence de détection du signal alors qu'il est présent)

Les descriptions techniques qui suivent montrent comment la présente invention répond à ces problèmes.

### 2) Vue d'ensemble de l'invention

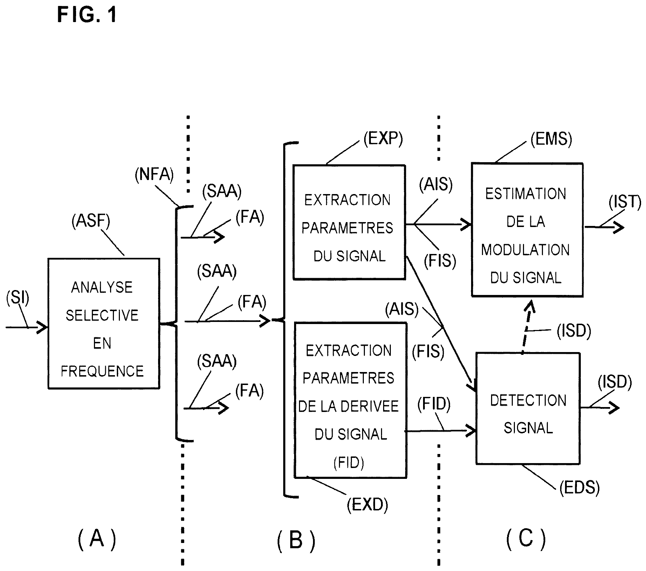

La Figure 1 présente une vue d'ensemble de l'invention. On y distingue 3 grandes parties dénommées (A), (B) et (C). Le traitement du signal initial (SI) est réalisé en passant successivement dans les parties dénommées (A), (B) et (C).

Les parties (B) et (C) permettent de définir deux variantes principales dans le traitement du signal initial (SI) .

Dans tous les cas, la première étape (partie (A)) est l'étape (ASF) d'analyse sélective en fréquence, qui fournit en sortie une pluralité (NFA) de signaux d'analyse (SAA), de type monocomposant à large bande et à auto interférence limitée, avec un tel signal pour chaque fréquence analysée (FA) de ladite pluralité (NFA).

Ces signaux d'analyse (SAA), de type monocomposant à large bande et à auto interférence limitée, présentent, comme il sera vu ultérieurement, plusieurs propriétés avantageuses qui facilitent significativement les étapes ultérieures du traitement du signal initial (SI).

La partie (B) correspond à l'extraction de paramètres de ces signaux d'analyse (SAA), ces paramètres étant des informations de phase et d'amplitude instantanées calculées pour chaque échantillon desdits signaux d'analyse (SAA). Les opérations (EXP) d'extraction de paramètres du signal (PAS) fournissent l'Amplitude instantanée (AIS) et la Fréquence instantanée (FIS) des signaux d'analyse (SAA), et les opérations (EXD) d'extraction de paramètres de la dérivée temporelle du signal (PAD) fournissent en plus la Fréquence instantanée (FID) du signal dérivé (SAD) égal à la dérivée temporelle d'un signal d'analyse (SAA).

Il existe plusieurs méthodes pour obtenir l'Amplitude instantanée (AIS) d'un signal. Toutefois, pour obtenir cette information à partir d'un signal d'analyse (SAA), il est particulièrement avantageux d'utiliser la méthode décrite dans la Référence 3. Demande PCT/BE2011/000052 du 12/08/2011 car son principe n'implique aucune opération supplémentaire de filtrage.

La partie (C) correspond à des opérations de détection de modulations particulières présentes dans le signal d'analyse (SAA), et d'une opération plus générale de détection de la présence d'un tel signal d'analyse (SAA).

Les opérations d'estimation de la modulation du signal (EMS) déterminent chacune sur une durée d'observation de (DOB) échantillons du signal initial (SI) la présence de types de modulation spécifiques:

a) Une modulation d'amplitude de type sinusoïdal peut être détectée en observant que deux paramètres issus des paramètres extraits par les opérations (EXP) d'extraction de paramètres (PAS) du signal d'analyse (SAA) sont en quadrature (une définition précise de ce terme sera donnée ultérieurement)
b) Une modulation d'amplitude de type exponentiel peut être détectée en observant qu'un autre paramètre issu des paramètres extraits par les opérations (EXP) d'extraction de paramètres (PAS) du signal d'analyse (SAA) est constant
c) La localisation des pics de modulation d'amplitude peut être détectée en observant les pics d'amplitude d'un autre paramètre issu des paramètres extraits par les opérations (EXP) d'extraction de paramètres (PAS) du signal d'analyse (SAA)
d) Une modulation de fréquence peut être détectée en observant qu'un autre paramètre issu des paramètres extraits par les opérations (EXP) d'extraction de paramètres (PAS) du signal d'analyse (SAA) varie dans le temps
e) Une modulation de fréquence à amplitude constante peut être détectée en comparant un autre paramètre issu des paramètres extraits par les opérations (EXP) d'extraction de paramètres du signal (PAS) avec un un paramètre extrait par les opérations (EXD) d'extraction de paramètres (PAD) du signal dérivé (SAD)

f) La présence ou l'absence d'un signal a priori quelconque peut être détectée en utilisant en plus de paramètres extraits par les opérations (EXP) d'extraction de paramètres (PAS) du signal d'analyse (SAA) un paramètre extrait par les opérations (EXD) d'extraction de paramètres du signal dérivé (PAD), après s'être assuré que le signal ne présente pas une modulation d'amplitude de type exponentiel, y compris ses cas limite, ou n'est pas une signal modulé en fréquence et d'amplitude constante (les justifications mathématiques seront fournies ultérieurement)

Les indicateurs précédents sont disponibles pour chaque nouvel échantillon (SAE) d'un signal d'analyse (SAA) et sont relatifs à une durée d'observation de (DOB) échantillons du signal initial (SI). Pour améliorer la fiabilité des observations, il peut être avantageux d'observer l'évolution des indicateurs précédents sur une durée (DMC) de mise en cohérence des indicateurs, égale par exemple à 3 ou 5 fois la durée d'observation de (DOB) échantillons du signal initial (SI), en observant notamment:

a) l'évolution dans le temps de chaque indicateur (sur quelle durée l'indicateur reste-t-il sensiblement constant?)
b) les évolutions significatives conjointes dans le temps de plusieurs indicateurs (des indicateurs présentent-ils des variations significatives au même moment?)

Par ailleurs, et sauf indications contraire, dans le cadre de l'invention:

a) Les signaux sont des signaux complexes, avec des dérivées temporelles effectuées indépendamment sur la partie réelle et la partie imaginaire
b) Les paramètres (amplitude et phase, ainsi que leurs dérivées temporelles et les logarithmes) sont des quantités réelles

le signal initial (SI) peut être réel ou complexe. S'il est réel, tout signal généré par translation de fréquence de ce signal vers la fréquence nulle (F0) pourra, suivant les cas, être réel ou complexe, tout signal généré par translation de fréquence de ce signal vers une autre fréquence sera complexe.

### 3) Les signaux d'analyse (SAA), de type monocomposant à large bande et à auto interférence limitée

Il est habituel de modéliser une grande gamme de signaux physiques, en dehors des périodes transitoires, comme une somme de signaux sinusoïdaux possédant à la fois une modulation d'amplitude et une modulation de fréquence. Avec cette optique, on pourra donc considérer que le signal utile (SU) est composé de signaux élémentaires (SEL) de fréquence centrale identique ou proche d'une fréquence analysée (FA) et ayant une largeur de bande effective (SEB), correspondant par exemple à la largeur de bande qui contient 90% de l'énergie du signal élémentaire (SEL).

Un signal d'analyse (SAA), de type monocomposant à large bande et à auto interférence limitée, présente les carac-téristiques suivantes, particulièrement avantageuses pour l'analyse d'un signal utile (SU) composé d'une somme de signaux élémentaires (SEL), chaque signal élémentaire (SEL) ayant une largeur de bande effective (SEB):

(SAA1) : il est essentiellement monocomposant, c'est à dire modélisable comme une seule sinusoïde modulée potentiellement à la fois en temps et en fréquence. A ce titre sa fréquence instantanée est toujours du même signe. En pratique, il suffira que dans le spectre de fréquences d'un signal d'analyse (SAA),
(SAA2) : il est à large bande, c'est à dire que son spectre occupe une partie importante (plus d'un tiers et possiblement plus de la moitié) de la totalité du spectre disponible après le traitement qui a permis de générer le signal d'analyse (SAA). A ce titre, les informations de phase et de fréquence instantanées ont une dynamique importante, qui leur permet notamment de bien ressortir du bruit ajouté (BRA) pouvant exister et être important
(SAA3) : il est à auto interférence limitée, c'est à dire que au cours de son élaboration à partir du signal initial (SI), il n'a que peu interféré avec lui-même, et en particulier il n'a pas fait l'objet de moyennes ou de filtrages longs (c'est à dire portant sur un nombre important d'échantillons), sauf s'ils sont suivis par une opération qui permette de «casser» cette interférence avec lui-même, par exemple une opération de sous-échantillonnage.

Les caractéristiques (SAA1) et (SAA2) garantissent dans le cadre de l'invention des informations de phase et de fréquences instantanées particulièrement simples à traiter et à interpréter. La caractéristique (SAA3) garantit que ces informations de phase et de fréquences instantanées seront représentatives de celles du du signal initial (SI) dans la bande de fréquences autour de la fréquence analysée (FA).

Alternativement, en conséquence des points précédents, on peut aussi dire que le traitement qui permet de passer du signal initial (SI) à un signal d'analyse (SAA) correspondant à une fréquence analysée (FA) ne doit pas augmenter, ou très peu augmenter, la durée d'auto-corrélation exprimée en nombre d'échantillons du signal d'analyse (SAA), c'est à dire en nombre d'échantillons après les opérations de sous-échantillonnage.

Le prix à payer pour l'utilisation d'opérations de sous-échantillonnage est une réduction de la précision temporelle. Suivant l'application considérée cette réduction peut présenter des inconvénients, mais elle peut aussi présenter des avantages. On verra en particulier dans les observations sur un signal vocal que cette réduction présente des avantages dans une application dont l'importance pratique est reconnue.

On peut donc résumer de la manière suivante et en termes qualitatifs l'effet des traitements qui convertissent le signal initial (SI) en une pluralité (NFA) de signaux d'analyse (SAA):

> d'un côté on perd en précision temporelle
> de l'autre convertit un signal initial (SI), somme de signaux élémentaires (SEL) non connus, en une pluralité de signaux d'analyse (SAA), faciles à analyser et relativement résistants au bruit (en raison de la bande large), et dont la structure temporelle (avec la précision temporelle réduite) est très voisine de celle du signal élémentaire (SEL) correspondant (en raison de l'auto interférence limitée)

Les informations de fréquence instantanée sont connues pour présenter des difficultés d'interprétation (voir par exemple la Référence 4. Boualem Boashash "Estimating and Interpreting the Instantaneous Frequency of a Signal---Part 1: Fundamentals"). De plus, de manière pratique il semble quelque contradictoire de définir une valeur instantanée, de fréquence ou autre, pour un signal qui est lui-même une moyenne longue ou un filtrage long d'un autre signal.

### 4) La durée d'observation (DOB)

La durée d'observation (DOB) sera de l'ordre de 100 échantillons du signal initial (SI), typiquement entre 100 et 200 échantillons de ce signal initial (SI), durée qui est pertinente dans diverses applications. Dans certaines applications, comme on le verra ci-après, cette durée pourra être supérieure.

Dans le cadre de l'étude du signal vocal on sait qu'il est intéressant d'étudier ce signal en synchronisation avec la fréquence fondamentale (voir Référence 10. Thomas F. Quatieri, "Discrete Time Speech Signal Processing", Prentice Hall éditeur, 2002) et que cette fréquence fondamentale est de l'ordre de 100 Hz pour un homme, 200 Hz pour une femme et jusque 350 Hz chez un enfant. Avec une fréquence d'échantillonnage de 8.000 Hz en téléphonie (application pour laquelle on cherche la fréquence d'échantillonnage la plus basse possible), on retrouve cette valeur de 100 échantillons si l'on veut traiter tous les types de voix. Si la fréquence d'échantillonnage est supérieure à 8.000 Hz, comme en haute-fidélité où elle est supérieure à 40.000 Hz, on pourra augmenter cette durée d'observation (DOB) et/ou sous-échantillonner le signal initial (SI).

En contre-mesures électroniques, on dispose de moins de 5 microsecondes (2 à 3 typiquement) pour identifier le signal radio reçu. En admettant une fréquence intermédiaire de 100 Mhz, on retrouve bien cette durée d'observation (DOB) de 100 à 200 échantillons pour étudier finement le signal reçu.

Par ailleurs, cette durée d'observation (DOB) de 100 à 200 échantillons est compatible avec des modulations numériques typiques pour étudier finement le signal modulé.

### 5) La Transformée de Fourier Glissante (TFG) classique et les signaux d'analyse (SAA)

Un point important à remarquer est que une Transformée de Fourier Glissante (TFG) ne peut pas être utilisée pour générer des signaux d'analyse (SAA), de type monocomposant à large bande et à auto interférence limitée, si elle d'une longueur habituellement utilisée (quelques dizaines d'échantillons à quelques centaines d'échantillons, par exemple de 64 à 256 échantillons, possiblement de 32 à 1024 échantillons).

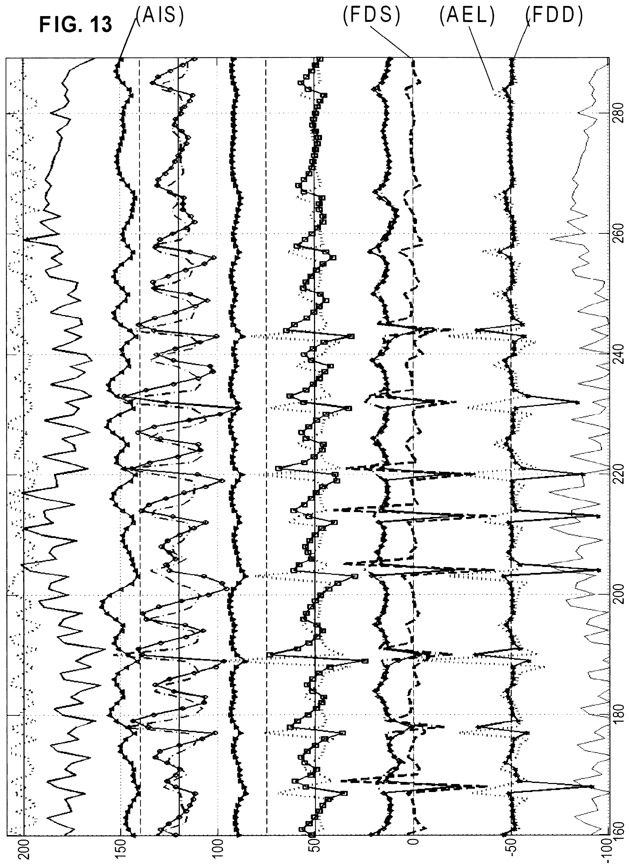

En effet, dans le domaine temporel, la réponse impulsionnelle d'une Transformée de Fourier Glissante (TFG) à fenêtre temporelle rectangulaire est d'une durée égale à la longueur de cette une Transformée de Fourier Glissante (TFG) (voir par exemple la Figure 13-48 de la Référence 1. Richard G. Lyons "Understanding Digital Signal Processing" Third édition, 2011). Elle peut être considérée comme plus courte si la fenêtre n'est pas rectangulaire puisque la fenêtre temporelle a des valeurs proches de zéro en son début et en sa fin. Toutefois l'examen de nombreuses fenêtres temporelles usuelles (voir notamment la Référence 11. Frederic J. Harris "On the use of Windows for Harmonic Analysis with the Discrète Fourier Transform" montre que les fenêtres temporelles usuelles ont des valeurs significatives sur au moins 50% de la durée de la fenêtre rectangulaire correspondante.

De plus, dans le domaine fréquentiel, le signal en sortie d'une Transformée de Fourier Glissante (TFG) est typiquement à bande étroite car les Transformées de Fourier Glissante (TFG) habituellement utilisées ont une durée temporelle typique de 60 à 256 échantillons, qui va parfois jusque 1024 échantillons ou plus. Ces durées sont contradictoires avec la contrainte d'auto-interféerence limitée, et les observations réalisées confirmeront ce point.

**6) L'utilisation de la Transformée de Fourier Glissante (TFG) pour générer des signaux d'analyse (SAA)**

Une méthode, présentée dans la Référence 1 sous le nom de «Zoom FFT» (voir Section 13.19 «The Zoom FFT») consiste à effectuer la séquence suivante d'opérations, appliquée ici au signal initial (SI):

ZF1) Translation de fréquence du signal initial (SI) vers la fréquence nulle (F0), pour générer un signal complexe
ZF2) Filtrage passe bas
ZF3) Sous-échantillonnage du signal ainsi obtenu
ZF4) Application de la Transformée de Fourier

On constate que cette méthode est bien adaptée à la génération de signaux d'analyse (SAA) à la condition que la Transformée de Fourier de l'étape ZF4 ci-dessus soit d'une suffisamment réduite pour être adaptée à être utilisée dans le cadre de l'invention (on remarquera qu'il n'est fait aucune mention de contrainte sur la longueur de la Transformée de Fourier dans la référence précitée).

Dans le contexte de l'invention, l'étape ZF1 de Translation de Fréquence sera faite vers une fréquence de travail (FTR) qui peut être a priori quelconque, mais qui est avantageusement, pour des raisons de simplicité des calculs, soit la fréquence nulle (F0), soit la fréquence (F4) égale au quart de la fréquence d'échantillonnage (FE). L'intérêt de la fréquence (F4) est documenté dans la Référence 3 et sera détaillé ultérieurement. On remarquera aussi qu'il est très simple de passer de la fréquence nulle (F0) à la fréquence (F4) égale au quart de la fréquence d'échantillonnage (FE) et inversement puisqu'il suffit de multiplier le signal par les puissances successives de la racine carrée de -1 (j) ou de -j.

Dans le cas d'une translation de fréquence vers la fréquence (F4) égale au quart de la fréquence d'échantillonnage (FE), la séquence d'opérations ci-dessus peut devenir:

ZF1a) Translation de fréquence (TF) du signal initial (SI) vers la fréquence (F4) égale au quart de la fréquence d'échantillonnage (FE), pour générer un signal complexe
ZF2a) Filtrage passe bande autour de ladite fréquence (F4)
ZF3) Sous-échantillonnage du signal ainsi obtenu
ZF4) Application de la Transformée de Fourier selon la Référence 3.

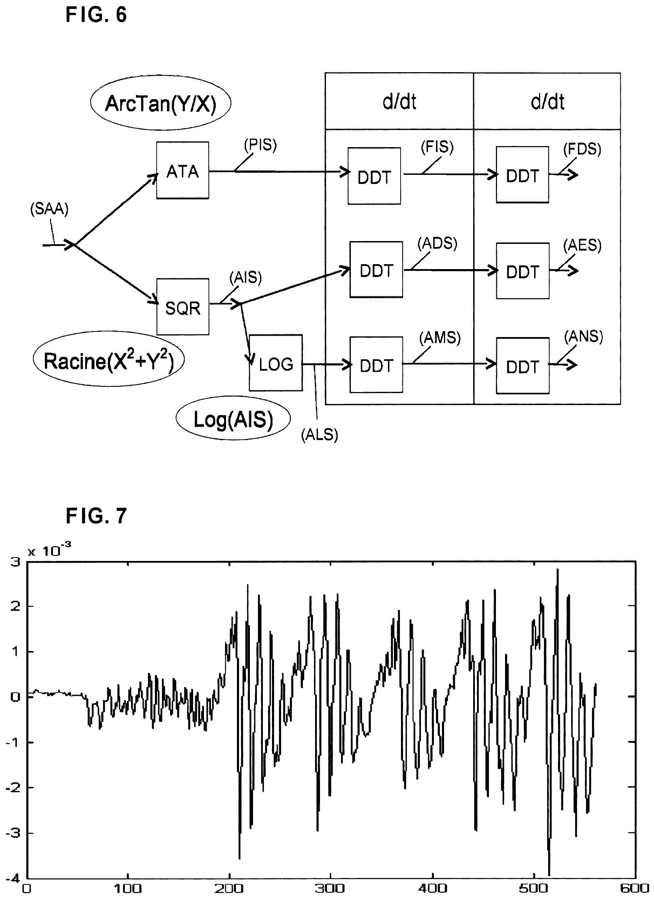

Nota: La Référence 2. Jae S. Lim et Allan V. Oppenheim Eitors "Advanced Topics in Signal Processing" (Chapitre 6 «Short Time Fourier Transform»; Section 6.1.2 «Filtering View», Figure 6.6; Section 6.2.3 «The Filter Bank Approach», Figure 6.14) indique qu'une Transformée de Fourier Glissante (TFG) réalisée sur un signal initial (SI) peut être vue comme le résultat d'une pluralité (NFA) d'opérations de filtrage, réalisée chacune pour une fréquence analysée (FA) au moyen de la séquence suivante d'opérations:

TF1) Une Translation de fréquence complexe de la fréquence analysée (FA) vers la fréquence nulle (F0) effectuée sur le signal initial (SI)
TF2) Un filtrage passe-pas du signal ainsi obtenu et la reconstruction du signal initial (SI) étant effectuée par la séquence suivante d'opérations (Section 6.3 «Short Time Fourier Synthesis», Section 6.3.1 «The filter Bank Summation Method»):

TF3) Une pluralité (NFA) d'opérations de Translations de fréquence complexe de la fréquence nulle (F0) vers la fréquence analysée (FA) effectuée sur la pluralité (NFA) des signaux obtenus en sortie de l'étape TF2 décrite ci-dessus
TF4) Une sommation de la pluralité (NFA) des signaux obtenus en sortie de l'étape TF3 décrite ci-dessus

A ce titre, l'opération de «Zoom FFT» décrite ci-dessus peut être considérée comme la succession des opérations suivantes:

ZG1) Une première Transformée de Fourier Glissante (TFG)
ZG2) Une opération de sous-échantillonnage du signal ainsi obtenu
ZG3) Une deuxième Transformée de Fourier Glissante (TFG)portant sur le signal sous-échantillonné

A ce titre aussi, la Transformée de Fourier selon la Référence 3 peut être vue comme une Transformée de Fourier Glissante (TFG) réalisée au moyen des opérations TF1 à TF4 ci-dessus, en remplaçant la fréquence nulle (F0) par la fréquence (F4) égale au quart de la fréquence d'échantillonnage (FE). Les opérations TF1 à TF4 deviennent alors respectivement les opérations suivantes :

TF41) Une Translation de fréquence complexe de la fréquence analysée (FA) vers la fréquence (F4) égale au quart de la fréquence d'échantillonnage (FE) effectuée sur le signal initial (SI)

TF42) Un filtrage passe-bande du signal ainsi obtenu autour de la fréquence (F4) égale au quart de la fréquence d'échantillonnage (FE)

TF43) Une pluralité (NFA) d'opérations de Translations de fréquence complexe de la fréquence (F4) égale au quart de la fréquence d'échantillonnage (FE) vers la fréquence analysée (FA) effectuée sur la pluralité (NFA) des signaux obtenus en sortie de l'étape TF42 décrite ci-dessus

TF44) Une sommation de la pluralité (NFA) des signaux obtenus en sortie de l'étape TF43 décrite ci-dessus.

### 7) D'autres possibilités pour générer des signaux d'analyse (SAA)

La Référence 8. Lawrence Rabiner, Ronald Crochiere "A novel implementation for Narrow band FIR digital filters" indique une méthode pour obtenir un filtrage étroit en fréquence (et donc a priori mis en oeuvre avec un filtre long) avec la séquence d'opérations suivantes (pour un filtre passe-bas):

ND1) une alternance des opérations suivantes:

ND11) filtrage passe bas (avec un filtre le plus souvent court)
ND12) Sous-échantillonnage

ND2) une alternance des opérations suivantes:

ND21) Sur-échantillonnage d'un facteur égal au facteur de sous-échantillonnage de l'étape correspondante dans l'alternance ZD1
ND22) Filtrage passe bas (avec un filtre le plus souvent court)

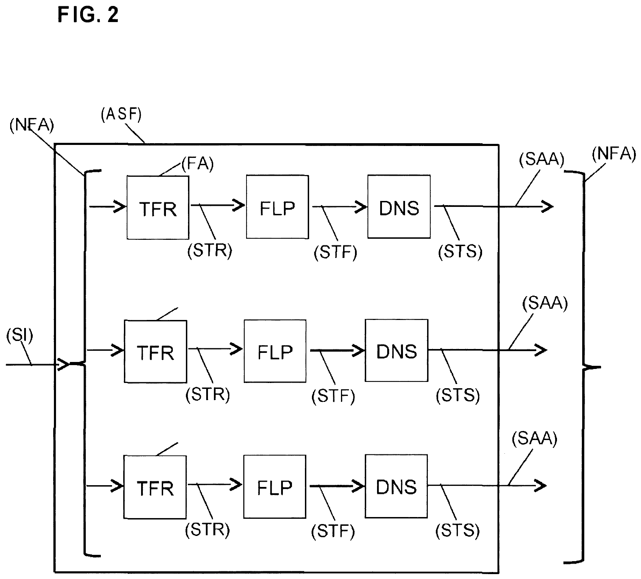

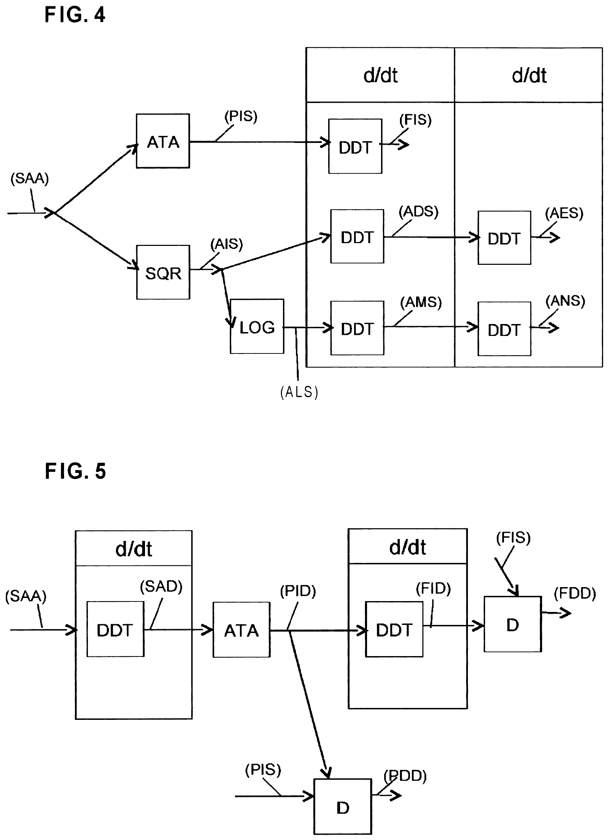

(Voir notamment les Figures 2 et 5 de ladite référence)

On constate que le signal obtenu à la fin de la séquence ND1 définie ci-dessus peut être un signal d'analyse (SAA). On constate aussi que la démarche décrite ci-dessus peut être utilisée conjointement avec des Translations de Fréquence, et que ces dernières peuvent être positionnées librement dans la séquence ND1 d'opérations.

En particulier, on constate que si on utilise comme filtres passe bas des moyennes courtes (moyennes sur 2 à 6 échantillons par exemple) itérées, on obtient bien en sortie de la séquence ND1 un signal d'analyse (SAA), et que la réponse en fréquence du filtre ainsi obtenu est gaussienne.

### 8) Points communs entre les différentes possibilités pour générer des signaux d'analyse (SAA)

Dans les points précédents, on remarque les points suivants:

a) La Référence 2 indique que les éléments constitutifs d'une Transformée de Fourier Glissante (TFG) sont une Translation de Fréquence complexe (TF) et un filtrage passe-bas

b) La Référence 8 indique qu'il est possible de réaliser une filtre passe-bas à bande étroite au moyen d'une succession d'alternances de filtrage passe-bas élémentaires et d'opérations de sous-échantillonnage, suivie d'une alternance symétrique d'opérations de sur-échantillonnage suivies de filtrages passe-bas élémentaires

c) Dans le cadre de l'invention, pour générer des signaux d'analyse (SAA) de type mono-composant à large bande et à auto interférence limitée on peut:

c1) soit faire une Transformée de Fourier Glissante (TFG) suivie d'une opération de sous-échantillonnage suivie d'une deuxième Transformée de Fourier Glissante (TFG) courte

c2) soit faire une succession d'alternances de filtrage passe-bas élémentaires et d'opérations de sous-échantillonnage, à l'intérieur desquelles on procède à des Translations de Fréquence (TF) complexes

En fonction des observations précédentes, ces deux modes de réalisation sont équivalents, et d'autres modes de réalisation pourront aussi être équivalents.

On peut donc unifier et résumer de la manière suivante le principe de l'étape (ASF) d'analyse sélective en fréquence:

- AS1) une succession d'opérations de sous-échantillonnage, composée chacune d'un filtrage fréquentiel passe-bas ou passe-bande et d'une suppression correspondante d'échantillons

- AS2) zéro ou plus opération de filtrage fréquentiel passe-bas ou passe-bande non suivie d'une suppression correspondante d'échantillons
- AS3) au moins une Translation de Fréquence (TF) complexe qui amène la fréquence analysée (FA) à une fréquence de travail (FTA) adaptée à calculer l'Amplitude instantanée (AIS) et à une fréquence de travail (FTP) adaptée à calculer la Phase Instantanée (PIS) et la Fréquence Instantanée (FIS) du signal d'analyse (SAA)

telles que l'effet combiné des sous-étapes AS1) et AS2) est que, en dehors des périodes transitoires, chaque signal d'analyse (SAA) contient au plus un signal élémentaire (SEL) d'amplitude dominante, et ce signal élémentaire (SEL) d'amplitude dominante occupe au moins 30% du spectre du signal d'analyse (SAA)

En effet :

SA1) Une ou plusieurs Translation de Fréquence (TF) complexe sont des opérations inversibles et ne changent pas la largeur de bande d'un signal ou les amplitudes relatives de deux signaux

SA2) L'effet d'une opération de sous-échantillonnage, composée d'un filtrage fréquentiel passe-bas ou passe-bande et d'une suppression correspondante d'échantillons est d'élargir le spectre de fréquences (exprimé en fréquences normalisées) d'un signal qui a été conservé par le filtrage fréquentiel passe-bas ou passe-bande

SA3) Les périodes transitoires sont un cas particulier durant lequel un signal quelconque présente un amplitude instantanée élevée dans une bande de fréquence très large, plus large que celle qu'il peut avoir en régime permanent

SA4) Pour avoir un signal d'analyse (SAA) facilement interprétable et qui présente (hors translation de fréquence vers la fréquence nulle (F0) ou une fréquence voisine) une fréquence instantanée qui soit toujours de même signe, il est important qu'un seul signal élémentaire (SEL) intervienne en pratique dans le calcul de cette fréquence instantanée. Pour cela un signal élémentaire (SEL) du signal initial (SI) doit être dominant dans le spectre de fréquences du signal d'analyse (SAA). En pratique, on constate qu'une dominance de 20 dB est suffisante, et qu'une dominance de 10-15 dB suffit souvent

SA4) Un signal qui occupe au moins 30 % du spectre des fréquences possibles est généralement considéré comme un signal à bande large.

SA5) L'intérêt d'un tel signal à bande large dans le cadre de l'invention est double :

> dans le domaine fréquentiel, la dynamique des informations de fréquence et de phase instantanées est aussi élevée que possible

> dans le domaine temporel, en vertu du principe de dualité entre temps et fréquence, l'auto-corrélation du signal étudié peut être très faible

Dans ce contexte, la Référence 8 et la Référence 2 indiquent quelles sont les conditions pour permettre une reconstruction du signal initial (SI) à partir de la pluralité (NFA) de signaux d'analyse (SAA) correspondant chacun à une des fréquences analysées (FA) de ladite pluralité (NFA).

### 9) L'extraction des paramètres des signaux d'analyse (SAA)

On souhaite extraire des informations d'amplitude instantanée, de phase instantanée d'un signal d'analyse (SAA). On remarque que pour générer de tels signaux d'analyse (SAA) à partir du signal initial (SI), des opérations de sous échantillonnage ont pu être effectuées. A ce titre, il est donc important de disposer de ces informations pour chaque échantillon du signal d'analyse (SAA). Cela rend peu avantageux le calcul d'une Transformée de Fourier par un algorithme de type «FFT» (Transformée de Fourier Rapide).

Par ailleurs, par la nature même des signaux d'analyse (SAA), il est important d'éviter toute opération de filtrage long qui ne soit pas suivie d'une opération de sous-échantillonnage.

Les éléments précédents rendent donc peu avantageux les méthodes classiques de calcul des valeurs instantanées au moyen du signal analytique, ce signal analytique étant lui-même calculé par Transformée de Fourier ou par un filtre temporel qui réalise une Transformée de Hilbert, et dont les performances sont d'autant meilleures que le filtre est long.

Dans ces conditions, le calcul de ces valeurs instantanées par les méthodes de la Référence 3. Demande PCT/BE2011/000052 du 12/08/2011 « Procédé d'Analyse de signaux fournissant des fréquences instantanées et des transformées de Fourier Glissantes et dispositif d'analyse de signaux » s'avèrent particulièrement avantageuses car ces valeurs peuvent facilement calculées pour tout échantillon du signal, et aucun filtrage supplémentaire n'est nécessaire dans le cadre d'une analyse sélective en fréquence.

La Référence 6. Sylvain Marchand "The simplest analysis method for non stationary sinusoidal modeling", qui évalue les performances d'une méthode comparable, indique que les performances de cette méthode en termes de détection des modulations présentes dans un signal est comparable aux meilleures méthodes connues.

Les Figures 4, 5 et 6 décrivent l'enchaînement des opérations qui aboutissent à l'extraction et au calcul de l'ensemble des paramètres et informations qui seront utilisées ultérieurement pour détecter la présence d'une modulation ou d'un signal.

Le calcul des informations provenant de la Phase Instantanée (PIS) du signal d'analyse (SAA) ou la Phase Instantanée (PID) du signal dérivé (SAD) peut se faire à une fréquence quelconque, mais est réalisée plus simplement à la fréquence nulle (F0) ou à la fréquence (F4) égale au quart de la Fréquence d'Echantillonnage (FE).

La Référence 12. Boualem Boashash "Estimating and Interpreting the Instantaneous Frequency of a Signal---Part 2: Algorithns and Applications" indique diverses méthodes pour calculer une Fréquence Instantanée, autres que celles décrites dans la Référence 3. Dans la suite du document, on supposera par simplicité que la Fréquence instantanée est calculée comme la dérivée temporelle de la Phase Instantanée.

Pour le calcul de l'Amplitude Instantanée dans le cadre de l'invention, la méthode de la Référence 3 est particulièrement adaptée en raison de sa simplicité et de l'absence de filtrage supplémentaire requis. Il suffit en effet de calculer Racine carrée de $X^2+Y^2$, X et Y étant les parties réelles et imaginaires d'un signal complexe de fréquence voisine de la fréquence (F4) égale au quart de la Fréquence d'Echantillonnage (FE). Si la fréquence instantanée du signal s'éloigne de ladite fréquence (F4), le résultat est d'autant moins précis que l'on s'éloigne de ladite fréquence (F4). Dans le cadre de l'invention, cette liéite ne pose pas de problème car la précision reste suffisante pour les signaux considérés et pour le calcul d'indicateurs.

Dans la suite du document, on calculera l'Amplitude Instantanée avec la méthode de la Référence 3, c'est à dire comme la racine carrée de la somme des carrés des coordonnées du signal complexe.

Notations:

> d/dt et l'opération DDT signifient dérivation temporelle du signal en entrée
> l'opération D signifie différence entre les deux signaux en entrée
> l'opération LOG signifie logarithme du signal en entrée (une Amplitude Instantanée, qui est donc positive ou nulle, avec un traitement particulier des valeurs nulles de Amplitude Instantanée, comme on le verra ultérieurement)
> l'opération ATA signifie Arc Tangente du signal complexe en entrée (ArcTangente(Y/X))
> l'opération SQR signifie Module du signal complexe en entrée (Racine carrée de $X^2 + Y^2$)

### *10) L'intérêt des paramètres provenant de la dérivée temporelle des signaux d'analyse (SAA)*

Le calcul ci-dessous montre que les paramètres suivants sont liés par une relation simple et indépendante de la nature du signal S(t), supposé dérivable et d'amplitude supérieure à zéro sur un intervalle de temps:

a) la Fréquence instantanée (FIS) du signal d'analyse (SAA), qui est la dérivée temporelle de la phase instantanée (PIS) du signal d'analyse (SAA)
b) la dérivée temporelle (ADS) du logarithme de l'Amplitude instantanée du signal (AIS) du signal d'analyse (SAA)
c) la différence de phase (PDD) entre la phase instantanée (PIS) du signal d'analyse (SAA) d'une part et la phase instantanée (PID) du signal dérivé (SAD) d'autre part

**Relation entre la Fréquence Instantanée et la variation de l'Amplitude Instantanée d'un signal :**

```
S(t) = A(t).exp(j.P(t))                    avec        A(t) >= 0
```

```
dS(t)/dt = exp(j.P(t)).[dA(t)/dt + j.A(t).dP(t)/dt]
                                           avec        A(t) >= 0
```

Avec un changement de notation pour simplifier l'écriture des dérivées, on obtient :

```
S'(t) = exp(j.P(t)).[A'(t) + j.A(t).P'(t)]
                                           avec        A(t) >= 0
```

Si A(t) > 0, on peut écrire :

$$\mathtt{S'(t)\ =\ S(t).[(A'(t)/A(t))\ +\ j.P'(t)]\quad avec\qquad A(t)\ >\ 0}$$

On pose que : LA(t) = Log(A(t)), alors :

$$\mathtt{S'(t)\ =\ S(t).[LA'(t)\ +\ j.P'(t)]\qquad avec\qquad A(t)\ >\ 0}$$

On en déduit que :

$$\mathtt{Phase(S'(T))\ =\ Phase(S(T))\ +\ Phase[LA'(t)\ +\ j.P'(t)]}$$

On pose que :

$$\mathtt{DPhase(t)\quad =\ Phase(S'(T))\ -\ Phase(S(T))}$$

Alors :

$$\mathtt{DPhase(t)\quad =\ Phase[LA'(t)\ +\ j.P'(t)]}$$
$$\mathtt{=\ ArcTan(P'(t)\ /\ LA'(t))}$$

<u>D'où la relation (RPA) suivante</u> :

$$\mathtt{P'(t)\ /\ LA'(t)\ =\ Tangente\ (\ DPhase(t)\ )}$$

Notations : j est la racine carrée de -1, exp() représente la fonction exponentielle, et F'(t) représente la dérivée temporelle de la fonction F(t)

Les relations entre un signal complexe et sa dérivée temporelle sont un fait connu en soi, et les deux références suivantes traitent de ces relations:

Référence 5. Sylvain Marchand, Philippe Depaille "Generalization of the derivative analysis method to non stationary sinusoidal modeling" Proceedings of the 11th conférence of Digital Audio Effects (DAFx-08), Septembre 2008
Référence 7. François Auger, Eric Chassande Motin, Patrick Flandrin, "On Phase Magnitude Relationships in the Short Time Fourier Transform" IEEE Signal Processing Letters Vol 6, No 1, January 2012

Un point important est que, dans la présente invention, et contrairement aux deux références citées (et à de nombreuses autres), aucun quotient ou aucune division d'aucune sorte de quantités liées à des signaux ne sont calculés, seules des différences de phase et/ou de fréquences instantanées entre un signal et sa dérivée sont calculées, ce qui change la nature des calculs effectués.

En particulier, la dérivée temporelle du signal n'intervient en général que par l'intermédiaire de sa phase instantanée ou de sa fréquence instantanée. On remarquera que la définition même des signaux d'analyse (SAA) rend l'information de phase, et donc les informations qui en dérivent, particulièrement intéressantes et faciles à exploiter.

La relation phase amplitude (RPA) définie dans le calcul ci-dessus sera utilisée dans le cadre de l'invention pour définir dans quelle condition la différence de phase (PDD) entre la phase instantanée (PIS) du signal d'analyse (SAA) d'une part et d'autre part la phase instantanée (PID) du signal dérivé (SAD), est constante dans le temps, c'est à dire lorsque la Fréquence instantanée (FIS) du signal (SAA) d'analyse est égale à la Fréquence instantanée (FID) du signal dérivé (SAD).

**Cas particuliers de la relation phase amplitude (RPA) en relation avec l'invention dans lesquels DPhase(t) est constant:**

**A) Tangente(DPhase(t)) = 0 =>**
**P'(t) = 0 => P(t) est constante : Impossible**
**B) Tangente(DPhase(t)) = plus ou moins l'infini => DPhase(t) = + PI/2 ou -PI/2**
**LA'(t) = 0 => A(t) est constante et P(t) quelconque =>**

> **> Modulation de Fréquence à Amplitude constante**
> **> Le signal et sa dérivée temporelle sont en quadrature**

**C) P'(t) = constante => Signal à Phase linéaire**
**LA'(t) = constante => A(t) = exp(K.t) ou exp(-K.t)**

> **=> Amplitude exponentielle (pouvant être à la limite constante)**
> **=> Signal à durée limitée (sauf à la limite d'amplitude constante)**

**D) P'(t) = proportionnelle au temps => Signal à Phase quadratique**
**LA'(t) = proportionnelle au temps**

> **=> $A(t) = exp(K.t^2)$ ou $exp(-K.t^2)$**
> **=> Amplitude à variation plus qu'exponentielle**
> **=> Signal impulsionnel ou signal constant ou signal de type gaussien**

### *11) Calcul détaillé des indicateurs de modulation et de présence*

#### *11.1) Principes généraux et Durées d'observations*

Les indicateurs sont disponibles pour chaque nouvel échantillon (SAE) d'un signal d'analyse (SAA) et sont relatifs à une durée d'observation de (DOB) échantillons du signal initial (SI).

Pour améliorer la fiabilité des observations, il peut être avantageux d'observer l'évolution des indicateurs précédents sur une durée (DMC) de mise en cohérence, égale par exemple à 3 ou 5 fois la durée d'observation de (DOB) échantillons du signal initial (SI), en observant notamment:

> a) l'évolution dans le temps de chaque indicateur (sur quelle durée l'indicateur reste-t-il sensiblement constant?)
> b) les évolutions significatives conjointes dans le temps de plusieurs indicateurs (des indicateurs présentent-ils des variations significatives au même moment?)
> c) le degré de cohérence des informations apportées par les différents indicateurs

Dans la suite de la description, on s'intéressera principalement aux observations effectuées sur une durée d'observation de (DOB) échantillons du signal initial (SI), en indiquant le cas échéant quelles peuvent être les améliorations apportées par une durée d'observation plus longue.

#### *11.2) Points communs entre les calculs des divers indicateurs*

La plupart des indicateurs comparent une valeur ou une différence à une valeur constante (zéro ou +- PI/2 ce qui peut se ramener à une comparaison à zéro). Dans tous les cas la proximité par rapport à zéro doit être calculée comme le rapport (exprimé par exemple en pourcentage) entre une valeur instantanée d'une part et d'autre part une moyenne observée sur une période égale ou supérieure à la durée d'observation de (DOB) échantillons du signal initial (SI), et qui peut être avantageusement la durée (DMC) de mise en cohérence, égale par exemple à 3 ou 5 fois la durée d'observation de (DOB) échantillons du signal initial (SI).

Sauf cas particulier, on considèrera qu'une valeur instantanée est proche de zéro si, en valeur absolue, elle est inférieure à 5% ou 10% de la moyenne définie précédemment.

On remarquera que l'allure générale des indicateurs (niveaux d'ondulation et de bruit notamment) dépend de nombreux facteurs tels que : nature du signal utile (SU) observé, niveau de bruit rajouté (BRA), type de filtrage passe-bas ou passe-bande effectué sans opération de suppression d'échantillons correspondante (par exemple dans les observations décrites précédemment la nature de la Transformée de Fourier Glissante (TFG) effectuée après les opérations de suppression d'échantillons a un impact important sur le bruit observé dans les indicateurs). Dans cette optique, il sera avantageux de définir le détail du calcul des indicateurs dans un contexte d'observations typiques.

*11.3) Relations logiques entre les calculs des divers indicateurs*

D'une manière générale, les indicateurs peuvent être calculées et interprétées indépendamment les uns des autres. Les exceptions à ce principe sont les suivantes:

a) L'indicateur de signal non significatif (INS) rend les autres indicateurs invalides lorsqu'il est mis à vrai en raison de la faible valeur de l'Amplitude instantanée (AIS) du signal d'analyse (SAA)
b) L'indicateur de signal non significatif (INS) est mis à vrai par les autres indicateurs si une incohérence est observée sur ces indicateurs (voir les observations effectuées sur le chirp pour un tel exemple d'incohérence)
c) L'observation conjointe d'indicateurs sur la durée (DMC) de mise en cohérence permet d'augmenter la fiabilité accordée à un indicateur en raison de son comportement constant sur cette période, ou au contraire de considérer qu'il s'agit d'un phénomène transitoire si par exemple l'indicateur a une valeur constante sur cette durée sauf à un instant isolé.

*11.4) Calcul de l'indicateur de signal non significatif (INS)*

Cet indicateur est faux par défaut, et vrai si une des conditions suivantes est remplie:

> soit l'Amplitude instantanée (AIS) a, sur la durée d'observation de (DOB) échantillons du signal initial (SI) une valeur moyenne inférieure à un premier seuil (AS1) défini à l'avance ou une valeur instantanée minimale inférieure à un deuxième seuil (AS2) défini à l'avance
> soit d'autres indicateurs observés ont un comportement contradictoire

Les points 11.2 et 11.3 ci-dessus précisent des modalités de calcul de cet indicateur dans les deux cas mentionnés. On remarquera que, dans la plupart des applications, qu'un niveau maximum d'amplitude est est en général connu ou au moins anticipé. C'est en effet le cas lorsque il existe un contrôle automatique de gain (CAG) qui régule l'amplitude maximum.

*11.5) Calcul de l'indicateur (IAS) de modulation d'amplitude sinusoïdale*

Cet indicateur indique dans quelle mesure la dérivée temporelle première (ADS) de l'Amplitude instantanée (AIS) d'une part et d'autre part la dérivée temporelle seconde de l'Amplitude instantanée (AIS) sont en quadrature.
Dans le cadre de l'invention, on dira que deux signaux sont en quadrature si les conditions suivantes sont remplies :

Q1) Les maxima locaux, minima locaux et passages a zéro de chaque signal se présentent sous la forme répétitive suivante : extremum local d'un signe (maximum local positif ou minimum local négatif) / passage à zéro / extremum local de l'autre signe (minimum local négatif ou maximum local positif) / passage à zéro / ...
Q2) Les passages à zéro de chacun des signaux correspondent au maxima et au minima de l'autre

Le but est de détecter des signaux qui soient comparables à un sinus et un cosinus, et l'on sait que :

a) un sinus et un cosinus d'une même variable présentent ces caractéristiques ; et
b) la dérivée temporelle d'un sinus est un cosinus, et inversement.

Ces conditions Q1 et Q2 permettent de définir quatre sous-indicateurs qui mesurent respectivement le respect de la condition Q1 et le respect de la condition Q2, et cela pour chacun des deux signaux. L'indicateur global pourra alors être composé avec les quatre sous-indicateurs.
Lorsqu'un des deux signaux étudiés est la dérivée temporelle de l'autre, on doit tenir compte d'un décalage temporel de un échantillon.

*11.6) Calcul de l'indicateur (IAE) de modulation d'amplitude exponentielle*

Cet indicateur indique dans quelle mesure la dérivée temporelle première (ADL) du Logarithme de l'Amplitude instantanée (AIS) est constante.
Les points 11.2 et 11.3 ci-dessus précisent des modalités de calcul de cet indicateur.

*11.7) Calcul de l'indicateur (IPA) de détection de pics de modulation d'amplitude*

Cet indicateur indique dans quelle mesure la dérivée temporelle seconde (AEL) du Logarithme de l'Amplitude instantanée (AIS) présente un pic d'amplitude important et limité dans le temps.

La détection d'un pic d'amplitude isolé est un problème bien connu. Ici on pourra étudier la forme des 4 ou 5 derniers échantillons et déduire s'il y a un pic ou non.

La périodicité éventuelle des pics observés apporte typiquement une information importante.

*11.8) Calcul de l'indicateur (IFM) de modulation de fréquence*

Cet indicateur indique dans quelle mesure la dérivée temporelle première (FDS) de la Fréquence instantanée (FIS) du signal d'analyse (SAA), qui est elle-même la dérivée temporelle première de la Phase Instantanée (PIS) du signal d'analyse (SAA), est constante.

Les points 11.2 et 11.3 ci-dessus précisent des modalités de calcul de cet indicateur.

*11.9) Calcul de l'indicateur (IPS) de probabilité de présence de signal*

Cet indicateur indique dans quelle mesure la différence (FDD) de fréquences instantanées entre la Fréquence instantanée (FIS) du signal d'analyse (SAA) d'une part et d'autre part la Fréquence instantanée (FID) du signal dérivé (SAD) est différente de zéro.

Les points 11.2 et 11.3 ci-dessus précisent des modalités de calcul de cet indicateur.

*11.10) Calcul de l'indicateur (IMD) de modulation de fréquence à amplitude constante*

Cet indicateur indique dans quelle mesure la différence entre la Phase instantanée (PIS) du signal d'analyse (SAA) d'une part et d'autre part la Phase instantanée (PID) du signal dérivé (SAD) est sensiblement égale à $+PI/2$ ou $-PI/2$.

Les points 11.2 et 11.3 ci-dessus précisent des modalités de calcul de cet indicateur.

*11.11) Calcul de l'indicateur de présence de signal (ISP)*

Cet indicateur est calculé de la manière suivante lorsque l'indicateur de signal non significatif (INS) est faux:

4.1) si l'indicateur (IAE) de modulation d'amplitude exponentielle indique la présence d'une modulation d'amplitude exponentielle, alors l'indicateur de présence de signal (ISP) est vrai

4.2) si l'indicateur (IPS) de probabilité de présence de signal est différent de zéro, alors l'indicateur de présence de signal (ISP) est vrai

4.3) si l'indicateur (IMD) de modulation de fréquence à amplitude constante indique une telle modulation, alors l'indicateur de présence de signal (ISP) est vrai

4.4) dans les autres cas l'indicateur de présence de signal (ISP) est faux

Cet indicateur résulte de l'application de tests logiques à des indicateurs précédemment définis.

**12) Observations réalisées et résultats constatés**

*12.1) Traitement effectués*

Les observations ont porté (sauf mention contraire) sur les informations générées par les traitements suivants, avec une fréquence d'échantillonnage de 8.000 Hz :

TR1) Translation de Fréquence complexe vers la fréquence nulle (F0)
TR2) Filtrage passe-bas et Décimation temporelle par un facteur 10
TR3) Transformée de Fourier Glissante (TFG) de longueur 12 avec une fenêtre de Hann, la fréquence analysée (FA) étant la fréquence (F4) égale au quart de la fréquence d'échantillonnage (FE)

On remarquera que la Transformée de Fourier Glissante (TFG) de longueur 12 avec une fenêtre de Hann présente une atténuation de moins de 5 dB sur 50 % du spectre de fréquences, ce qui permet d'avoir en sortie un signal en bande large, tout en réduisant significativement le bruit que l'on peut observer dans les indicateurs.

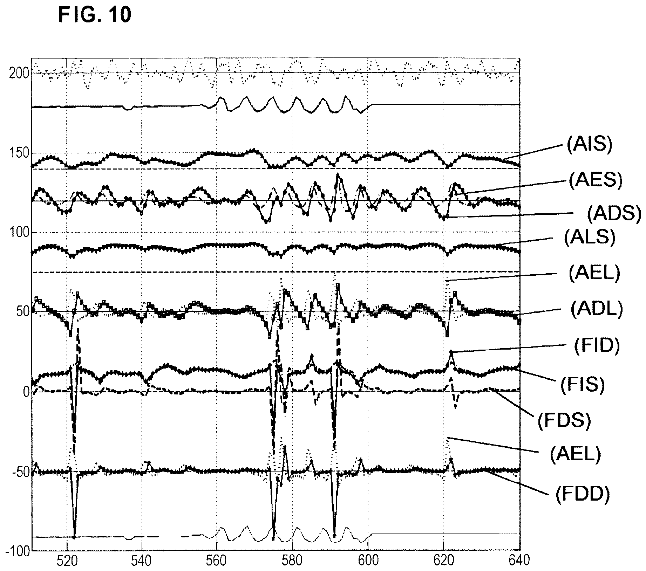

La courbe en traits pointillés en haut des Figures 10 à 15 représente le bruit rajouté (BRA).

*12.2) Présentation des résultats*

La Figure 10 montre les différentes courbes représentant les observations réalisées, avec l'indication des noms des informations correspondantes:

> L'axe horizontal est celui du temps (les chiffres correspondent au numéro de l'échantillon dans une séquence de 6.000 échantillons)
> Les signaux étudiés sont représentés sur les courbes suivantes:

>> Entre +150 et +200 le signal utile (SU) sans bruit
>> En +200 le bruit ajouté (BRA)
>> En -100, le signal utile (SU) sans bruit est répété

> Les courbes suivantes décrivent les paramètres qui permettent le calcul des indicateurs:

>> En +140, l'Amplitude Instantanée (AIS) du signal d'analyse (SAA), en trait continue avec des triangles avec la pointe en haut
>> En +120, la dérivée temporelle première (ADS) de l'Amplitude Instantanée (AIS), en trait continu avec des marqueurs en cercle
>> En +120 aussi, la dérivée temporelle seconde (AES) de l'Amplitude Instantanée (AIS), en trait avec des tirets et sans marqueurs
>> En +95, le logarithme (ALS) de l'Amplitude Instantanée (AIS), en trait continue avec des triangles avec la pointe en bas
>> En +50, la dérivée temporelle première (ADL) du logarithme (ALS) de l'Amplitude Instantanée (AIS), en trait continu avec des carrés comme marqueurs
» En +50 aussi, la dérivée temporelle seconde (AEL) du logarithme (ALS) de l'Amplitude Instantanée (AIS), en trait pointillés sans marqueurs
>> En 0, la Fréquence Instantanée (FIS) du Signal d'analyse (SAA), en trait continu avec des losanges comme marqueurs
>> En 0 aussi, la Fréquence Instantanée (FID) du signal dérivé (SAD), en traits tiretés-pointillés sans marqueur
>> En 0 enfin, la dérivée temporelle (FDS) de la Fréquence Instantanée (FIS) du Signal d'analyse (SAA) en traits tiretés
>> En -50, répétition en traits pointillés sans marqueurs de la dérivée temporelle seconde (AES) du logarithme (ALS) de l'Amplitude Instantanée (AIS)
>> En -50, en traits continus avec des pentagrammes comme marqueurs, la différence (FDD) de fréquences instantanées entre:

- Fréquence Instantanée (FIS) du Signal d'analyse (SAA)
- Fréquence Instantanée (FID) du signal dérivé (SAD)

*12.3) Observations sur un signal de type « chirp » linéaire*

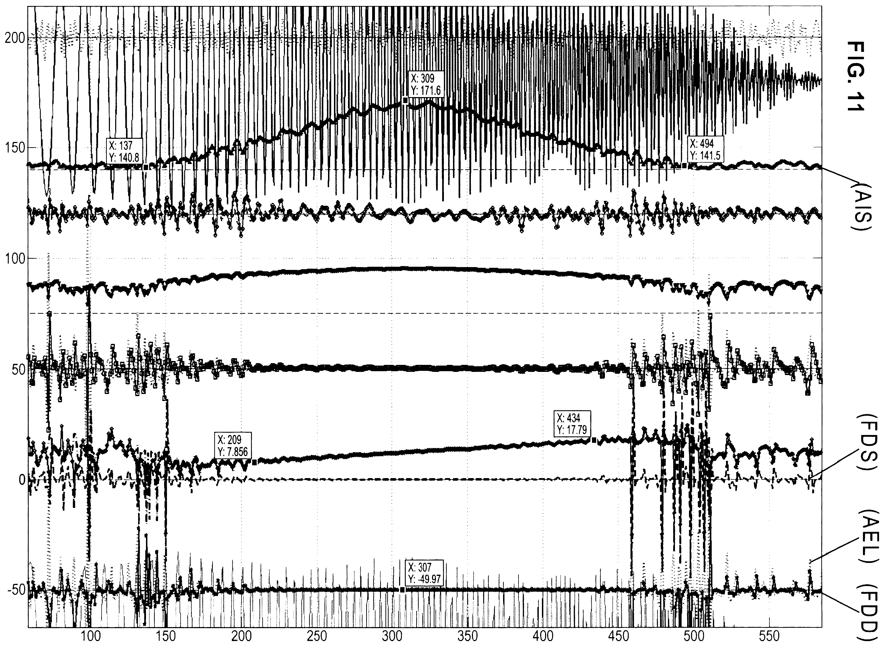

La Figure 11 montre les observations faites avec un signal d'amplitude constante et modulé linéairement en fréquence de 0 à 400 Hz (chirp linéaire). On pourra remarquer les points suivants :

CH1) Il existe deux zones d'amplitude très faible avant et après le pic d'amplitude (au centre de la figure). Dans ces zones, les indicateurs ont des valeurs qui ne représentent pas la réalité
CH2) On remarque les indicateurs relatifs aux dérivées temporelles du logarithme de l'Amplitude Instantanée (AIS) présentent des variations fortes et présentant une structure, tandis que les indicateurs relatifs aux dérivées temporelles de l'Amplitude Instantanée (AIS) présentent des variations plus faible et peu structurées. Ces deux types de variation ne sont pas compatibles, sauf à considérer que le signal étudié est d'amplitude très faible
CH3) De la même manière des variations de fréquence instantanée moins fortes que les variations des indicateurs relatifs aux dérivées temporelles du logarithme de l'Amplitude Instantanée (AIS), ce qui est peu probable si les fréquences instantanées (FIS) et (FID) du signal d'analyse (SAA) et du signal dérivé (SAD) respectivement restent sensiblement constantes
CH4) On a donc bien un exemple d'indicateurs avec des comportements contradictoires, qui renforcent la probabilité que l'amplitude instantanée (AIS) est insuffisante pour que les autres indicateurs soient valides.
CH5) On observe enfin que :

> les indicateurs de fréquence instantanée ont bien une progression linéaire dans la partie du signal qui a une amplitude suffisante pour que les indicateurs soient significatifs

> l'indicateur de probabilité de présence de signal, qui correspond à la différence des fréquences instantanées (FIS) et (FID) du signal d'analyse (SAA) et du signal dérivé (SAD), indique bien, comme prévu, une absence probable de signal puisque le signal étudié est une des exceptions (modulation de fréquence à amplitude constante) pour cet indicateur, qui nécessite l'examen d'autres indicateurs pour confirmer l'absence de signal

*12.4) Observations sur un signal vocal*

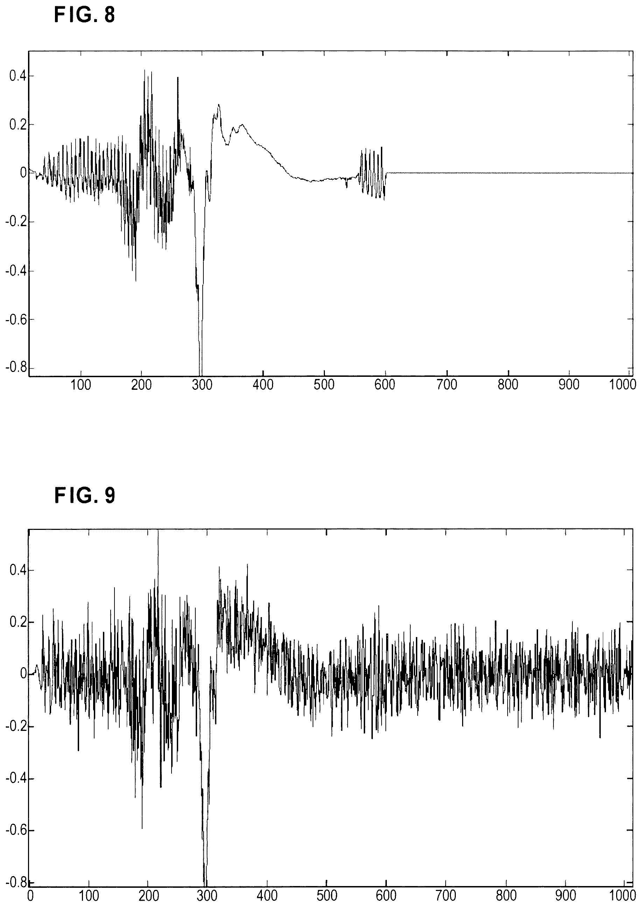

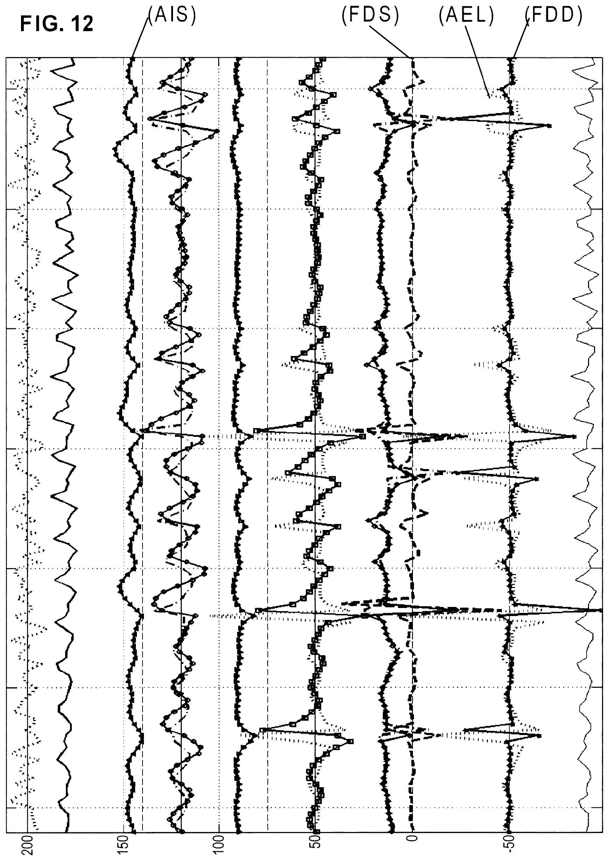

Les Figures 12 à 15 montrent des observations faites avec l'invention sur le signal présenté dans les Figures 7 et 8. On pourra remarquer les points suivants :

VO1) (Figures 12 et 13) En +120 et autour de l'échantillon 100, on on un exemple de 2 indicateurs qui sont faiblement en quadrature, mais sur une période de 30 échantillons. Ces mêmes indicateurs sont plus nettement en quadrature autour de l'échantillon 220

VO2) (Figure 13) Entre l'échantillon 200 et l'échantillon 220 on voit une concordance de plusieurs indicateurs pour suivre la fréquence fondamentale de la parole. On remarque que la précision n'est pas absolue et que le pic d'amplitude en 205 du signal de parole est moins bien détecte que les autres pics

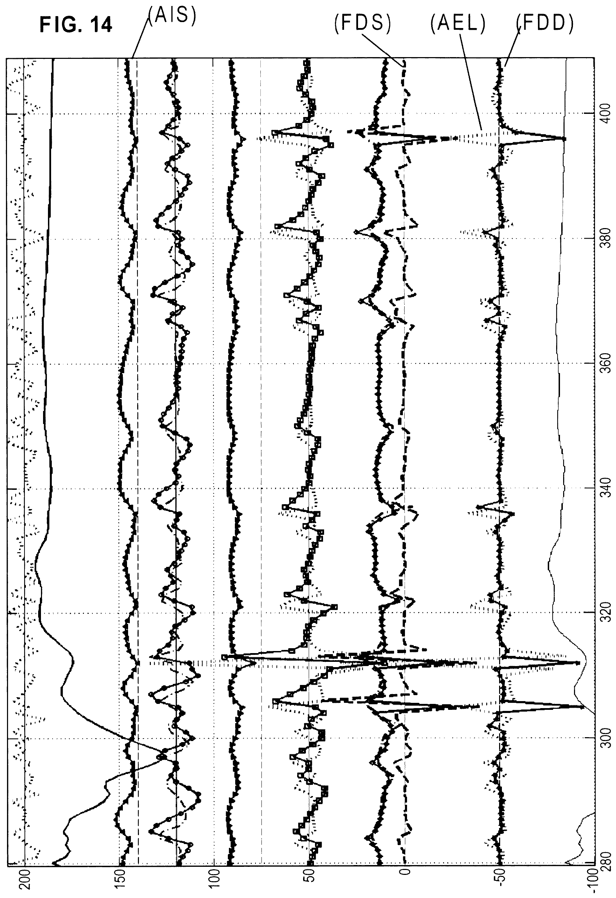

VO3) (Figure 14) On voit que l'absence de signal de parole est dans l'ensemble bien détecté par l'indicateur de présence du signal qui ne présente que quelques pics parasites, peu crédibles dans le type d'application concerné

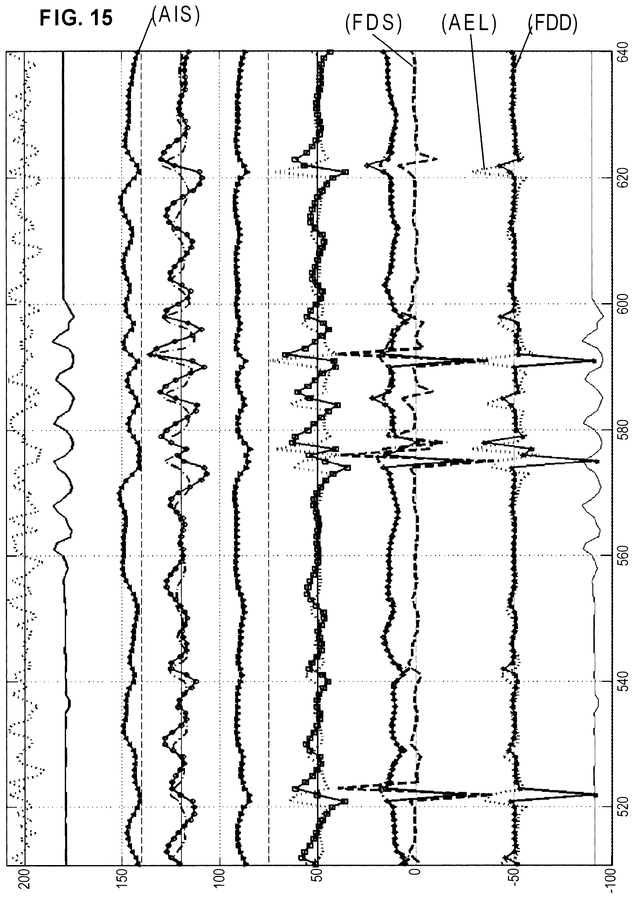

VO4) (Figure 15) On voit que le signal d'amplitude comparable au bruit (voir courbe en haut de la figure) est dans l'ensemble détecté. On remarquera que le pic d'amplitude du signal de parole en 568 est très difficile à détecter car le bruit et le signal de parole sont à ce moment précis en opposition de phase.

VO5) On remarque aussi une concordance entre plusieurs indicateurs qui contribuent tous à indiquer la présence d'un signal structuré entre les échantillons 575 et 600 :

> l'indicateur de modulation d'amplitude sinusoïdale qui détecte les signaux en quadrature
> les indicateurs relatifs aux dérivées temporelles du logarithme de l'Amplitude Instantanée (AIS)
> les indicateurs de fréquence instantanée

On voit bien dans cet exemple que l'incertitude sur la détection (et notamment sur l'instant où un signal commence à être détecté) serait moins bonne.

**13) Application à l'étude du signal vocal**

La Figure 7 est un extrait d'un signal vocal numérisé avec une fréquence d'échantillonnage (FE) de 8.000 Hz.

On y remarque une structure complexe, qui rend notoirement difficile la détection de la fréquence fondamentale du signal ; cette fréquence fondamentale est appelée « pitch » dans la littérature anglo-saxonne.

En comparaison, le signal de parole après filtrage passe bas et suppression d'échantillons qui est représenté en haut et en bas des Figures 12 à 15 est beaucoup plus simple, même s'il a une précision temporelle inférieure. Le point important pour l'application de détection de la fréquence fondamentale de la parole est que un pic de modulation d'amplitude est bien présent dans les deux représentations du signal de parole (Figure 7 et Figure 8).

On peut constater que la fréquence fondamentale est bien suivie par des indicateurs dont les pics correspondent à un positionnement à peu près constant par rapport au pic d'amplitude du signal de parole représenté en haut et en bas des Figures 12 à 15.

La Référence 9. Article Wikipedia "Pitch Détection Algorithm", recense les méthodes connues pour effectuer cette recherche de fréquence fondamentale. La Référence 10. Thomas F. Quatieri, "Discrete Time Speech Signal Processing", Prentice Hall éditeur, 2002 détaille de nombeux aspects du traitement numérique du signal de parole.

Il est donc possible de détecter la fréquence fondamentale d'un signal de parole en détectant les éléments suivants:

VA) les pics significatifs d'amplitude d'au moins un des indicateurs suivants:

V1) l'indicateur (ITA) de détection de pics de modulation d'amplitude
V2) l'indicateur (IPS) de probabilité de présence de signal
V3) l'indicateur (IFM) de modulation de fréquence VB) la concordance dans le temps d'apparition de pics d'amplitude des indicateurs précédents

Les éléments de l'invention présentée ci-dessus décrivent ainsi un procédé de traitement d'un signal initial (SI) au moyen d'une pluralité (NFA) de fréquences analysées (FA) dans ledit signal initial (SI), composé d'un signal utile (SU) composé d'une somme de signaux élémentaires (SEL), représentatif d'une onde qui se propage dans un milieu physique, auquel peut s'ajouter un bruit ajouté (BRA),

ledit procédé étant mis en oeuvre sur une séquence d'échantillons (SE), échantillonnés à une fréquence d'échantillonnage (FE) constante, obtenus à partir d'un signal initial (SI)

ledit procédé comprenant une étape (ASF) d'analyse sélective en fréquence fournissant à partir du signal initial (SI) une pluralité (NFA) de signaux d'analyse (SAA) de type monocomposant à large bande et à auto interférence limitée, chaque signal d'analyse (SAA) correspondant à une des fréquences analysées (FA), ladite étape comprenant les sous-étapes suivantes :

- AS1) une succession d'opérations de sous-échantillonnage, composée chacune d'un filtrage fréquentiel passe-bas ou passe-bande et d'une suppression correspondante d'échantillons
- AS2) zéro ou plus opération de filtrage fréquentiel passe-bas ou passe-bande non suivie d'une suppression correspondante d'échantillons
- AS3) au moins une Translation de Fréquence (TF) complexe qui amène la fréquence analysée (FA) à une fréquence de travail (FTA) adaptée à calculer l'Amplitude instantanée (AIS) et à une fréquence de travail (FTP) adaptée à calculer la Phase Instantanée (PIS) et la Fréquence Instantanée (FIS) du signal d'analyse (SAA)

telles que l'effet combiné des sous-étapes AS1) et AS2) est que, en dehors des périodes transitoires, chaque signal d'analyse (SAA) contient au plus un signal élémentaire (SEL) d'amplitude dominante, et ce signal élémentaire (SEL) d'amplitude dominante occupe au moins 30 % du spectre du signal d'analyse (SAA)

Selon un aspect du procédé, la fréquence de travail (FTA) adaptée à calculer l'Amplitude instantanée (AIS) est égale à la fréquence (F4) égale au quart de la fréquence d'échantillonnage (FE)

Selon un aspect du procédé, la fréquence de travail (FTP) adaptée à calculer la Phase Instantanée (PIS) et la Fréquence Instantanée (FIS) du signal d'analyse (SAA) est égale soit à la fréquence nulle (F0), soit à la fréquence (F4) égale au quart de la fréquence d'échantillonnage (FE)

Les éléments de l'invention présentée ci-dessus décrivent également un procédé d'analyse d'un signal initial (SI) au moyen d'une pluralité (NFA) de fréquences analysées (FA) dans ledit signal initial (SI), composé d'un signal utile (SU) composé d'une somme de signaux élémentaires (SEL), représentatif d'une onde qui se propage dans un milieu physique, auquel peut s'ajouter un bruit ajouté (BRA), pour fournir des paramètres de présence et une description des modulations de chacune des fréquences analysées (FA) de la pluralité (NFA) de fréquences analysées,

ledit procédé étant mis en oeuvre sur une séquence d'échantillons (SE), échantillonnés à une fréquence d'échantillonnage (FE) constante, obtenus à partir d'un signal initial (SI),

ledit procédé comprenant les étapes successives suivantes:

1.1) Une étape (ASF) d'analyse sélective en fréquence fournissant à partir du signal initial (SI) une pluralité (NFA) de signaux d'analyse (SAA) du type monocomposant à large bande et à auto interférence limitée, chaque signal d'analyse (SAA) correspondant à une des fréquences analysées (FA),

1.2) Une pluralité (NFA) d'opérations (EXP) d'extraction de paramètres (PAS) du signal d'analyse (SAA) pour chaque échantillon (EAA) de la pluralité (NFA) des signaux d'analyse (SAA), ces paramètres comprenant au moins les signaux suivants:

a) l'Amplitude instantanée (AIS) du signal d'analyse (SAA)
b) la Phase instantanée (PIS) du signal d'analyse (SAA)

1.3) Une pluralité (NFA) d'opérations d'estimation de la modulation du signal (EMS) qui chacune détermine pour chaque échantillon (EAA) de la pluralité (NFA) des signaux (SAA) d'analyse, et sur une durée d'observation de (DOB) échantillons du signal initial (SI), l'indicateur suivant:

a) indicateur de signal non significatif (INS), qui est faux par défaut et vrai soit si l'Amplitude instantanée (AIS) a, sur la durée d'observation de (DOB) échantillons du signal initial (SI) une valeur moyenne inférieure à un premier seuil (AS1) défini à l'avance ou une valeur instantanée minimale inférieure à un deuxième seuil (AS2) défini à l'avance soit si d'autres indicateurs observés ont un comportement contradictoire et au moins un des autres indicateurs suivants:

b1) un indicateur (IAS) de modulation d'amplitude sinusoïdale qui indique dans quelle mesure la dérivée temporelle première (ADS) de l'Amplitude instantanée (AIS) d'une part et d'autre part la dérivée temporelle seconde de l'Amplitude instantanée (AIS) sont en quadrature

b2) un indicateur (IAE) de modulation d'amplitude exponentielle qui indique dans quelle mesure la dérivée temporelle première (ADL) du Logarithme de l'Amplitude instantanée (AIS) est constante

b3) un indicateur (IPA) de détection de pics de modulation d'amplitude qui indique dans quelle mesure la dérivée temporelle seconde (AEL) du Logarithme de l'Amplitude instantanée (AIS) présente un pic d'amplitude important et limité dans le temps

b4) un indicateur (IFM) de modulation de fréquence qui indique dans quelle mesure la dérivée temporelle première (FDS) de la Fréquence instantanée (FIS) du signal d'analyse (SAA), qui est elle-même la dérivée temporelle première de la Phase Instantanée (PIS) du signal d'analyse (SAA), est constante.

Selon un aspect du procédé, l'Étape 1.1 (ASF) d'analyse sélective en fréquence est réalisée de la manière suivante :

- AS1) une succession d'opérations de sous-échantillonnage, composée chacune d'un filtrage fréquentiel passe-bas ou passe-bande et d'une suppression correspondante d'échantillons
- AS2) zéro ou plus opération de filtrage fréquentiel passe-bas ou passe-bande
- AS3) au moins une Translation de Fréquence (TF) complexe qui amène la fréquence analysée (FA) à une fréquence de travail (FTA) adaptée à calculer l'Amplitude instantanée (AIS) et à une fréquence de travail (FTP) adaptée à calculer la Phase Instantanée (PIS) et la Fréquence Instantanée (FIS) du signal d'analyse (SAA)

telles que l'effet combiné des sous-étapes AS1) et AS2) est que, en dehors des périodes transitoires, chaque signal d'analyse (SAA) contient au plus un signal élémentaire (SEL) d'amplitude dominante, et ce signal élémentaire (SEL) d'amplitude dominante occupe au moins 30 % du spectre du signal d'analyse (SAA)

Selon un aspect du procédé, la fréquence de travail (FTA) adaptée à calculer l'Amplitude instantanée (AIS) est égale à la fréquence (F4) égale au quart de la fréquence d'échantillonnage (FE)

Selon un aspect du procédé, la fréquence de travail (FTP) adaptée à calculer la Phase Instantanée (PIS) et la Fréquence Instantanée (FIS) du signal d'analyse (SAA) est égale soit à la fréquence nulle (F0) ou à la fréquence (F4) égale au quart de la fréquence d'échantillonnage (FE)

Selon un aspect du procédé, les opérations (EXP) d'extraction de paramètres du signal (PAS) pour chaque échantillon (EAA) de la pluralité (NFA) des signaux d'analyse (SAA), fournissent en plus les deux signaux suivants:

c) la Phase instantanée (PID) du signal dérivé (SAD) égal à la dérivée temporelle d'un signal d'analyse (SAA),

d) la Fréquence instantanée (FID), égale à la dérivée temporelle de ladite Phase instantanée (PID) du signal dérivé (SAD)

les opérations d'estimation (EMS) de la modulation du signal déterminant au moins un des deux indicateurs supplémentaires suivants :

b5) un indicateur (IPS) de probabilité de présence de signal qui indique dans quelle mesure la différence (FDD) de fréquences instantanées entre la Fréquence instantanée (FIS) du signal d'analyse (SAA) d'une part et d'autre part la Fréquence instantanée (FID) du signal dérivé (SAD) est différente de zéro

b6) un indicateur (IMD) de modulation de fréquence à amplitude constante qui indique dans quelle mesure la différence entre la Phase instantanée (PIS) du signal d'analyse (SAA) d'une part et d'autre part la Phase instantanée (PID) du signal dérivé (SAD) est sensiblement égale à +PI/2 ou -PI/2

Selon un aspect du procédé, un indicateur de présence de signal (ISP) est calculé de la manière suivante lorsque l'indicateur de signal non significatif (INS) est faux :

4.1) si l'indicateur (IAE) de modulation d'amplitude exponentielle indique la présence d'une modulation d'amplitude exponentielle, alors l'indicateur de présence de signal (ISP) est vrai

4.2) si l'indicateur (IPS) de probabilité de présence de signal est différent de zéro, alors l'indicateur de présence de signal (ISP) est vrai

4.3) si l'indicateur (IMD) de modulation de fréquence à amplitude constante indique une telle modulation, alors l'indicateur de présence de signal (ISP) est vrai

4.4) dans les autres cas l'indicateur de présence de signal (ISP) est faux

Selon un aspect du procédé, la durée d'observation de (DOB) échantillons du signal initial (SI) est de l'ordre de 100 à 200 échantillons du signal initial (SI)

Selon un aspect du procédé, l'Étape 1.1) (ASF) d'analyse sélective en fréquence fournissant à partir du signal initial (SI) une pluralité (NFA) de signaux d'analyse (SAA) comprend, pour chaque signal d'analyse (SAA), au moins les étapes suivantes :

11.1) Une opération de translation de fréquence (TFR), adaptée à changer chaque fréquence analysée (FA) en une fréquence de travail (FTR)

11.2) Une opération de filtrage fréquentiel passe bande (FFP), réalisée par un filtre passe bande (FPB), de fréquence centrale égale à la fréquence de travail (FTR), et de largeur de bande effective (FBW) égale à une fraction (FBP) de la fréquence d'échantillonnage (FE)

11.3) Une opération de sous-échantillonnage (DNS) d'un facteur de sous-échantillonnage (IDN) égal ou inférieur à la fraction (FBP) de la fréquence d'échantillonnage (FE) occupée par la largeur de bande effective (FBW) du filtre passe bande (FPB), fournissant un signal sous-échantillonné (SAS)

Selon un aspect du procédé, l'Étape 1.1) (ASF) d'analyse sélective en fréquence fournissant à partir du signal initial (SI) une pluralité (NFA) de signaux d'analyse (SAA) comprend, pour chaque signal d'analyse (SAA), en plus l'étape suivante :

12.4) Une transformée de Fourier Glissante (TFG) dont la longueur (TFN) exprimée en nombre d'échantillons du signal sous-échantillonné (SAS) est inférieure ou égale à deux fois le facteur de sous-échantillonnage (IDN) de l'opération de sous-échantillonnage (DNS)

Selon un aspect du procédé, l'Étape 1.1) (ASF) d'analyse sélective en fréquence fournissant à partir du signal initial (SI) une pluralité (NFA) de signaux d'analyse (SAA), pour chaque signal d'analyse (SAA), est constituée par la répétition de la séquences des opérations 11.1), 11.2) et 11.3) de la revendication 11

Selon un aspect du procédé, utilisé dans le traitement du signal vocal, permettant de détecter la fréquence fondamentale (FFV) du signal vocal en détectant les éléments suivants:

VA) les pics significatifs d'amplitude d'au moins un des indicateurs suivants:

V1) l'indicateur (ITA) de détection de pics de modulation d'amplitude

V2) l'indicateur (IPS) de probabilité de présence de signal

V3) l'indicateur (IFM) de modulation de fréquence VB) la concordance dans le temps d'apparition de pics d'amplitude des indicateurs précédents

Selon un aspect du procédé l'ensemble des opérations est effectué à une vitesse adaptée pour permettre un traitement en continu de l'ensemble des fréquences analysées (FA) de la pluralité des fréquences analysées(NFA).

Les éléments de l'invention présentée ci-dessus décrivent également un dispositif d'analyse mettant en oeuvre le procédé précédent.

### 14) *Présentation de la suite du document*

La suite du présent document présentera successivement:

a) Des précisions concernant les éléments présentés ci-dessus

b) Des compléments permettant de compléter ou d'améliorer les éléments présentés ci-dessus

### 15) *(Précisions) Comparaison de l'invention avec d'autres techniques*

On comparera ici l'invention telle que décrite ci-dessus, que l'on peut qualifier de Transformée de Fourier Glissante en Bande Large (« TFG BL »), avec deux autres techniques:

1/ La technique décrite dans la section 13.9 de la Référence 1, dite « Zoom FFT »

2/ La technique décrite dans la Référence 4, que l'on peut qualifier de Transformée de Fourier Glissante centrée sur F4, soit « TFG F4 »

La Table 1 et la Table 2 ci-dessous résument pour l'invention d'une part et pour chacune des deux techniques mentionnées ci-dessus la séquence des opérations effectuées.

La Table 1 liste les opérations jusqu'à l'opération de sous-échantillonnage, la Table 2 les opérations suivantes.

## Table 1

| SEQUENCE D'OPERATIONS | TFG BL (Invention) | Zoom FFT | TFG F4 |
|---|---|---|---|
| TF INITIAL -> F0 | | X | |
| TF INITIAL -> F4 | | | X |
| TF INITIAL -> FX | X | | |
| FILTRAGE FREQUENTIEL | X | | |
| EXTRACTION AMPLITUDE INSTANTANEE & FREQUENCE INSTANTANEE | | | X |
| SOUS ECHANTILLONNAGE | X | | |

L'invention (« TFG BL ») et la « Zoom FFT » comportent une opération de sous échantillonnage. Au contraire, la « TFG F4 » ne comporte pas d'opération de sous échantillonnage. En conséquence, l'invention (« TFG BL ») et la « TFG F4 » sont donc des procédés différents.

## Table 2

| SEQUENCE D'OPERATIONS | TFG BL (Invention) | Zoom FFT | TFG F4 |
|---|---|---|---|
| DFT 3 CANAUX SIGNIFICATIFS AU MAXIMUM (Bande large) | X | | |
| EXTRACTION DE PARAMETRES (AMPLITUDE INSTANTANEE & FREQUENCE INSTANTANEE) | X | | |
| TRANSFORMEE DE FOURIER NON SPECIFIEE (DFT ou FFT; sans revendication d'un faible nomùbre de canaux significatifs) | | X | |
| EXTRACTION DE PARAMETRES D'AMPLITUDE ET DE FREQUENCE (PARAMETRES NON SPECIFIES) | | X | |

On remarque que la technique Zoom FFT est décrite en tant que principe général, mais est loin d'être complètement spécifiée puisqu'il s'agit en fait d'un traitement préalable du signal qui alimente une Transformée de Fourier ou une Transformée de Fourier rapide (FFT dans la littérature anglo-saxonne) préalablement existante.

Les trois sections suivantes expliquent:

1/ Les spécificités de l'invention par rapport à un traitement de type Zoom FFT tel que typiquement pratiqué par l'homme du métier, tel que décrit dans la Référence 1.

2/ La notion de correspondance entre indicateurs et sa spécificité dans l'invention

3/ Les effets surprenants constatés avec l'invention

**16) (Précisions) La spécificité de l'invention**

*17.1) Le fonctionnement en bande large*

Les spécificités de l'invention concernent :

1/ Les différences importantes de propriétés de largeur de bande et de temps de montée pour les indicateurs qu'il est possible de calculer avec chacune des trois techniques étudiées ci-dessus.
La Table 3 ci-dessous (« Propriétés ») résume pour l'invention d'une part et d'autre part pour chacune des deux techniques mentionnées ci-dessus ces différences
2/ La Transformée de Fourier Glissante (TFG) effectuée dans l'invention après l'opération de sous-échantillonnage, opération qui n'apporterait aucune valeur ajoutée dans le cadre d'une « Zoom FFT » classique.

Ce dernier point sera traité ci-dessous dans la section 18) « Les effets surprenants de l'invention » et ne sera pas développé dans cette section.

*17.2) Le fonctionnement en bande large*

*Un point important de l'invention est le suivant :*

➢ *Si on normalise l'amplitude maximum à une valeur de 2.Pi (ce qui n'entraîne pas de perte de généralité)*
➢ *Alors les évolutions des indicateurs calculés d'une part à partir de l'amplitude instantanée (AIS) d'un signal et d'autre part à partir de la fréquence instantanée (FIS) de ce même signal sont directement comparables car à la fois les valeurs possibles et les vitesses de variations des indicateurs sont directement comparables*

La table 3 ci-dessous liste les propriétés des indicateurs d'amplitude et de fréquence tels qu'ils résultent des spécifications ou du manque de spécifications pour chacune des trois techniques étudiées ci-dessus.

## Table 3

| PROPRIETES | TFG BL (Invention) | Zoom FFT | TFG F4 |
|---|---|---|---|
| VARIATION POSSIBLE AMPLITUDE INSTANTANEE | IDEM | | |
| VITESSE DE VARIATION POSSIBLE AMPLITUDE INSTANTANEE | ELEVEE | NON SPECIFIEE (A priori FAIBLE) | |
| VARIATION POSSIBLE FREQUENCE INSTANTANEE | ELEVEE | NON SPECIFIEE (A priori FAIBLE) | |
| VITESSE DE VARIATION POSSIBLE FREQUENCE INSTANTANEE | ELEVEE | NON SPECIFIEE (A priori FAIBLE) | |
| SUPERPOSITION ET COMPARAISON POSSIBLE D'INDICATEURS D'AMPLITUDE ET DE FREQUENCE INSTANTANEES | OUI (PAR CONSTRUCTION) | NON SPECIFIEE (A priori NON) | |

En effet :

1/ L'amplitude instantanée (AIS) peut varier entre 0 et 2.Pi, et typiquement l'amplitude instantanée (AIS) a une valeur comprise entre 0 et 60 % de la valeur maximum

2/ Il a été vu ci-dessus que la durée utile (DUF) d'une Transformée de Fourier Glissante (TFG) avec une fenêtre de Hann de longueur 12, considérée comme un filtre fréquentiel, est de l'ordre de 8 échantillons, soit un temps de montée entre une amplitude instantanée (AIS) significativement différente de zéro et la valeur maximale de cette amplitude de l'ordre de 4 échantillons

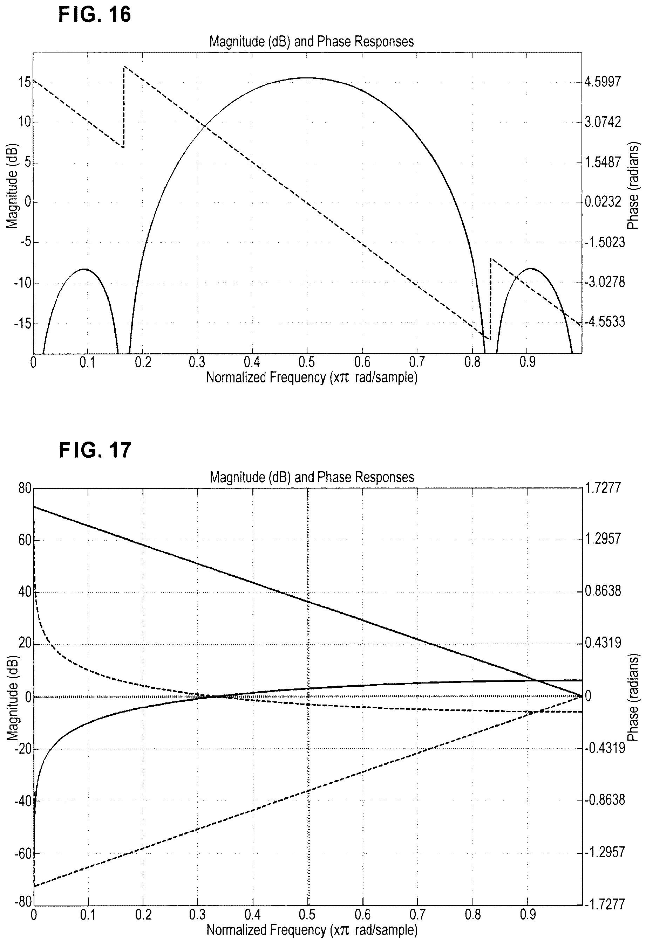

3/ La fréquence instantanée (FIS) lorsqu'elle est exprimée dans les mêmes unités que dans la Figure 17, peut varier entre -Pi et +Pi, et occupe par construction au moins 30 % de cet intervalle de variation. Des variations de la fréquence instantanée (FIS) de l'ordre de 15% du spectre sont donc possibles et sont aussi effectivement constatées.

Cette propriété de comparaison directe n'est pas revendiquée dans la littérature. Elle ne peut être obtenue, comme il a été dit ci-dessus, que par un fonctionnement en bande large.

En conséquence, dans la description précédente de l'invention, le point le plus important des signaux d'analyse (SAA) de type monocomposant à large bande est le fait qu'ils soient à large bande, c'est-à-dire des signaux d'analyse à large bande (SAL).

Le fait qu'ils soient à auto-interférence limitée provient mécaniquement des deux éléments suivants :

1/ Ils sont à large bande (ce qui est permis par l'opération de sous-échantillonnage de l'étape (AS1))
2/ Le fait que l'opération de filtrage fréquentiel passe-bas ou passe-bande non suivie d'une suppression correspondante d'échantillons (étape (AS2)) est mise en oeuvre avec un filtre dont la durée en nombre d'échantillons est très courte (par exemple et avantageusement une Transformée de Fourier Glissante (TFG) avec une telle fenêtre de Hann de longueur 12, tel qu'il a été mentionné précédemment)

Le fait qu'ils soient monocomposant peut être obtenu en choisissant les fréquences analysées (FA) et la largeur de la bande passante autour des fréquences analysées (FA) telle qu'elle résulte des étapes successives du traitement.

Dans ce qui suit, on supposera que la génération des signaux d'analyse à large bande (SAL) est effectuée avec les moyens décrits précédemment pour la génération des signaux d'analyse (SAA) de type monocomposant à large bande.

On voit donc que l'invention rend possible la comparaison directe et donc des mesures de concordance entre des indicateurs de nature différente:

1/ des indicateurs provenant de traitements effectués sur l'information d'amplitude instantanée (AIS)
2/ des indicateurs provenant de traitements effectués sur l'information de phase instantanée (PIS) ou de fréquence instantanée (FIS)

En conséquence, on pourra donc parler dans le cadre de l'invention d'indicateurs (INC), directement comparables à la fois pour les valeurs possibles et pour les vitesses de variations

### 17) (Précisions) La notion de concordance entre indicateurs

#### 17.1) La notion de concordance et le lien avec le fonctionnement en bande large

La notion de concordance entre indicateurs est une concordance temporelle de la valeur comparée ou de l'évolution temporelle comparée de divers indicateurs à un instant donné ou au voisinage d'un instant donné, typiquement dans un voisinage de +- 2 à 5 échantillons centrés autour d'un instant donné.

Cela suppose que des concordances temporelles puissent être calculées avec une précision de l'ordre de +- 1 ou échantillons, ce qui nécessite :

1/ Un fonctionnement en bande large (voir ci-dessus « La spécificité de l'invention »).
2/ L'utilisation d'un facteur de sous-échantillonnage (IDN) adapté

La section 3) « Les signaux d'analyse (SAA), de type monocomposant à large bande et à auto interférence limitée » décrit des effets du sous-échantillonnage. Ici, on remarquera tout d'abord que selon la théorie du signal (voir Référence 1 par exemple), dans une opération de sous-échantillonnage (DNS) :

> le facteur de sous-échantillonnage (IDN) (c'est-à-dire le rapport entre le nombre d'échantillons restant après sous échantillonnage et le nombre initial d'échantillons)
> doit être égal ou inférieur à la fraction du spectre occupée par la largeur de bande effective (FBW) du filtre passe bande (FPB) qui précède l'opération de suppression d'échantillons

Pour obtenir un fonctionnement optimal en bande large dans le cadre de l'invention, on se placera dans la suite du document dans le cas où le facteur de sous-échantillonnage (IDN) est égal à la fraction du spectre occupée par la largeur de bande effective (FBW) du filtre passe bande (FPB) qui précède l'opération de suppression d'échantillons (par exemple, si on ne garde qu'un échantillon sur 10, la largeur de bande effective (FBW) du filtre passe bande (FPB) qui précède l'opération de suppression d'échantillons est de 1/10$^{ème}$ de la largeur du spectre).

Avec la condition précédente, chaque échantillon d'indicateur peut être considéré comme significatif.

Des adaptations de l'invention à d'autres situations sont possibles, mais ne seront pas décrites ici.

En conséquence, dans ce contexte, il pourra être plus avantageux de spécifier la durée d'observation de (DOB) échantillons, en nombre d'échantillons du signal d'analyse à large bande. Avec un facteur de sous-échantillonnage (IDN) de 1/10$^{ème}$ comme il a été vu ci-dessus, une durée de l'ordre de 100 à 200 échantillons du signal initial (SI) est équivalente à une durée de 10 à 20 échantillons du signal d'analyse à large bande (SAL). Une telle durée sera utilisée dans le reste du document. Des observations ou des calculs pourront par ailleurs être faits avec des fenêtres temporelles d'une durée de 5 à 7 échantillons du signal d'analyse à large bande (SAL), à l'intérieur de cette durée d'observation de (DOB) échantillons.

*17.2) Les éléments sur lesquels peut porter la concordance*

Les éléments sur lesquels peut porter la concordance sont les suivants :

Co1) (pour des indicateurs quelconques) Instants d'apparition d'événements significatifs (EVS), tels que maximum, minimum, passage à zéro ou transitions rapide (mesurées sur 1, 2 ou 3 échantillons successifs)

Co2) (pour des indicateurs pour lesquels il a été trouvé ou pour lesquels il a été constaté une relation mathématique entre les valeurs) Valeurs comparées (VCI) à un instant donné

Co3) (pour des indicateurs quelconques) Evolutions comparées (ECO) sur une durée typique de 5 à 7 échantillons des courbes de variation des indicateurs

Dans le dernier cas Co3), les points importants pour établir cette concordance entre deux ou plusieurs indicateurs sont :

1/ en premier : une corrélation forte (positive ou négative) entre la forme des courbes de ces indicateurs, localement autour d'un instant donné, chaque échantillon obtenu après sous-échantillonnage étant considéré comme significatif

2/ secondairement : le fait que à des instants successifs la corrélation entre ces indicateurs soit toujours dans le même sens (positive ou négative)

On s'intéressera prioritairement aux évolutions comparées des courbes d'indicateurs au voisinage d'événements pouvant être identifiés avec une précision temporelle élevée, de l'ordre d'un échantillon ou deux.

Le fait que, à un instant donné, une corrélation donnée soit positive ou négative n'a, a priori, pas de signification particulière.

Le fait qu'une transition d'un indicateur à un instant donné soit significative doit être apprécié par rapport à la valeur moyenne de l'indicateur et à sa variance moyenne sur une durée de comparaison (DCO) qui est avantageusement de 5 à 15 échantillons précédents.

*18) (Précisions) Les effets surprenants constatés avec l'invention*

Les effets surprenants sont au nombre de six. Quatre effets concernent les indicateurs obtenus en application de l'invention :

1/ La pertinence d'un indicateur (AEL) calculé comme la dérivée temporelle seconde du logarithme (ALS) de l'amplitude instantanée du signal (AIS) pour déterminer la présence ou non d'un signal dans un bruit élevé

2/ La pertinence d'un indicateur (FDS) calculé comme la dérivée temporelle première de la Fréquence instantanée (FIS) du signal d'analyse (SAA), qui est elle-même la dérivée temporelle première de la Phase Instantanée (PIS) du signal d'analyse (SAA) pour déterminer la présence ou non d'un signal dans un bruit élevé

3/ La pertinence d'un indicateur (FDD) calculé comme la différence de fréquences instantanées entre la Fréquence instantanée (FIS) du signal d'analyse (SAA) d'une part et d'autre part la Fréquence instantanée (FID) du signal dérivé (SAD) pour déterminer la présence ou non d'un signal dans un bruit élevé

4/ La très bonne correspondance (en fait la quasi superposition) entre ces trois indicateurs

Les Figures 12 à 15 présentent divers indicateurs, avec la même disposition des signaux et des indicateurs que la Figure 10, des indicateurs calculées sur une fréquence analysée (FA) et sur les échantillons 40 à 400 (Figures 12 à 14) et 510 à 640 (Figure 15) d'un même signal vocal.

On constate en effet que :

1/ lorsqu'il existe un signal (échantillons 40 à 260 et 570 à 600) ces 3 indicateurs, calculés avec des algorithmes très différents présentent localement des corrélations temporelles positives ou négatives très significatives

2/ lorsqu'il n'existe pas de signal soit ces indicateurs restent à zéro ou ont souvent une moins bonne corrélation temporelle (par exemple autour des échantillons 295, 338, 366, 542

Nota : les échantillons 564 à 576 sont un cas particulier inévitable, car le bruit (courbe pointillée en +200) et le signal (courbe continue en +180) sont dans cet intervalle en opposition de phase, et donc se neutralisent. Il est donc très difficile, quelle que soit la méthode de calcul utilisée de détecter un signal.

On constate aussi que chacun de ces indicateurs, encore une fois calculés avec des méthodes très différentes, indiquent, au moyen d'impulsions quasi-périodiques ou de transitions similaires, la présence d'un signal périodique, et en présence de bruit ne présentent de telles impulsions qu'à des endroits isolés.

Le cinquième effet concerne la Transformée de Fourier Glissante de longueur 12 avec une fenêtre de Hann effectuée après l'opération de sous-échantillonnage (section 12.1, Etape TR3).

La Figure 16 présente la réponse en amplitude (courbe) et en phase (droites) de cette Transformée de Fourier Glissante (TFG) avec une fenêtre de Hann de longueur 12 considérée comme un filtre fréquentiel.

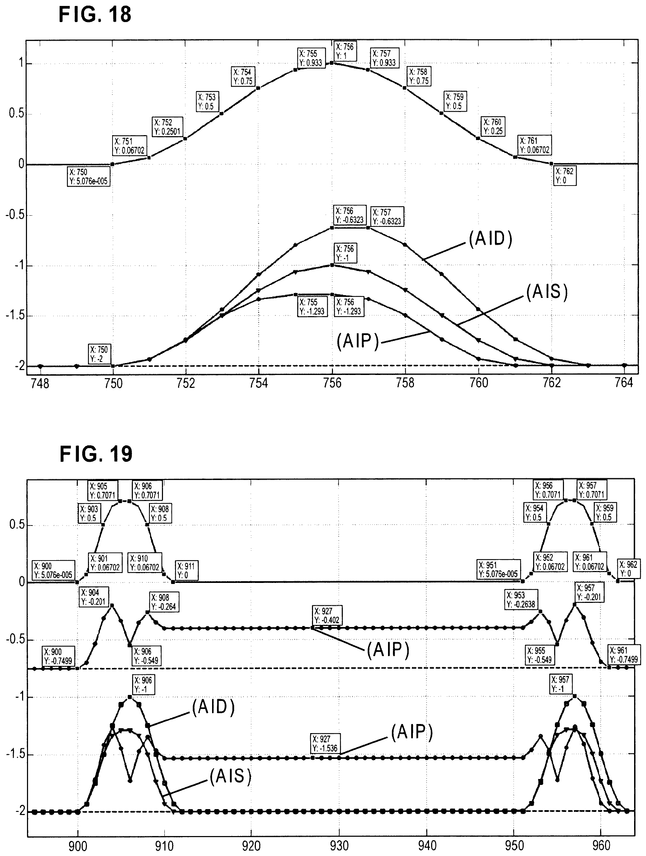

Par ailleurs, si on examine la réponse impulsionnelle d'un tel filtre (voir Figure 18 présentée ci-après), on constate que si sa durée nominale est de 12 échantillons, sa durée utile (DUF) est de l'ordre de 8 échantillons car seuls 7 à 9 échantillons centrés sur le pic d'amplitude de la réponse impulsionnelle ont une amplitude significative (de l'ordre de 10 % ou 25 % respectivement de l'amplitude maximale, ce qui correspond à 1 % ou 6,25 % de l'énergie maximale mesurée par l'amplitude).

On constate en effet que :

1/ La réponse fréquentielle (voir Figure 16), indique un faible effet, car l'atténuation d'amplitude est faible sur environ 50% du spectre de fréquences (de 0,25 à 0,75 pour un spectre de fréquences allant de 0 à 1).

2/ Une telle réponse fréquentielle est inhabituelle pour une Transformée de Fourier Glissante (TFG) en ce que le nombre de canaux fréquentiels de cette Transformée de Fourier Glissante ayant un contenu fréquentiel significativement différents des autres canaux est très inférieur à la longueur de la Transformée de Fourier Glissante (de 1 à 3 canaux fréquentiels significativement distincts pour une longueur de 12)

3/ Une telle courbe de réponse est très peu utile dans un traitement de type Zoom FFT car on cherche à avoir en sortie un nombre élevé de canaux fréquentiels ayant des informations distinctes

Une telle Transformée de Fourier Glissante (TFG) de longueur 12 avec une fenêtre de Hann est donc à la fois inhabituelle et consommatrice de ressources pour un résultat peu attractif a priori.

Toutefois, on constate que l'utilisation d'une Transformée de Fourier Glissante (TFG) avec une telle fenêtre de Hann, comparée à l'utilisation d'une Transformée de Fourier Glissante (TFG) utilisant une fenêtre rectangulaire, augmente de manière très appréciable l'immunité de l'invention au bruit, et représente donc pour l'invention :

➢ Un élément important d'immunité au bruit
➢ Un élément de différence significative par rapport à un traitement de type « Zoom FFT » classique

Le sixième et dernier effet sera examiné en fin de document. En effet, les sections 22 à 24 décrivent des indicateurs mesurés après traitement d'une sinusoïde modulée en amplitude et d'une sinusoïde d'amplitude constante modulée linéairement en fréquence, en l'absence et en présence de bruit rajouté important, ainsi que ces mêmes indicateurs après traitement d'un bruit pur, sans autre signal.

Il apparaîtra alors que le degré de corrélation temporelle entre:

> d'une part, un indicateur calculé à partir d'informations d'amplitude instantanée
> d'autre part, plusieurs indicateurs de fréquence instantanée

Fournira un indicateur de présence de signal détectable et d'estimation du rapport signal sur bruit

## 19) (Précisions) Reformulation du procédé de traitement de l'invention

En fonction des éléments précédents le procédé de traitement selon l'invention peut être reformulé de la manière suivante, en cherchant à être aussi général que possible et en remarquant que toute Translation de Fréquence (TFR) complexe est une opération inversible, et qui donc ne change pas le contenu en information d'un signal:

**Procédé de traitement** d'un signal initial (SI) au **moyen d'une pluralité (NFA) de fréquences analysées (FA)** dans ledit signal initial (SI), composé d'un signal utile (SU) composé d'une somme de signaux élémentaires (SEL), représentatif d'une onde qui se propage dans un milieu physique, auquel peut s'ajouter un bruit ajouté (BRA), ledit procédé étant mis en oeuvre sur une séquence d'échantillons (SE), échantillonnés à une fréquence d'échantillonnage (FE) constante, obtenus à partir d'un signal initial (SI) ledit procédé comprenant une étape (ASF) d'analyse sélective en fréquence fournissant à partir du signal initial (SI) une pluralité (NFA) de signaux d'analyse (SAL) à large bande, chaque signal d'analyse (SAL) correspondant à une des fréquences analysées (FA), ladite étape comprenant les sous-étapes suivantes :

- AS1) une succession d'opérations de sous-échantillonnage, composée chacune d'un filtrage fréquentiel passe-bas ou passe-bande et d'une suppression correspondante d'échantillons
- AS2) au moins une opération de filtrage fréquentiel passe-bas ou passe-bande non suivie d'une suppression correspondante d'échantillons
- AS3) zéro ou plus Translation de Fréquence complexe qui amène la fréquence analysée à une première fréquence de travail (FTA) adaptée à calculer l'Amplitude instantanée et à une deuxième fréquence de travail (FTP) adaptée à calculer la Phase Instantanée et la Fréquence Instantanée du signal d'analyse,

De plus, il est particulièrement avantageux que l'opération de filtrage fréquentiel de l'étape AS2) soit réalisée avec un filtre fréquentiel dont la durée utile (DUF) exprimée en nombre d'échantillons est inférieure ou égale à 12, et avantageusement égale à 8, et dont la bande passante occupe au moins 30 % du spectre du signal en sortie de l'étape AS1)

Fréquemment, dans des situations concrètes assez générales, le traitement suivant, particulièrement simple, peut être très avantageux:

- AS10) une succession d'opérations de sous-échantillonnage, composée chacune d'un filtrage fréquentiel passe-bas autour de la fréquence nulle (F0) ou passe bande autour de la fréquence (F4) égale au quart de la fréquence d'échantillonnage (FE), et d'une suppression correspondante d'échantillons
- AS20) au moins une opération de filtrage fréquentiel passe-bas autour de la fréquence nulle (F0) ou passe-bande autour de la fréquence (F4) égale au quart de la fréquence d'échantillonnage (FE), non suivie d'une suppression correspondante d'échantillons réalisée avec un filtre fréquentiel dont la durée utile (DUF) exprimée en nombre d'échantillons est inférieure ou égale à 12, et avantageusement égale à 8, et dont la bande passante occupe au moins 30 % du spectre du signal en sortie de l'étape AS1)
- AS30) zéro ou plus Translation de Fréquence complexe qui amène la fréquence analysée à la fréquence (F4) égale au quart de la fréquence d'échantillonnage (FE), adaptée à calculer l'Amplitude instantanée, la Phase Instantanée et la Fréquence Instantanée du signal d'analyse.

Enfin, encore avantageusement, l'étape précédente AS20) peut être mise en oeuvre, autour de la fréquence (F4) égale au quart de la fréquence d'échantillonnage (FE), de la manière suivante, et l'étape AS30) dans ce cas ne pas nécessiter de Translation de Fréquence complexe:
AS200) Une opération de filtrage fréquentiel passe-bande de fréquence centrale la fréquence (F4) égale au quart de la fréquence d'échantillonnage (FE), non suivie d'une suppression correspondante d'échantillons, réalisée par une Transformée de Fourier Glissante (TFG) de longueur 12 avec une fenêtre de Hann, en se limitant au canal fréquentiel centré sur la fréquence (F4) égale au quart de la fréquence d'échantillonnage (FE)
(voir Figure 16 pour la réponse fréquentielle de cette Transformée de Fourier Glissante (TFG))

Il est donc possible et avantageux en termes de simplicité de calcul de mettre en oeuvre l'invention par un procédé utilisant les deux seules étapes AS10) et AS200). Dans ce cas, on remarquera que:

1/ Il est usuel et avantageux pour la simplicité de calcul d'effectuer les opérations de sous-échantillonnage (filtrage fréquentiel+suppression d'échantillons) autour de la fréquence nulle (F0), si nécessaire après Translation de Fréquence complexe pour amener la fréquence centrale du signal à la fréquence nulle (F0)
2/ Le passage de la fréquence nulle (F0) à la fréquence (F4) égale au quart de la fréquence d'échantillonnage (FE) n'implique pas translation complexe de fréquence (TFR) effective, car elle ne nécessite pas de multiplications par des nombres autres 0, +1 ou -1. Le procédé n'implique donc, dans cette mise en oeuvre, qu'une seule translation complexe de fréquence (TFR) effective, et ces deux fréquences peuvent donc en pratique être considéré comme équivalentes pour les opérations de filtrage fréquentiel.

Il existe toutefois une grande diversité de manières de combiner des opérations de translation de fréquence et de sous-échantillonnage, qui peuvent être chacune avantageuse dans des situations particulières. La Référence 1 décrit diverses méthodes à cet effet.

### 20) (Précisions) Les contraintes et les avantages de l'utilisation de la dérivée temporelle du signal

#### 20.1) Propriétés et mise en oeuvre de la dérivée temporelle

La Figure 17 (courbes en traits plein) représente la réponse en amplitude (courbe) et en phase (droite) du filtre numérique différence première (valeur d'un échantillon à l'instant N moins valeur de l'échantillon à l'instant N-1), avec une échelle logarithmique en ordonnée, et une échelle linéaire en abscisse (fréquence normalisée variant entre +Pi et -Pi).

Ce filtre est une mise en oeuvre possible et simple d'un différentiateur. Pour un signal complexe, ce filtre est appliqué indépendamment à la composante en X et à la composante en Y.

La ligne pointillée verticale représente la fréquence F4 égale au quart de la fréquence d'échantillonnage, et la ligne pointillée horizontale un gain de 1 en amplitude et un délai en phase de zéro.

On observe que :

1/ la réponse en phase est linéaire
2/ le filtre présente un zéro à la fréquence zéro
3/ le filtre est sensiblement linéaire en amplitude au voisinage de la fréquence F4 égale au quart de la fréquence d'échantillonnage

Il est donc nécessaire que le signal à différencier contienne aussi peu de fréquences voisines de la fréquence nulle (F0) que possible. On constate par exemple que la réponse de ce différentiateur simple à un signal de bande passante centrée sur la fréquence F4 égale au quart de la fréquence d'échantillonnage (0.5 sur la Figure 17) peut avoir une largeur de bande allant de la fréquence 0.3 à la fréquence 0.7 (soit 40% du spectre possible) sera à phase linéaire et avec un gain en amplitude qui varie de manière significativement linéaire.

#### 20.2) L'utilisation de la dérivée temporelle

L'invention rend donc possible la comparaison directe, et donc les mesures de concordance définies précédemment entre des indicateurs d'amplitude instantanée (AIS), de phase instantanée (PIS) ou de fréquence instantanée (FIS) provenant:

1/ d'une part, de traitements effectués sur un signal d'analyse à bande large (SAL)
2/ d'autre part, de traitements effectués sur un signal de dérivée temporelle (SAD) de ce signal d'analyse à bande large (SAL)

Nota : La Référence 1 (section 7.1.1 « Simple Differentiators » indique que le délai de groupe du filtre numérique différence première est de 1/2 échantillon. Ce délai doit être pris en compte, notamment lorsqu'on calcule la différence entre, par exemple, d'une part l'amplitude, la phase ou la fréquence instantanées du signal d'analyse à bande large (SAL) et d'autre part la même information relative au signal de dérivée temporelle (SAD) de ce signal d'analyse à bande large (SAL).

### 21) (Compléments) L'utilisation de la primitive temporelle du signal et ses propriétés

#### 21.1) Définition et mise en oeuvre de la primitive temporelle

Il a été vu précédemment que la comparaison du signal et de sa dérivée temporelle fournissait des informations et des indicateurs pertinents pour la détection et l'analyse d'un signal, en particulier un signal sinusoïdal, avec un bruit important ajoutée. En particulier, la différence de phase entre le signal et sa dérivée temporelle (qui correspond à la phase du quotient du signal et de sa dérivée temporelle) a été examinée en détail.

La comparaison du signal et de sa primitive temporelle fournit d'autres informations et indicateurs pertinents dans le même domaine.

De la même manière que l'opérateur de dérivation temporelle a été mis en oeuvre par l'opérateur de différence première (la différence entre la valeur du signal à un instant N et sa valeur à l'instant N-1, différence réalisée indépendamment pour les composantes X et Y d'un signal complexe(, l'opérateur primitive temporelle est mis en oeuvre par la somme cumulée du signal entre les instants zéro et N, somme réalisée indépendamment pour les composantes X et Y d'un signal complexe.

On remarque que ces deux opérateurs (différence et somme cumulée) sont l'inverse l'un de l'autre : l'application de l'un des deux puis de l'autre redonne le signal initial.

*21.2) Propriétés de la primitive temporelle*

Les propriétés de la somme cumulée considérée comme un filtre fréquentiel sont données par les courbes en trait tireté de la Figure 17 (la courbe est la réponse en amplitude et la droite est la réponse en phase). On constate bien que les propriétés de ce filtre sont inverses de celle du filtre de différence.

On constate en particulier que l'opérateur somme cumulée a :

> A la fréquence (F4) égale au quart de la fréquence d'échantillonnage, un gain en amplitude proche de celui de l'opérateur différence première

> A la fréquence nulle (F0), un gain infini (pôle)

En conséquence l'opérateur somme cumulée devra opérer sur des signaux ne présentant pas de composante fréquentielle à la fréquence nulle (F0), c'est-à-dire pas de composante continue, et opérer sur des signaux centrés sur la fréquence (F4) égale au quart de la fréquence d'échantillonnage s'avère particulièrement avantageux.

L'intérêt de l'opérateur somme cumulée sera mieux apprécié en examinant sa réponse impulsionnelle et surtout sa réponse à une marche d'un signal ne présentant pas de composante continue.

*21.3) Réponse à une impulsion*

La Figure 18 montre la réponse en sortie de l'invention, c'est-à-dire en sortie de la Transformée de Fourier Glissante (TFG) située en sortie de l'opération de sous-échantillonnage (ici de longueur 12 avec une fenêtre de Hann) à une impulsion en sortie de l'opération de sous-échantillonnage et avant application de filtre de dérivée temporelle ou de primitive temporelle:

1/ La courbe supérieure (commençant en zéro) montre l'évolution de l'amplitude instantanée (AIS) du signal d'analyse à bande large (SAL) suite à une impulsion commençant à l'échantillon 750 (valeur en sortie de l'opération de sous-échantillonnage)

2/ Les 3 courbes inférieures (commençant en -2) sont respectivement :

2.a/ La courbe du milieu, avec les marqueurs en triangle, est la même que la courbe commençant en zéro (amplitude instantanée (AIS) du signal d'analyse à bande large (SAL))

2.b/ La courbe supérieure, avec les marqueurs en carré, est la courbe de l'amplitude instantanée (AID) du signal dérivée temporelle (SAD) du signal d'analyse à bande large (SAL)

2.c/ La courbe inférieure, avec les marqueurs en cercle, est la courbe de l'amplitude instantanée (AIP) du signal primitive temporelle (SAP) du signal d'analyse à bande large (SAL)

On remarque les points suivants :

1/ La courbe commençant en zéro montre les valeurs permettant de calculer la durée utile du filtre (DUF) pour la Transformée de Fourier Glissante (TFG) de longueur 12 avec une fenêtre de Hann

2/ Les trois courbes commençant en -2 ont la même forme générale, et des durées voisines mais différant de +-1 par rapport à la courbe de l'amplitude instantanée (AIS) du signal d'analyse à bande large (SAL)

En conséquence, les réponses des signaux suivants:

> signal d'analyse à bande large (SAL)
> signal dérivée temporelle (SAD) du signal d'analyse à bande large (SAL)
> signal primitive temporelle (SAP) du signal d'analyse à bande large (SAL) à une impulsion en entrée du procédé constituant l'invention sont qualitativement les mêmes.

*21.4) Réponse à une marche*

La Figure 19 montre (avec la même disposition que la Figure 18 plus une courbe au milieu) la réponse en sortie de l'invention, c'est-à-dire en sortie de la Transformée de Fourier Glissante (TFG) située en sortie de l'opération de sous-échantillonnage (ici de longueur 12 avec une fenêtre de Hann) à une marche en sortie de l'opération de sous-échantillonnage et avant application de filtre de dérivée temporelle ou de primitive temporelle :

1/ La courbe supérieure (commençant en zéro) montre l'évolution de l'amplitude instantanée (AIS) du signal d'analyse à bande large (SAL) suite à une marche commençant à l'échantillon 900 et se terminant à l'échantillon 950 (valeur en sortie de l'opération de sous-échantillonnage)

2/ Les 3 courbes inférieures (commençant en -2) sont respectivement :

2.a/ La courbe du milieu, avec les marqueurs en triangle, est la même que la courbe commençant en zéro (amplitude instantanée (AIS) du signal d'analyse à bande large (SAL))

2.b/ La courbe supérieure, avec les marqueurs en carré, est la courbe de l'amplitude instantanée (AID) du signal dérivée temporelle (SAD) du signal d'analyse à bande large (SAL)

2.c/ La courbe inférieure, avec les marqueurs en cercle, est la courbe de l'amplitude instantanée (AIP) du signal primitive temporelle (SAP) du signal d'analyse à bande large (SAL)

La courbe commençant en -0.75 est la reprise de la courbe de l'amplitude instantanée (AIP) du signal primitive temporelle (SAP) du signal d'analyse à bande large (SAL) pour mieux mettre en évidence sa forme particulière.

Nota : la description intuitive du signal et du traitement utilisés pour obtenir ces réponses est la suivante :

a) On part, en sortie de l'opération de sous-échantillonnage et avant application d'un filtre de dérivée temporelle ou de primitive temporelle, d'une composante continue (donc de fréquence nulle (F0)) d'amplitude zéro puis d'amplitude constante puis à nouveau d'amplitude zéro

b) On applique ensuite une translation de fréquence complexe pour amener la fréquence nulle (F0) vers la fréquence (F4) égale au quart de la fréquence d'échantillonnage

c) On applique ensuite la Transformée de Fourier Glissante (TFG), en se limitant au canal fréquentiel centré sur la fréquence (F4) égale au quart de la fréquence d'échantillonnage (F4)

Si on applique une impulsion ou une marche comme signal initial (SI) en entrée du procédé constituant l'invention, on obtient une réponse impulsionnelle de forme très voisine, avec une durée très voisine et une réponse à une marche de durée très voisine, avec aussi deux pics au début et à la fin, et un plateau d'amplitude supérieure à celui du premier ou dernier pic.

On remarque les points suivants :

1/ La courbe de l'amplitude instantanée (AIS) du signal d'analyse à bande large (SAL) et la courbe de l'amplitude instantanée (AID) du signal dérivée temporelle (SAD) du signal d'analyse à bande large (SAL) présentent deux pics correspondant à l'impulsion de début puis à l'impulsion de fin de la marche

2/ la courbe de l'amplitude instantanée (AIP) du signal primitive temporelle (SAP) du signal d'analyse à bande large (SAL) a une forme particulière et qualitativement différente :

2.1/ A l'intérieur de la durée de la réponse impulsionnelle de la Transformée de Fourier Glissante (TFG) de longueur 12 avec une fenêtre de Hann (durée nominale de 12 échantillons) la réponse présente une marche montante ou descendante et des oscillations

2.2/ A l'extérieur de cette durée de la réponse impulsionnelle de la Transformée de Fourier Glissante (TFG) de longueur 12 avec une fenêtre de Hann mais à l'intérieur de la durée de la marche (échantillons 910 à 950) l'amplitude instantanée (AIP) du signal primitive temporelle (SAP) du signal d'analyse à bande large (SAL) est constante mais a une valeur différente de zéro (présence d'un plateau)

*21.5) L'utilisation de la primitive temporelle*

En conséquence, les réponses des signaux suivants:

> signal d'analyse à bande large (SAL)

> signal dérivée temporelle (SAD) du signal d'analyse à bande large (SAL) à une marche en signal d'entrée du procédé constituant l'invention sont qualitativement les mêmes, car l'amplitude présente deux pics réguliers au début et à la fin de la marche et descend à zéro à l'intérieur de la marche.

En revanche, la réponse au signal primitive temporelle (SAP) du signal d'analyse à bande large (SAL) est qualitativement différente et démontre les deux propriétés spécifiques 2.1/ et 2.2/ ci-dessus qui seront utiles pour construire de nouveaux indicateurs

On voit donc que l'invention rend possible la comparaison et donc des mesures de concordance entre :

1/ d'une part des indicateurs d'amplitude instantanée (AIS), de phase instantanée (PIS) ou de fréquence instantanée (FIS) provenant de traitements effectués sur un signal d'analyse à bande large (SAL)

2/ d'autre part des indicateurs d'amplitude instantanée (AIS), de phase instantanée (PIS) ou de fréquence instantanée (FIS) provenant de traitements effectués sur un signal le primitive temporelle (SAP) de ce signal d'analyse à bande large (SAL)

Nota : La Figure 17 montre que les courbes de réponse fréquentielles de la différence première et de la somme cumulée sont inverses ou opposées l'une de l'autre. En conséquence, le filtre numérique somme cumulée a un délai de groupe de 1/2 échantillon, de signe opposé à celui du filtre numérique différence première. Ce délai doit aussi être pris en compte, notamment lorsqu'on calcule la différence entre, par exemple, d'une part l'amplitude, la phase ou la fréquence instantanées du signal d'analyse à bande large (SAL) et d'autre part la même information relative au signal de primitive temporelle (SAP) de ce signal d'analyse à bande large (SAL).

### 21.6) Les aspects spécifiques de la primitive temporelle

L'opérateur primitive temporelle dans son principe présente une différence importante par rapport à l'opérateur de dérivée temporelle :

> Avec l'opérateur de dérivée temporelle il est possible, comme il a été vu précédemment, d'obtenir dans le cas général des relations mathématiques explicites entre un signal et sa dérivée temporelle
> Avec l'opérateur de primitive temporelle il n'est pas possible, dans le cas général, d'obtenir des relations mathématiques explicites entre un signal et sa dérivée temporelle

La mise en oeuvre de l'opérateur primitive temporelle par une somme cumulée présente aussi une différence qualitative importante par rapport à la mise en oeuvre de l'opérateur dérivée temporelle par une différence première :

> Une différence première est un filtre à durée de réponse finie et a une mémoire très courte
> Une somme cumulée est un filtre à durée de réponse potentiellement infinie et a donc une mémoire de durée significative. Des comportements de type oscillatoire sont donc possibles

### 22) (Précisions & Compléments) Traitement d'une sinusoïde modulée en amplitude selon l'invention

### 22.1) Le signal utile (SU)

Le signal utile (SU) du signal initial (SI) se compose de :

1/ une sinusoïde d'amplitude constante 1 et de fréquence un dixième (1/10$^{\text{ème}}$) de la fréquence (F4) égale à un quart de la fréquence d'échantillonnage (FE) (voir ci-après), appelée fréquence porteuse (FPO)
2/ multipliée (opération de modulation d'amplitude) par le signal suivant, appelé signal modulant en amplitude (SMA) :

$$( 1 + (\text{rampe linéaire}) \ X \ ( \text{sinusoide} )$$

Dans lequel :

> la rampe linéaire vaut zéro au début et 1 à la fin
> la sinusoide, appelée fréquence modulante en amplitude (FMA), est de fréquence constante égale à un trente-cinqième (1/35$^{\text{ème}}$) de la fréquence (F4) égale à un quart de la fréquence d'échantillonnage (FE)

La séquence d'échantillons (SE) correspondante se compose de 6.000 échantillons, échantillonnés à une fréquence d'échantillonnage (FE) de 8.000 Hertz.

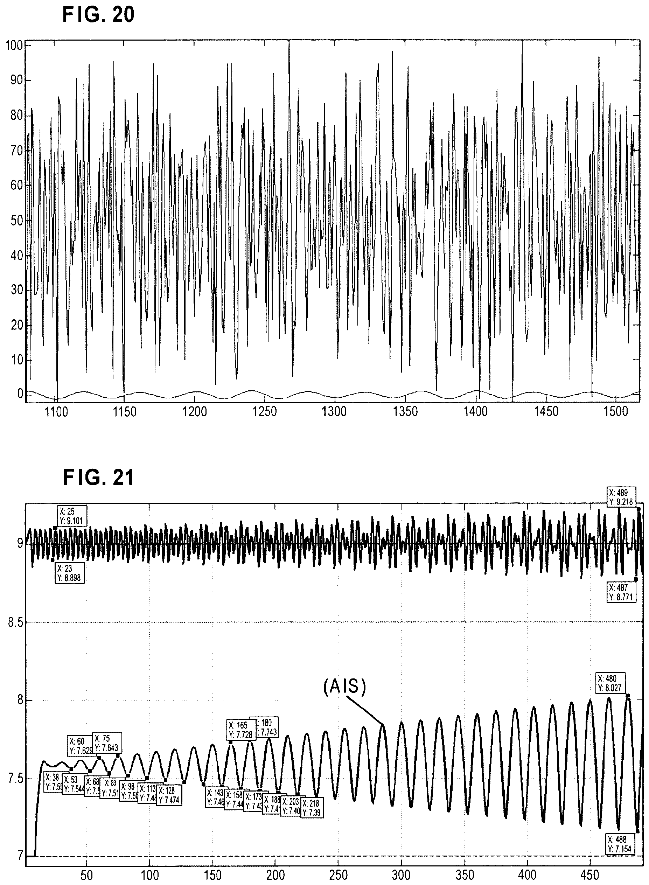

La Figure 21 représente :

> (courbe supérieure) le signal après l'opération de sous-échantillonnage d'un facteur 10 (le signal se compose alors de 600 échantillons)
> (courbe inférieure) l'amplitude instantanée (AIS) du signal d'analyse à large bande (SAL)

On voit que cette l'amplitude instantanée (AIS) a deux composantes :

1/ une composante d'amplitude constante, qui représente la fréquence porteuse (FPO)
2/ une composante variable qui s'ajoute ou se retranche à la composante précédente et qui représente signal modulant en amplitude (SMA), qui est dans le cas présent une sinusoïde d'amplitude croissante

### 22.2) Le bruit rajouté (BRA)

Le bruité rajouté (BRA) qui sera ou non rajouté est obtenu à partir d'un générateur de nombre aléatoire, limité en fréquence à 10% et 90% de la moitié de la fréquence d'échantillonnage (FE), et normalisé pour que la valeur de crête soit inférieure ou égale à 64.
On examinera le traitement selon l'invention du signal utile (SU) seul puis de la somme du signal utile (SU) et du bruit rajouté (BRA).

### 22.3) Le rapport Signal sur bruit (SNR)

Dans le signal initial (SI), le signal utile (SU) varie au maximum entre +-2, et le bruit ajouté varie entre +-64, soit un rapport sur bruit (SNR) de 32, soit $2^5$, soit 30 db.
Toutefois, comme le montre la Figure 21, au début du signal, le signal utile (SU) varie entre +-1, ce qui fait que le rapport sur bruit (SNR) est de 32, soit 36 db, et cette valeur correspond au rapport sur bruit (SNR) de la fréquence porteuse (FPO). Pour le signal modulant en amplitude (SMA), le rapport sur bruit (SNR) est beaucoup plus défavorable, car ce signal modulant en amplitude (SMA) est très faible au début du signal. Si on considère que ce signal modulant en amplitude (SMA) est 8 fois plus faible que la fréquence porteuse (FPO) au début du signal, le rapport sur bruit (SNR) rapporté au signal modulant en amplitude (SMA) est de 36 db + 18 db = 54 db.

### 22.4) Les informations observées

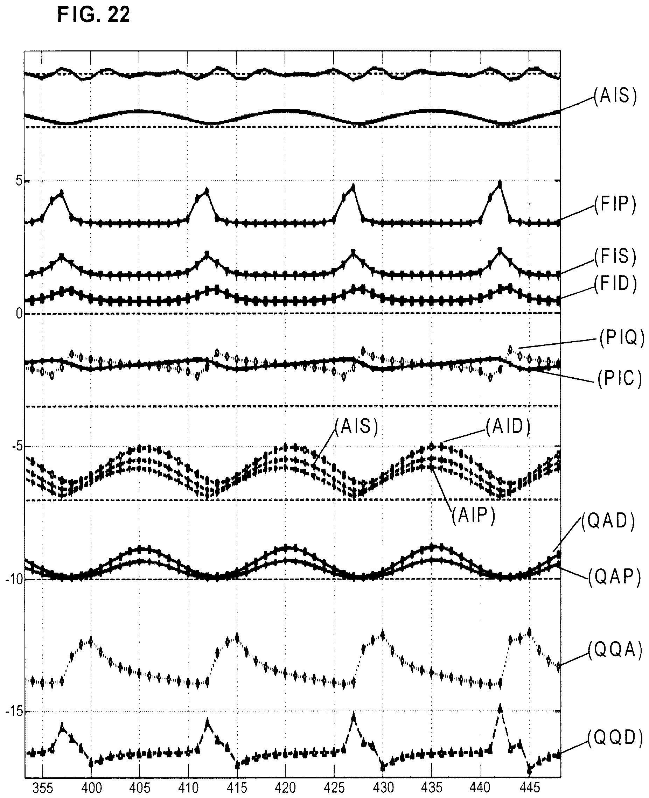

La Figure 22 représente les informations observées relatives au signal d'analyse à large bande, avec une échelle linéaire en temps en abscisse, et une échelle linéaire en ordonnée. Ces informations sont les suivantes, du haut vers le bas :

O1/ Le signal utile (SU) après l'opération de sous-échantillonnage, effectuée à la fréquence nulle (F0)
O2/ L'amplitude instantanée (AIS)
O3/ Trois fréquences instantanées :

O31/ La Fréquence instantanée de la primitive temporelle du signal (FIP), avec des marqueurs ronds
O32/ La Fréquence instantanée du signal (FIS), avec des marqueurs en triangle
O33/ La Fréquence instantanée de la dérivée temporelle du signal (FID), avec des marqueurs carrés

O4/ Deux différences de phase instantanée:

O41/ La différence de phase instantanée (PIC) entre d'une part la phase instantanée de la dérivée temporelle du signal (PID) et d'autre part la phase instantanée du signal (PIS)
O42/ La différence de phase instantanée (PIQ) entre d'une part la phase instantanée de la primitive temporelle du signal (PIP) et d'autre part la phase instantanée du signal (PIS)

O5/ Trois amplitudes instantanées :

O51/ L'amplitude instantanée (AIP) de la primitive temporelle (SAP) du signal d'analyse à large bande (SAL), avec des marqueurs ronds
O52/ L'amplitude instantanée (AIS) du signal d'analyse à large bande (SAL), avec des marqueurs en triangle
O53/ L'amplitude instantanée (AID) de la dérivée temporelle (SAD) du signal d'analyse à large bande (SAL), avec des marqueurs carrés

O6/ Deux quotients concernant ces trois amplitudes instantanées :

O61/ Le quotient (QAD) entre les amplitudes instantanées de la dérivée temporelle du signal (AID) d'une part et du signal (AIS) d'autre part, avec des marqueurs carrés
O62/ Le quotient (QAP) entre les amplitudes instantanées du signal (AIS) d'une part, et de la primitive temporelle du signal (AIP), avec des marqueurs ronds

O7/ Le quotient (QQA) des deux quotients d'amplitude, définis en O61/ et O62/
O8/ La dérivée temporelle (QQD) du quotient (QQA) des deux quotients d'amplitude

Nota : Les comparaisons entre amplitudes instantanées du signal, de sa dérivée temporelle et de sa primitive temporelle ont été présentées ci-dessus sous forme de quotients. Il est important de remarquer que ces comparaisons peuvent être faites, de manière mathématiquement équivalente, sous la forme de différences de logarithmes de ces amplitudes instantanées, de la même manière que les comparaisons entre phases instantanées ou de fréquences instantanées se font par différence.

*22.5) Les résultats observés en l'absence de bruit*

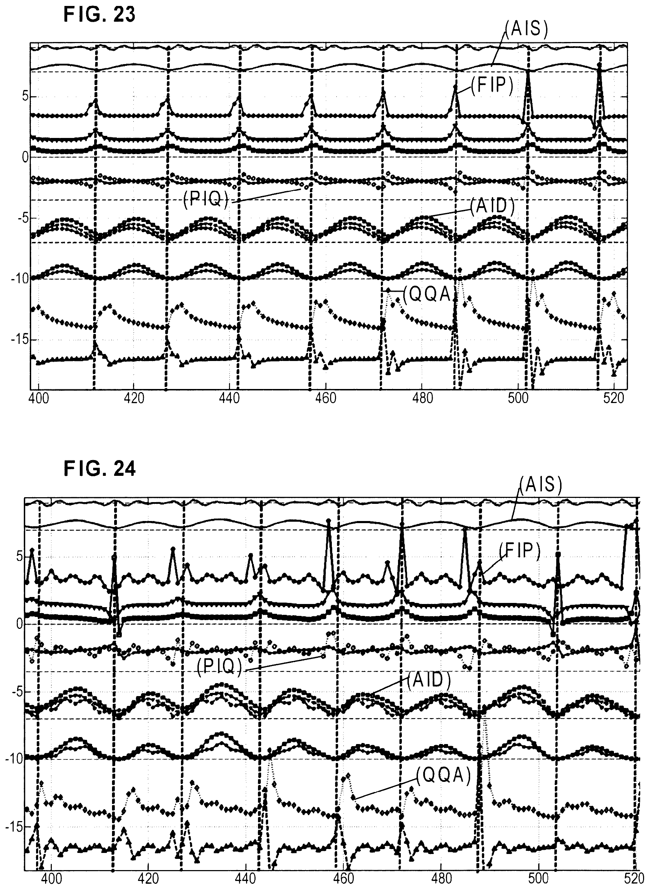

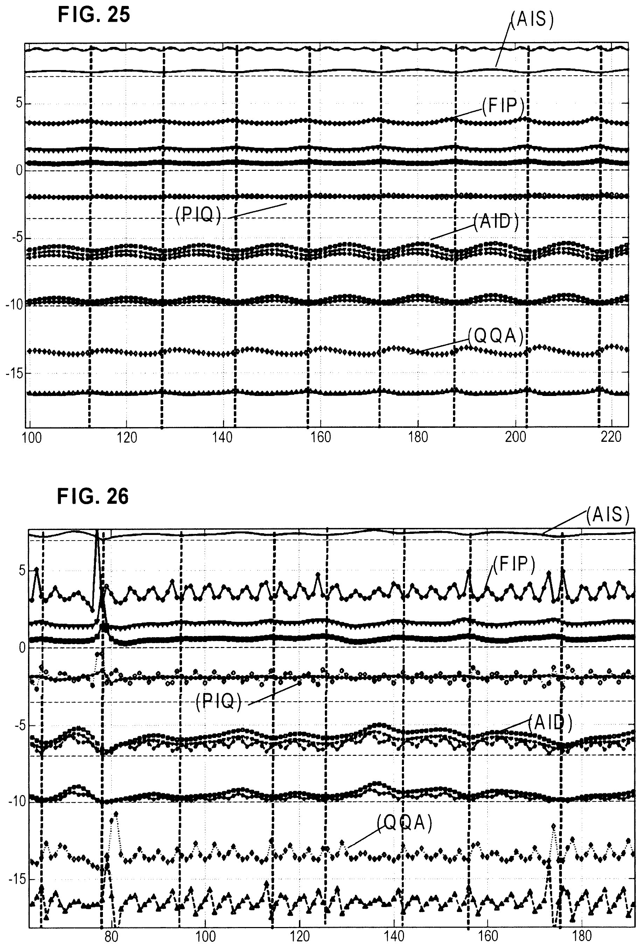

Les Figures 23 et 25 montrent les observations effectuées avec le signal utile (SU) décrit ci-dessus sans bruit ajouté, en fin de signal et en début de signal respectivement (les numéros d'échantillons des Figures 23 à 26 correspondent).
On remarque notamment :

RA1/ la très bonne concordance entre les indicateurs, mise en évidence par les lignes verticales pointillées
RA2/ les variations très significatives des observations lorsque la modulation d'amplitude est forte (Figure 23) et moins significatives la modulation d'amplitude est faible (Figure 25)
RA3/ les impulsions de hauteur croissante pour la fréquence instantanée (FIP) de la primitive temporelle du signal (FIP), avec des marqueurs ronds
RA4/ les impulsions de hauteur croissante pour la dérivée temporelle (QQD) du quotient (QQA) des deux quotients d'amplitude (dernière courbe en partant du haut),
RA5/ le fait que la dérivée temporelle (QQD) du quotient (QQA) des deux quotients d'amplitude présente des impulsions dont la hauteur varie de manière parallèle à celle de la fréquence instantanée de la primitive temporelle du signal (FIP)
RA6/ Une forme identique pour les trois courbes d'amplitudes instantanées
RA7/ Une faible variance pour les deux différences de phase instantanées (les différences correspondantes de fréquences instantanées sont nulles ou très faibles)

Nota : Les pics observés sur les courbes de fréquences instantanées, et en particulier la fréquence instantanée (FIP) de la primitive temporelle du signal (FIP), sont typiques de l'observation de la fréquence instantanée qui comporte deux fréquences (voir notamment Référence 13, sections 10.6 et 10.7).

*22.6) Les résultats observés en présence de bruit*

La Figure 24 montre les observations effectuées avec le signal utile (SU) décrit ci-dessus avec bruit ajouté, dans un cas de figure où ce bruit ajouté important (voir Figure 20) apporte peu de modifications (les échantillons observés sont les mêmes que dans la Figure 23, et correspondent à une forte modulation d'amplitude, voir Figure 21).
On remarque notamment :

RAB1/ La moins bonne (mais réelle) concordance entre les indicateurs, mise en évidence par les lignes verticales pointillées
RAB2/ La assez bonne concordance entre les indicateurs (lignes verticales pointillées) et la fréquence effective du signal modulant en amplitude (SMA)
RAB3/ Une courbe de l'amplitude instantanée (AIP) de la primitive temporelle (SAP) du signal d'analyse à large bande (SAL) qui présente une modulation à une fréquence différente de celle du signal modulant en amplitude (SMA) (courbe du bas)
RAB4/ Les deux autres courbes d'amplitudes instantanées sont une version légèrement déformées de la version sans bruit, sans nouvelle modulation
RAB5/ Une différence de variance entre les deux différences de phase instantanées (celle impliquant la primitive temporelle est forte, l'autre reste faible) ; la même remarque pourrait être faite pour les différences correspondantes de fréquences instantanées

La Figure 25 montre les observations effectuées avec le signal utile (SU) décrit ci-dessus avec bruit ajouté, dans un cas de figure où ce bruit ajouté important (voir Figure 20) apporte des modifications importantes (les échantillons observés ne sont pas les mêmes que dans la Figure 23, et correspondent à une faible modulation d'amplitude, voir Figure 21).

On remarque notamment :

RAB3/ Une moins bonne concordance entre les indicateurs, mise en évidence par les lignes verticales pointillées
RAB4/ La moins bonne (détectable, mais peu précise) concordance entre les indicateurs, mise en évidence par les lignes verticales pointillées
RAB5/ La moins bonne concordance entre les indicateurs (lignes verticales pointillées) et la fréquence effective du signal modulant en amplitude (SMA)
RAB6/ Une courbe de l'amplitude instantanée (AIP) de la primitive temporelle (SAP) du signal d'analyse à large bande (SAL) qui présente une modulation à une fréquence différente de celle du signal modulant en amplitude (SMA) (courbe du bas)
RAB7/ Les deux autres courbes d'amplitudes instantanées sont une version assez déformées de la version sans bruit, sans nouvelle modulation (voir RAB4/)
RAB8/ Une différence de variance entre les deux différences de phase instantanées (celle impliquant la primitive temporelle est forte, l'autre reste faible) ; la même remarque pourrait être faite pour les différences correspondantes de fréquences instantanées (voir RAB5/)

### 23) (Compléments) Traitement d'une sinusoïde modulée linéairement en fréquence (chirp linéaire) selon l'invention

#### 23.1) Le signal utile (SU)

Le signal utile (SU) est une sinusoïde de 6.000 échantillons, d'amplitude constante, dont la fréquence varie linéairement de 0 à 240 Hz.

#### 23.2) Le bruit rajouté (BRA)

Le bruit ajouté (BRA) est le même que pour ci-dessus pour le signal sinusoïdal.

#### 23.3) Le rapport Signal sur bruit (SNR)

Le rapport sur bruit (SNR) évolue en raison de l'évolution de la fréquence du signal, qui est initialement inférieure à la fréquence des filtres fréquentiels, puis égale, puis supérieure à la fréquence des filtres fréquentiels.
Le rapport signal sur bruit (SNR) est donc très défavorable en début et en fin de signal (lorsque les amplitudes instantanées sont faibles ou très faibles) et le moins défavorable un peu après le milieu du signal (lorsque l'amplitude instantanée est maximale).

#### 23.4) Les informations observées

Les informations observées sont les mêmes que pour le signal précédent et sont présentées en Figure 22.

#### 23.5) Les résultats observés en l'absence de bruit

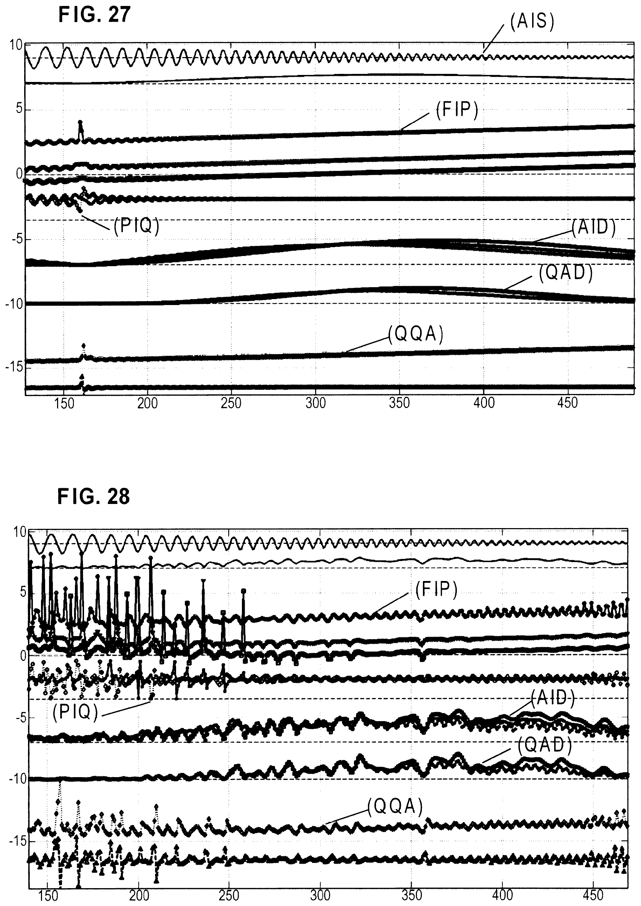

La Figure 27 montre une vue d'ensemble les observations effectuées avec le signal utile (SU) décrit ci-dessus sans bruit ajouté.
On remarque notamment :

RC1/ la très bonne concordance entre les trois indicateurs de fréquence instantanée, dont les courbes sont parallèles
RC2/ le comportement de la courbe de l'indicateur (QQA) de quotients d'amplitude, qui est parallèle aux trois courbes des indicateurs de fréquence instantanée, alors que cet indicateur est calculé exclusivement à partir d'informations d'amplitude instantanée

RC3/ l'identité de forme mais le décalage temporel des trois courbes d'amplitude instantanée
RC4/ Une très faible variance pour les deux différences de phase instantanée (les différences correspondantes de fréquences instantanées sont nulles ou très faibles)

*23.6) Les résultats observés en présence de bruit*

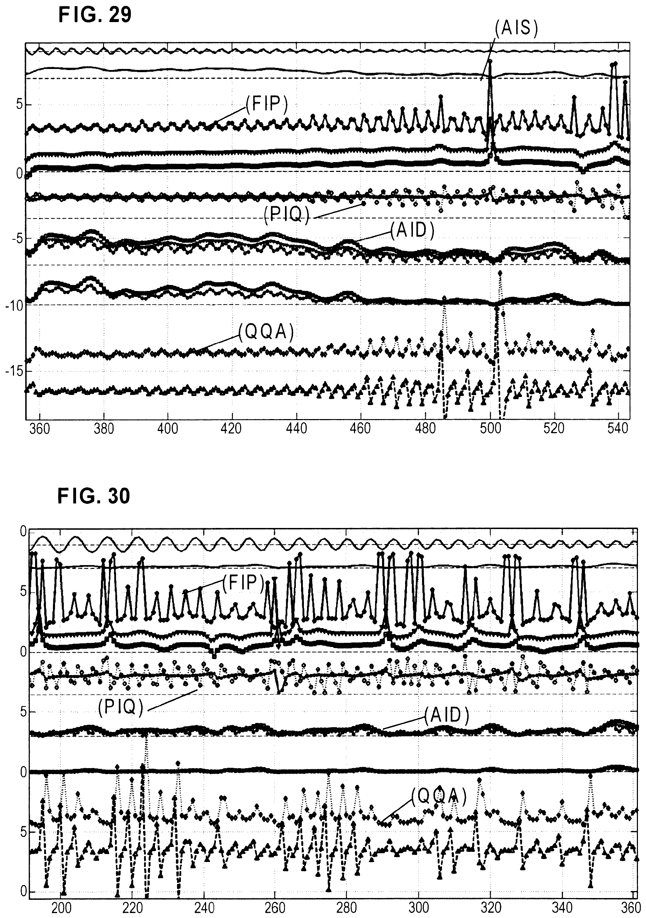

Les Figures 28 et 29 montrent les observations effectuées avec le signal utile (SU) décrit ci-dessus avec bruit ajouté, dans un cas de figure où ce bruit ajouté est important (voir Figure 20), en début et en fin de signal (les numéros d'échantillons des Figures 27, 28 et 29 correspondent).
On remarque notamment :

RCB1/ Une forte variance de plusieurs indicateurs en début de signal, lorsque le rapport signal sur bruit (SNR) est particulièrement défavorable :

> Indicateurs de fréquence instantanée
> Indicateurs de différence de phase
> Indicateurs quotient des quotients d'amplitude (QQA) et de sa dérivée temporelle (QQD)

RCB2/ Diminution de la variance de ces mêmes indicateurs vers le milieu du signal (lorsque le rapport signal sur bruit (SNR) est moins défavorable) puis augmentation de la variance de ces mêmes indicateurs vers la fin du signal (lorsque le rapport signal sur bruit (SNR) redevient moins favorable)
RCB3/ Valeurs de crête de ces mêmes indicateurs très comparables à chaque instant (en mesurant par exemple la valeur de crête dans une fenêtre temporelle de 5 échantillons successifs)
RCB4/ Variance des signaux d'amplitude instantanée plus forte au milieu du signal qu'au début ou à la fin
RCB5/ Une courbe de l'amplitude instantanée (AIP) de la primitive temporelle (SAP) du signal d'analyse à large bande (SAL) qui présente une modulation sans raison apparente (courbe du bas)
RCB6/ Les courbes du quotient des quotients d'amplitude (QQA) et de sa dérivée temporelle (QQD) présentent la même modulation sans raison apparente

**24) (Compléments) Traitement d'un signal de bruit pur**

*24.1) Le signal utile (SU)*

Le signal utile (SU) n'existe pas.

*24.2) Le bruit rajouté (BRA)*

Le bruit ajouté (BRA) est le même que pour ci-dessus pour le signal sinusoïdal.

*24.3) Le rapport Signal sur bruit (SNR)*

Le rapport sur bruit (SNR) est infini puisqu'il n'y a pas de signal utile (SU).

*24.4) Les informations observées*

Les informations observées sont les mêmes que pour le signal précédent et sont présentées en Figure 22.

*24.5) Les résultats observés*

La Figure 30 montre les observations effectuées.
On remarque notamment :

RB1/ Une forte variance de la fréquence instantanée (FIP) du signal primitive temporelle (SAP) du signal d'analyse à large bande (SAL), qui présente un comportement de type oscillatoire
RB2/ Une faible variance de la fréquence instantanée (FID) du signal dérivée temporelle (SAD) du signal d'analyse à large bande (SAL), et de la fréquence instantanée (FIS) du signal d'analyse à large bande (SAL)
RB3/ Une forte variance de la différence de phase instantanée (PIQ) entre d'une part la phase instantanée de la primitive temporelle du signal (PIP) et d'autre part la phase instantanée du signal (PIS)

RB4/ Une faible variance de la différence de phase instantanée (PIC) entre d'une part la phase instantanée de la dérivée temporelle du signal (PID) et d'autre part la phase instantanée du signal (PIS)

RB5/ La mauvaise concordance temporelle entre les évolutions des indicateurs suivants :

> fréquence instantanée (FIP) du signal primitive temporelle (SAP) du signal d'analyse à large bande (SAL)
> quotient des quotients d'amplitude (QQA) et de sa dérivée temporelle (QQD)

RB6/ Une courbe de l'amplitude instantanée (AIP) de la primitive temporelle (SAP) du signal d'analyse à large bande (SAL) qui présente une modulation sans raison apparente (courbe du bas), alors que les deux autres courbes d'amplitude instantanée ne présentent pas une telle modulation

RB7/ Faible valeur et faible variance des deux courbes d'amplitude instantanée qui ne présentent pas la modulation sans raison apparente

## 25) (Précisions & Compléments) De Nouveaux indicateurs possibles dans le cadre de l'invention et leur calcul

### 25.1) L'utilisation des informations de la primitive temporelle seule

Il a été constaté dans les trois exemples ci-dessus qu'en présence de bruit, l'amplitude, la phase et la fréquence instantanées du signal (SAP) primitive temporelle du signal (SAL) d'analyse à large bande.

On peut donc définir les 3 indicateurs suivants :

b5) un premier indicateur de bruit (IBA) calculé comme l'amplitude instantanée (AIP) du signal (SAP) primitive temporelle du signal d'analyse large bande (SAL), qui présente des oscillations rapides en présence de bruit significatif

b6) un deuxième indicateur de bruit (IBP) calculé comme la phase instantanée (PIP) du signal (SAP) primitive temporelle du signal d'analyse large bande (SAL), qui présente des oscillations rapides en présence de bruit significatif

b7) un troisième indicateur de bruit (IBF) calculé comme la fréquence instantanée (FIP) du signal (SAP) primitive temporelle du signal d'analyse large bande (SAL), qui présente des oscillations rapides en présence de bruit significatif

Dans les exemples ci-dessus, la fréquence de ces oscillations est voisine de la fréquence (F4) égale au quart de la fréquence d'échantillonnage, qui a été utilisée comme fréquence de travail pour l'extraction des paramètres. Des adaptations sont possibles dans le cas d'utilisation d'autres fréquences de travail.

### 25.1) L'utilisation des informations de la primitive temporelle avec d'autres informations

On peut aussi constater dans les trois exemples ci-dessus que des indicateurs plus précis peuvent être obtenus en comparant des informations instantanées du signal primitive temporelle à des informations instantanées du signal d'analyse à large bande (SAL) et/ou du signal dérivée temporelle. En effet, on peut définir les trois indicateurs suivants de présence de signal et d'estimation du rapport signal sur bruit.

b8) Un premier indicateur de présence de signal et d'estimation du rapport signal sur bruit (ISP), égal à la variance sur la durée d'observation de (DOB) échantillons du signal (SAL) d'analyse à large bande de la différence de phase instantanée (PIQ) entre, d'une part, la phase instantanée de la primitive temporelle du signal (PIP) et, d'autre part, la phase instantanée du signal (PIS)

b9) Un deuxième indicateur de présence de signal et d'estimation du rapport signal sur bruit (ISF), égal à la variance sur la durée d'observation de (DOB) échantillons du signal (SAL) d'analyse à large bande de la différence entre, d'une part, la fréquence instantanée (FIP) de la primitive temporelle du signal (FIP), et, d'autre part, la fréquence instantanée du signal (FIS)

Ces deux indicateurs ne font intervenir que des informations de phase ou de fréquence, et le deuxième indicateur est en pratique une conséquence du premier.

Le troisième indicateur, de manière surprenante, compare et fait intervenir à la fois des informations d'amplitude instantanée d'une part et des informations de fréquence instantanée d'autre part :

b.10) Un troisième indicateur de présence de signal et d'estimation du rapport signal sur bruit (ISA), calculé comme le quotient (QQA) des quotients d'amplitude suivants :

> Le quotient (QAD) entre les amplitudes instantanées de la dérivée temporelle du signal (AID) et du signal (AIS)
> Le quotient (QAP) entre les amplitudes instantanées de la primitive temporelle du signal (AIP) et du signal (AIS)

Et dont le degré de corrélation temporelle avec les deux signaux suivants:

b.10.a) la fréquence instantanée (FIP) du signal (SAP) primitive temporelle du signal d'analyse large bande (SAL),
b.10.b) l'un des deux signaux suivants :

> la fréquence instantanée (FIS) du signal d'analyse large bande (SAL)
> la fréquence instantanée (FID) du signal (SAD) dérivée temporelle du signal d'analyse large bande (SAL)

fournit une indication de présence du signal détectable et du rapport signal sur bruit (SNR) d'un signal d'analyse à large bande (SAL) grâce à ses propriétés suivantes:

b.10.1) en l'absence d'un signal détectable, le quotient (QQA) des quotients d'amplitude n'est corrélé à aucun des signaux de fréquence instantanée mentionnés en b.10.a) ou b.10.b) ci-dessus
b.10.2) en présence d'un signal détectable et en l'absence de bruit appréciable, le quotient (QQA) des quotients d'amplitude est corrélé aux trois signaux de fréquence instantanée mentionnés en b.10.a) ou b.10.b) ci-dessus
b.10.3) en présence d'un signal détectable et en présence de bruit appréciable, le quotient (QQA) des quotients d'amplitude est corrélé à la fréquence instantanée (FIP) du signal (SAP) primitive temporelle du signal d'analyse large bande (SAL) mentionnée en b.10.a) ci-dessus, mais pas aux deux autres signaux de fréquence instantanée mentionnés en b.10.b) ci-dessus

*26) (Compléments) La généralisation à plusieurs dimensions*

Lorsqu'un signal initial multi dimensionnel (SIM), avec un nombre (NDI), de dimensions peut être décomposé en un nombre (NSD) de signaux élémentaires (SLM) dont au moins 1 a une dimension 1, le procédé objet de la présente invention s'applique à chacun des au moins un signaux élémentaires (SLM) de dimension 1.

Exemple : Images, avec une décomposition cartésienne en X et Y ou en polaire (distance par rapport à l'origine et angle par rapport à un axe)

Dans ce cas, le procédé selon l'une des modalités précédentes, appliqué à chacun des au moins un signaux élémentaires (SLM) de dimension 1, résultant de la décomposition d'un signal initial multi dimensionnel (SIM), avec un nombre (NDI), de dimensions, en un nombre (NSD) de signaux élémentaires (SLM) dont au moins une a une dimension 1.

**Revendications**

1. **Procédé d'analyse** d'un signal initial (SI) au moyen d'une pluralité (NFA) de fréquences analysées (FA) dans ledit signal initial (SI), composé d'un signal utile (SU) composé d'une somme de signaux élémentaires (SEL), représentatif d'une onde qui se propage dans un milieu physique, auquel peut s'ajouter un bruit ajouté (BRA), pour fournir des paramètres de présence et une description des modulations de chacune des fréquences analysées (FA) de la pluralité (NFA) de fréquences analysées,
ledit procédé étant mis en oeuvre sur une séquence d'échantillons (SE), échantillonnés à une fréquence d'échantillonnage (FE) constante, obtenus à partir d'un signal initial (SI),
ledit procédé comprenant les étapes successives suivantes:

1.1) Une étape (ASF) d'analyse sélective en fréquence fournissant à partir du signal initial (SI) une pluralité (NFA) de signaux d'analyse à bande large (SAL), chaque signal d'analyse à bande large (SAL) correspondant à une des fréquences analysées (FA), ladite étape (ASF) d'analyse sélective en fréquence étant réalisée par les sous-étapes suivantes :

- AS1) une succession d'opérations de sous-échantillonnage, composée chacune d'un filtrage fréquentiel passe-bas ou passe-bande et d'une suppression correspondante d'échantillons

- AS2) au moins une opération de filtrage fréquentiel passe-bas ou passe-bande non suivie d'une suppression correspondante d'échantillons

- AS3) zéro ou plus Translation de Fréquence complexe qui amène la fréquence analysée à une première fréquence de travail (FTA) adaptée à calculer l'Amplitude instantanée et à une deuxième fréquence de travail (FTP) adaptée à calculer la Phase Instantanée et la Fréquence Instantanée du signal d'analyse

1.2) Une pluralité (NFA) d'opérations (EXP) d'extraction de paramètres (PAS) du signal d'analyse à bande large (SAL) pour chaque échantillon (EAA) de la pluralité (NFA) des signaux d'analyse à bande large (SAL), ces paramètres comprenant au moins les signaux suivants:

    a) l'Amplitude instantanée (AIS) du signal d'analyse à bande large (SAL)
    b) la Phase instantanée (PIS) du signal d'analyse à bande large (SAL)

1.3) Une pluralité (NFA) d'opérations d'estimation de la modulation du signal (EMS) qui chacune détermine pour chaque échantillon (EAA) de la pluralité (NFA) des signaux d'analyse à bande large (SAL) et sur une durée d'observation de (DOB) échantillons du signal (SAL) d'analyse à large bande:

    a) un <u>indicateur de signal non significatif</u> (INS), qui est faux par défaut et vrai si au moins une des trois conditions est satisfaite:

        <u>a.1</u>) si l'Amplitude instantanée (AIS) du signal (SAL) d'analyse à large bande a, sur la durée d'observation de (DOB) échantillons du signal (SAL) d'analyse à large bande une valeur moyenne inférieure à un premier seuil (AS1) défini à l'avance ou une valeur instantanée minimale inférieure à un deuxième seuil (AS2) défini à l'avance

        <u>a.2</u>) si au moins trois autres indicateurs (INC), directement comparables à la fois pour les valeurs possibles et pour les vitesses de variations, présentent une mauvaise concordance temporelle dans l'apparition d'événements significatifs, tels que maximum ou minimum ou transitions rapide, ladite concordance temporelle étant défini comme

            11.1) le nombre d'échantillons séparant l'apparition des événements, sans tenir compte des éventuelles différences systématiques de durées de calcul des indicateurs correspondants,
            11.2) une concordance de 0 ou 1 échantillon est considérée comme bonne, une concordance de 2 échantillons est considérée comme moyenne, et au-delà de 2 échantillons, elle est considérée comme mauvaise,
            11.3) Lorsque la concordance concerne plus de 2 indicateurs, un indicateur de concordance (ICO) sera calculé à partir des événements significatifs identifiés dans une fenêtre temporelle de 5 à 7 échantillons successifs,

        <u>a.3</u>) si au moins un indicateur (IPX) de présence du signal utile et d'estimation du rapport signal sur bruit (SNR) indique l'absence de signal ou du bruit

**2.** Procédé selon la revendication 1, dans lequel durant la pluralité (NFA) d'opérations d'estimation de la modulation du signal (EMS), chacune détermine en outre :
b) <u>au moins deux autres indicateurs (INC)</u>, directement comparables à la fois pour les valeurs possibles et pour les vitesses de variations, tels que:

    <u>ic.1</u>) au moins un des indicateurs (INC) directement comparables provient d'informations d'amplitude instantanée
    <u>ic.2</u>) au moins un des indicateurs (INC) directement comparables provient d'informations de phase ou de fréquence instantanée

**3.** Procédé selon la revendication 1 dans lequel les opérations (EXP) d'extraction de paramètres du signal (PAS) pour chaque échantillon (EAA) de la pluralité (NFA) des signaux d'analyse à bande large (SAL), fournissent en plus au moins deux des six signaux suivants:

    c) la Phase instantanée (PID) du signal dérivé (SAD) égal à la dérivée temporelle d'un signal d'analyse à large bande (SAL),

d) la Fréquence instantanée (FID) du signal dérivé, égale à la dérivée temporelle de ladite Phase instantanée (PID) du signal dérivé (SAD)

e) la Phase instantanée (PIP) du signal (SAP) primitive temporelle d'un signal d'analyse à large bande (SAL),

f) la Fréquence instantanée (FIP) dérivée temporelle de ladite Phase instantanée (PIP) du signal primitive (SAP)

g) l'Amplitude instantanée (AID) du signal dérivé (SAD),

h) l'Amplitude instantanée (AIP) du signal primitive (SAP).

**4.** Procédé selon la revendication 2 dans lequel les au moins deux indicateurs (INC) directement comparables sont tels que:

ic.3) au moins un des indicateurs (INC) directement comparables provient d'informations du signal dérivée temporelle (SAD) ou du signal primitive temporelle (SAP) du signal d'analyse large bande (SAL)

**5.** Procédé selon une des revendications 2 à 4 dans lequel les au moins deux indicateurs (INC) directement comparables sont au nombre de trois au minimum et tels que:

ic.4) au moins un des indicateurs (INC) directement comparables provient d'informations du signal d'analyse large bande (SAL)

ic.5) au moins un des indicateurs (INC) directement comparables provient d'informations du signal dérivée temporelle (SAD) du signal d'analyse large bande (SAL)

ic.6) au moins un des indicateurs (INC) directement comparables provient d'informations du signal primitive temporelle (SAP) du signal d'analyse large bande (SAL)

**6.** Procédé selon une des revendications 1 à 5 dans lequel les indicateurs (INC) directement comparables contiennent au moins un des indicateurs suivants :

b1) un indicateur (IAS) de modulation d'amplitude sinusoïdale qui indique dans quelle mesure la dérivée temporelle première (ADS) de l'Amplitude instantanée (AIS) d'une part et d'autre part la dérivée temporelle seconde de l'Amplitude instantanée (AIS) sont en quadrature

b2) un indicateur (IAE) de modulation d'amplitude exponentielle qui indique dans quelle mesure la dérivée temporelle première (ADL) du Logarithme de l'Amplitude instantanée (AIS) est constante

b3) un indicateur (IPA) de détection de pics de modulation d'amplitude qui indique dans quelle mesure la dérivée temporelle seconde (AEL) du Logarithme de l'Amplitude instantanée (AIS) du signal d'analyse (SAL) à large bande présente un pic d'amplitude limité dans le temps

b4) un indicateur (IFM) de modulation de fréquence qui indique dans quelle mesure la dérivée temporelle première (FDS) de la Fréquence instantanée (FIS) du signal d'analyse à bande large (SAL), qui est elle-même la dérivée temporelle première de la Phase Instantanée (PIS) du signal d'analyse à bande large (SAL), est constante

b5) un premier indicateur de bruit (IBA) calculé comme l'amplitude instantanée (AIP) du signal (SAP) primitive temporelle du signal d'analyse large bande (SAL), qui présente des oscillations rapides en présence de bruit

b6) un deuxième indicateur de bruit (IBP) calculé comme la phase instantanée (PIP) du signal (SAP) primitive temporelle du signal d'analyse large bande (SAL), qui présente des oscillations rapides en présence de bruit

b7) un troisième indicateur de bruit (IBF) calculé comme la fréquence instantanée (FIP) du signal (SAP) primitive temporelle du signal d'analyse large bande (SAL), qui présente des oscillations rapides en présence de bruit

**7.** Procédé selon une des revendications 1 à 3 dans lequel les indicateurs (IPX) de présence du signal utile et d'estimation du rapport signal sur bruit (SNR) contiennent au moins un des indicateurs suivants:

b8) Un premier indicateur de présence de signal et d'estimation du rapport signal sur bruit (ISP), égal à la variance sur la durée d'observation de (DOB) échantillons du signal (SAL) d'analyse à large bande de la différence de phase instantanée (PIQ) entre, d'une part, la phase instantanée de la primitive temporelle du signal (PIP) et, d'autre part, la phase instantanée du signal (PIS)

b9) Un deuxième indicateur de présence de signal et d'estimation du rapport signal sur bruit (ISF), égal à la variance sur la durée d'observation de (DOB) échantillons du signal (SAL) d'analyse à large bande de la différence entre, d'une part, la fréquence instantanée (FIP) de la primitive temporelle du signal (FIP) et, d'autre part, la fréquence instantanée du signal (FIS)

b.10) Un troisième indicateur de présence de signal et d'estimation du rapport signal sur bruit (ISA), calculé comme le quotient (QQA) des quotients d'amplitude suivants :

> Le quotient (QAD) entre les amplitudes instantanées de la dérivée temporelle du signal (AID) et du signal (AIS)

> Le quotient (QAP) entre les amplitudes instantanées de la primitive temporelle du signal (AIP) et du signal (AIS)

Et dont le degré de corrélation temporelle avec les deux signaux suivants:

b.10.a) la fréquence instantanée (FIP) du signal (SAP) primitive temporelle du signal d'analyse large bande (SAL),

b.10.b) l'un des deux signaux suivants :

> la fréquence instantanée (FIS) du signal d'analyse large bande (SAL)

> la fréquence instantanée (FID) du signal (SAD) dérivée temporelle du signal d'analyse large bande (SAL)

fournit une indication de présence du signal détectable et du rapport signal sur bruit (SNR) d'un signal d'analyse à large bande (SAL) grâce à ses propriétés suivantes:

b.10.1) en l'absence d'un signal détectable, le quotient (QQA) des quotients d'amplitude n'est corrélé à aucun des signaux de fréquence instantanée mentionnés en b.10.a) ou b.10.b) ci-dessus

b.10.2) en présence d'un signal détectable et en l'absence de bruit appréciable, le quotient (QQA) des quotients d'amplitude est corrélé aux trois signaux de fréquence instantanée mentionnés en b.10.a) ou b.10.b) ci-dessus

b.10.3) en présence d'un signal détectable et en présence de bruit appréciable, le quotient (QQA) des quotients d'amplitude est corrélé à la fréquence instantanée (FIP) du signal (SAP) primitive temporelle du signal d'analyse large bande (SAL) mentionnée en b.10.a) ci-dessus, mais pas aux deux autres signaux de fréquence instantanée mentionnés en b.10.b) ci-dessus

8. Procédé selon la revendication 1 dans lequel les étapes AS2) et AS3) sont les étapes AS21) et AS31) suivantes :

- AS21) zéro ou plus opération de filtrage fréquentiel passe-bas ou passe-bande,
- AS31) au moins une Translation de Fréquence complexe qui amène la fréquence analysée à une fréquence de travail adaptée à calculer l'Amplitude instantanée et à une fréquence de travail adaptée à calculer la Phase Instantanée et la Fréquence Instantanée du signal d'analyse.

9. Procédé selon la revendication 1 ou 8 dans lequel les étapes AS1), AS2) et AS3) (ou AS11), AS21 et AS31), sont réalisées respectivement par les étapes AS10), AS20) et AS30) suivantes:

- AS10) une succession d'opérations de sous-échantillonnage, composée chacune d'un filtrage fréquentiel passe-bas autour de la fréquence nulle (F0) ou passe bande autour de la fréquence (F4) égale au quart de la fréquence d'échantillonnage (FE), et d'une suppression correspondante d'échantillons
- AS20) au moins une opération de filtrage fréquentiel passe-bas autour de la fréquence nulle (F0) ou passe-bande autour de la fréquence (F4) égale au quart de la fréquence d'échantillonnage (FE), non suivie d'une suppression correspondante d'échantillons réalisée avec un filtre fréquentiel dont la durée utile (DUF) exprimée en nombre d'échantillons est inférieure ou égale à 12, et avantageusement égale à 8, et dont la bande passante occupe au moins 30 % du spectre du signal en sortie de l'étape AS1)
- AS30) zéro ou plus Translation de Fréquence complexe qui amène la fréquence analysée à la fréquence (F4) égale au quart de la fréquence d'échantillonnage (FE), adaptée à calculer l'Amplitude instantanée, la Phase Instantanée et la Fréquence Instantanée du signal d'analyse.

10. Procédé selon la revendication 9, dans lequel l'étape AS20) est réalisée par l'étape AS200) suivante:

AS200) Une opération de filtrage fréquentiel passe-bande de fréquence centrale la fréquence (F4) égale au quart de la fréquence d'échantillonnage (FE), non suivie d'une suppression correspondante d'échantillons, réalisée par une Transformée de Fourier Glissante (TFG) de longueur 12 avec une fenêtre de Hann, en se limitant au canal fréquentiel centré sur la fréquence (F4) égale au quart de la fréquence d'échantillonnage (FE)

11. Procédé selon l'une des revendications précédentes, dans lequel la durée d'observation de (DOB) échantillons du signal (SAL) d'analyse à large bande est de l'ordre de 10 à 20 échantillons du signal (SAL) d'analyse à large bande

**12.** Procédé selon la revendication 6, utilisé dans le traitement du signal vocal, permettant de détecter la fréquence fondamentale (FFV) du signal vocal en détectant les éléments suivants:

> VA) les pics d'amplitude d'au moins un des indicateurs suivants:

V1) l'indicateur (IPA) de détection de pics de modulation d'amplitude
V2) l'indicateur (IPX) de probabilité de présence de signal
V3) l'indicateur (IFM) de modulation de fréquence

> VB) la concordance dans le temps d'apparition de pics d'amplitude des indicateurs précédents

**13.** Procédé selon l'une des revendications précédentes, appliqué à chacun des au moins un signaux élémentaires (SLM) de dimension 1, résultant de la décomposition d'un signal initial multi dimensionnel (SIM), avec un nombre (NDI), de dimensions, en un nombre (NSD) de signaux élémentaires (SLM) dont au moins 1 a une dimension 1

**14.** **Dispositif d'analyse** d'un signal (SI) et de détection d'une pluralité (NFA) de fréquences analysées (FA) dans ledit signal initial (SI) éventuellement significativement bruité, échantillonné à une fréquence d'échantillonnage (FE) constante, ledit dispositif comprenant une plate-forme (PC) de calcul recevant un signal initial (SI) représentatif d'une onde qui se propage dans un milieu physique, et étant adapté pour mettre en oeuvre le procédé selon une ou plusieurs des revendications précédentes.

**15.** Dispositif selon la revendication 14, comprenant en outre un capteur (CA) générant ledit signal initial (SI) à partir de ladite onde.

**16.** Dispositif selon la revendication 14 ou la revendication 15, dans lequel la plate-forme (PC) est adaptée à des calculs en virgule fixe.

**Patentansprüche**

**1.** Verfahren zur Analyse eines Anfangssignals (SI) mittels mehrerer (NFA) analysierter Frequenzen (FA) in dem Anfangssignal (SI), das aus einem aus einer Summe von Elementarsignalen (SEL) zusammengesetzten Nutzsignal (SU) zusammengesetzt ist und das eine Welle repräsentiert, die sich in einem physikalischen Medium ausbreitet und das zusätzlich mit einem Zusatzrauschen (BRA) versehen sein kann, um Anwesenheitsparameter und eine Beschreibung jeder der analysierten Frequenzen (FA) der mehreren (NFA) analysierten Frequenzen bereitzustellen, wobei das Verfahren an einer Folge von Abtastwerten (SE) durchgeführt wird, die mit einer konstanten Abtastfrequenz (FE) abgetastet aus einem Anfangssignal (SI) gewonnen sind,
wobei das Verfahren die folgenden Schritte der Reihe nach aufweist:

1.1) einen Schritt (ASF) einer selektiven Frequenzanalyse, der ausgehend von dem Anfangssignal (SI) mehrere (NFA) breitbandige Analysesignale (SAL) liefert, wobei jedes breitbandige Analysesignal (SAL) einer der analysierten Frequenzen (FA) entspricht, wobei der Schritt der selektiven Frequenzanalyse durch die folgenden Teilschritte erfolgt:

- AS1) eine Folge von Unterabtastoperationen, von denen jede aus einer Tiefpass- oder Bandpass-Frequenzfilterung und einer entsprechenden Unterdrückung von Abtastwerten zusammengesetzt ist,
- AS2) mindestens eine Tiefpass- oder Bandpass-Frequenzfilteroperation ohne anschließende entsprechende Unterdrückung von Abtastwerten,
- AS3) null oder mehr komplexe Frequenztranslation, die die analysierte Frequenz in eine zur Berechnung der momentanen Amplitude geeignete erste Arbeitsfrequenz (FTA) und in eine zur Berechnung der momentanen Phase und der momentanen Frequenz des Analysesignals geeignete zweite Arbeitsfrequenz (FTP) bringt,

1.2) mehrere (NFA) Parameterextraktionsoperationen (EXP) zur Extraktion von Parametern (PAS) des breitbandigen Analysesignals (SAL) für jeden Abtastwert (EAA) der mehreren (NFA) breitbandigen Analysesignale (SAL), wobei diese Parameter mindestens die folgenden Signale aufweisen:

a) die momentane Amplitude (AIS) des breitbandigen Analysesignals (SAL),

b) die momentane Phase (PIS) des breitbandigen Analysesignals (SAL),

1.3) mehrere (NFA) Operationen zur Schätzung der Modulation des Signals (EMS), von denen jede für jeden Abtastwert (EAA) der mehreren (NFA) breitbandigen Analysesignale (SAL) und über eine Dauer einer Beobachtung (DOB) von Abtastwerten des breitbandigen Analysesignals (SAL) bestimmt:

a) einen Indikator für nichtsignifikantes Signal (INS), der per Voreinstellung falsch ist und wahr ist, wenn mindestens eine der drei Bedingungen erfüllt ist:

a.1) falls die momentane Amplitude (AIS) des breitbandigen Analysesignals über die Dauer der Beobachtung (DOB) von Abtastwerten des breitbandigen Analysesignals (SAL) einen Durchschnittswert hat, der kleiner als ein vorab definierter erster Schwellenwert (AS1) ist, oder einen minimalen momentanen Wert, der kleiner als ein vorab definierter zweiter Schwellenwert (AS2) ist,
a.2) falls mindestens drei andere Indikatoren (INC), die direkt vergleichbar zugleich für die möglichen Werte und für die Änderungsgeschwindigkeiten sind, eine schlechte zeitliche Übereinstimmung im Auftreten von signifikanten Ereignissen, wie Maximum oder Minimum oder schnelle Übergänge, haben, wobei die zeitliche Übereinstimmung wie folgt definiert ist:

11.1) die Anzahl von Abtastwerten, die das Auftreten der Ereignisse trennt, ohne Berücksichtigung eventueller systematischer Unterschiede der Berechnungsdauer der entsprechenden Indikatoren,
11.2) eine Übereinstimmung von 0 oder 1 Abtastwert wird als gut betrachtet, eine Übereinstimmung von 2 Abtastwerten wird als durchschnittlich betrachtet und jenseits von 2 Abtastwerten wird sie als schlecht betrachtet,
11.3) wenn die Übereinstimmung mehr als 2 Indikatoren betrifft, wird ein Übereinstimmungsindikator (ICO) aus signifikanten Ereignissen berechnet, die in einem Zeitfenster von 5 bis 7 aufeinanderfolgenden Abtastwerten identifiziert werden,

a.3) falls mindestens ein Indikator (IPX) für Anwesenheit des Nutzsignals und für Schätzung des Signal/Rauschen-Verhältnisses (SNR) die Abwesenheit von Signal oder von Rauschen anzeigt.

**2.** Verfahren nach Anspruch 1, in welchem während der mehreren (NFA) Signalmodulation-Schätzoperationen (EMS) ferner jede bestimmt:
b) mindestens zwei andere Indikatoren (INC), die direkt vergleichbar zugleich für die möglichen Werte und für die Änderungsgeschwindigkeiten sind, derart, dass:

ic.1) mindestens einer der direkt vergleichbaren Indikatoren (INC) aus Informationen über die momentane Amplitude stammt,
ic.2) mindestens einer der direkt vergleichbaren Indikatoren (INC) aus Informationen über die momentane Phase oder Frequenz stammt.

**3.** Verfahren nach Anspruch 1, in welchem die Parameterextraktionsoperationen (EXP) von Signalparametern (PAS) für jeden Abtastwert (EAA) der mehreren (NFA) breitbandigen Analysesignale (SAL) ferner mindestens zwei der sechs folgenden Signale liefern:

c) die momentane Phase (PID) des abgeleiteten Signals (SAD), die gleich der zeitlichen Ableitung eines breitbandigen Analysesignals (SAL) ist,
d) die momentane Frequenz (FID) des abgeleiteten Signals, die gleich der zeitlichen Ableitung der momentanen Phase (PID) des abgeleiteten Signals (SAD) ist,
e) die momentane Phase (PIP) des zeitlichen Stammsignals (SAP) eines breitbandigen Analysesignals (SAL),
f) die momentane Frequenz (FIP), die die zeitliche Ableitung der momentanen Phase (PIP) des Stammsignals (SAP) ist,
g) die momentane Amplitude (AID) des abgeleiteten Signals (SAD),
h) die momentane Amplitude (AIP) des Stammsignals (SAP).

**4.** Verfahren nach Anspruch 2, in welchem die mindestens zwei direkt vergleichbaren Indikatoren (INC) derart sind, dass:
ic.3) mindestens einer der direkt vergleichbaren Indikatoren (INC) aus Informationen des zeitlich abgeleiteten Signals (SAD) oder des zeitlichen Stammsignals (SAP) des breitbandigen Analysesignals (SAL) stammt.

5. Verfahren nach einem der Ansprüche 2 bis 4, in welchem die mindestens zwei direkt vergleichbaren Indikatoren (INC) mindestens drei an der Zahl sind und derart, dass:

ic.4) mindestens einer der direkt vergleichbaren Indikatoren (INC) aus Informationen des breitbandigen Analysesignals (SAL) stammt,
ic.5) mindestens einer der direkt vergleichbaren Indikatoren (INC) aus Informationen des zeitlichen abgeleiteten Signals (SAD) des breitbandigen Analysesignals (SAL) stammt,
ic.6) mindestens einer der direkt vergleichbaren Indikatoren (INC) aus Informationen des zeitlichen Stammsignals (SAP) des breitbandigen Analysesignals (SAL) stammt.

6. Verfahren nach einem der Ansprüche 1 bis 5, in welchem die direkt vergleichbaren Indikatoren (INC) mindestens einen der folgenden Indikatoren aufweisen:

b1) einen Indikator (IAS) für sinusförmige Amplitudenmodulation, der anzeigt, in welchem Maß die erste zeitliche Ableitung (ADS) der momentanen Amplitude (AIS) einerseits und andererseits die zweite zeitliche Ableitung der momentanen Amplitude (AIS) in Quadratur sind,
b2) einen Indikator (IAE) für exponentielle Amplitudenmodulation, der anzeigt, in welchem Maße die erste zeitliche Ableitung (ADL) des Logarithmus der momentanen Amplitude (AIS) konstant ist,
b3) einen Indikator (IPA) für Detektion von Amplitudenmodulationsspitzen, der anzeigt, in welchem Maße die zweite zeitliche Ableitung (AEL) des Logarithmus der momentanen Amplitude (AIS) des breitbandigen Analysesignals (SAL) eine in der Zeit begrenzte Amplitudenspitze aufweist,
b4) einen Indikator (IFM) für Frequenzmodulation, der anzeigt, in welchem Maße die erste zeitliche Ableitung (FDS) der momentanen Frequenz (FIS) des breitbandigen Analysesignals (SAL), die ihrerseits die erste zeitliche Ableitung der momentanen Phase (PIS) des breitbandigen Analysesignals (SAL) ist, konstant ist,
b5) einen ersten Rauschen-Indikator (IBA), der als die momentane Amplitude (AIP) des zeitlichen Stammsignals (SAP) des breitbandigen Analysesignals (SAL) berechnet wird und bei Anwesenheit von Rauschen schnelle Oszillationen zeigt,
b6) einen zweiten Rauschen-Indikator (IBP), der als die momentane Phase (PIP) des zeitlichen Stammsignals (SAP) des breitbandigen Analysesignals (SAL) berechnet wird und bei Anwesenheit von Rauschen schnelle Oszillationen zeigt,
b7) einen dritten Rauschen-Indikator (IBF), der als die momentane Frequenz (FIP) des zeitlichen Stammsignals (SAP) des breitbandigen Analysesignals (SAL) berechnet wird und bei Anwesenheit von Rauschen schnelle Oszillationen zeigt.

7. Verfahren nach einem der Ansprüche 1 bis 3, in welchem die Indikatoren (IPX) für Anwesenheit des Nutzsignals und für Schätzung des Signal/Rauschen-Verhältnisses (SNR) mindestens einen der folgenden Indikatoren aufweisen:

b8) einen ersten Indikator für Signalanwesenheit und für Schätzung des Signal/Rauschen-Verhältnisses (ISP), der gleich der über die Dauer einer Beobachtung (DOB) von Abtastwerten des breitbandigen Analysesignals (SAL) genommenen Varianz der Differenz der momentanen Phase (PIQ) zwischen einerseits der momentanen Phase des zeitlichen Stammsignals (PIP) und andererseits der momentanen Phase des Signals (PIS) ist,
b9) einen zweiten Indikator für Signalanwesenheit und für Schätzung des Signal/Rauschen-Verhältnisses (ISF), der gleich der über die Dauer einer Beobachtung (DOB) von Abtastwerten des breitbandigen Analysesignals (SAL) genommenen Varianz der Differenz zwischen einerseits der momentanen Frequenz (FIP) des zeitlichen Stammsignals (FIP) und andererseits der momentanen Phase des Signals (FIS) ist,
b10) einen dritten Indikator für Signalanwesenheit und für Schätzung des Signal/Rauschen-Verhältnisses (ISA), der berechnet wird als der Quotient (QQA) der folgenden Amplitudenquotienten:

> der Quotient (QAD) zwischen den momentanen Amplituden der zeitlichen Ableitung des Signals (AID) und des Signals (AIS)
> der Quotient (QAP) zwischen den momentanen Amplituden des zeitlichen Stamms des Signals (AIP) und des Signals (AIS)

und dessen Grad einer zeitlichen Korrelation mit den zwei folgenden Signalen:

b.10.a) der momentanen Frequenz (FIP) des zeitlichen Stammsignals (SAP) des breitbandigen Analysesignals (SAL)

b.10.b) einem der zwei folgenden Signalen:

> der momentanen Frequenz (FIS) des breitbandigen Analysesignals (SAL)
> der momentanen Frequenz (FID) des zeitlich abgeleiteten Signals (SAD) des breitbandigen Analysesignals (SAL)

eine Angabe für Anwesenheit des detektierbaren Signals und des Signal/Rauschen-Verhältnisses (SNR) eines breitbandigen Analysesignals (SAL) liefert und zwar dank seiner folgenden Eigenschaften:

b.10.1) in Abwesenheit eines detektierbaren Signals ist der Quotient (QQA) der Amplitudenquotienten mit keinem der vorstehend in b.10.a) oder b.10.b) erwähnten Signale momentaner Frequenz korreliert,
b.10.2) in Anwesenheit eines detektierbaren Signals und in Abwesenheit von beträchtlichem Rauschen ist der Quotient (QQA) der Amplitudenquotienten mit den drei vorstehend in b.10.a) oder b.10.b) erwähnten Signalen momentaner Frequenz korreliert,
b.10.3) in Anwesenheit eines detektierbaren Signals und in Anwesenheit von beträchtlichem Rauschen ist der Quotient (QQA) der Amplitudenquotienten mit der vorstehend in b.10.a) erwähnten momentanen Frequenz (FIP) des zeitlichen Stammsignals (SAP) des breitbandigen Analysesignals (SAL) korreliert, aber nicht mit den vorstehend in b.10.b) erwähnten zwei anderen Signalen momentaner Frequenz.

8. Verfahren nach Anspruch 1, in welchem die Schritte AS2) und AS3) die folgenden Schritte AS21) und AS31) sind:

- AS21) null oder mehr Tiefpass- oder Bandpass-Frequenzfilteroperation,
- AS31) mindestens eine komplexe Frequenztranslation, die die analysierte Frequenz in eine zur Berechnung der momentanen Amplitude geeignete Arbeitsfrequenz und in eine zur Berechnung der momentanen Phase und der momentanen Frequenz des Analysesignals geeignete Arbeitsfrequenz bringt.

9. Verfahren nach Anspruch 1 oder 8, in welchem die Schritte AS1), AS2) und AS3) (oder AS11), AS21) und AS31)) jeweils durch die folgenden Schritte AS10), AS20) und AS30 erfolgen:

- AS10) eine Folge von Unterabtastoperationen, von denen jede aus einer Tiefpass-Frequenzfilterung um die Frequenz Null (F0) oder Bandpass-Frequenzfilterung um die Frequenz (F4), die gleich dem Viertel der Abtastfrequenz (FE) ist, und einer entsprechenden Unterdrückung von Abtastwerten zusammengesetzt ist,
- AS20) mindestens eine Tiefpass-Frequenzfilterung um die Frequenz Null (F0) oder Bandpass-Frequenzfilterung um die Frequenz (F4), die gleich dem Viertel der Abtastfrequenz (FE) ist, ohne anschließende entsprechende Unterdrückung von Abtastwerten, durchgeführt mit einem Frequenzfilter, dessen in Anzahl von Abtastwerten ausgedrückte Nutzdauer (DUF) kleiner oder gleich 12 und vorteilhaft gleich 8 ist und dessen Durchlassband mindestens 30% des Spektrums des Ausgabesignals des Schritts AS1) einnimmt,
- AS30) null oder mehr komplexe Frequenztranslation, die die analysierte Frequenz in die Frequenz (F4) bringt, die gleich dem Viertel der Abtastfrequenz (FE) ist, die zur Berechnung der momentane Amplitude, der momentanen Phase und der momentanen Frequenz des Analysesignals angepasst ist.

10. Verfahren nach Anspruch 9, in welchem der Schritt AS20) durch den folgenden Schritt AS200) erfolgt: AS200) eine Operation zur frequenzzentralen Tiefpass-Frequenzfilterung der Frequenz (F4), die gleich dem Viertel der Abtastfrequenz (FE) ist, ohne anschließende entsprechende Unterdrückung von Abtastwerten, durchgeführt durch eine Fourier-Gleittransformation (TFG) einer Länge 12 mit einem Hann-Fenster und sich beschränkend auf den Frequenzkanal, der auf die Frequenz (F4) zentriert ist, die gleich dem Viertel der Abtastfrequenz (FE) ist.

11. Verfahren nach einem der vorstehenden Ansprüche, in welchem die Dauer einer Beobachtung (DOB) von Abtastwerten des breitbandigen Analysesignals (SAL) in der Größenordnung von 10 bis 20 Abtastwerten des breitbandigen Analysesignals (SAL) ist.

12. Verfahren nach Anspruch 6, das in der Verarbeitung des Sprachsignals verwendet wird und durch Detektieren der folgenden Elemente eine Detektion der Fundamentalfrequenz (FFV) des Sprachsignals erlaubt:

> VA) die Amplitudenspitzen mindestens eines der folgenden Indikatoren:

V1) des Indikators (IPA) für Detektion von Amplitudenmodulationsspitzen,
V2) des Indikators (IPX) für Signalanwesenheitswahrscheinlichkeit,

V3) des Indikators (IFM) für Frequenzmodulation,

> VB) die Übereinstimmung im zeitlichen Auftreten von Amplitudenspitzen der vorstehenden Indikatoren.

**13.** Verfahren nach einem der vorstehenden Ansprüche, angewendet auf jedes des mindestens einen Elementarsignals (SLM) der Dimension 1, das/die aus einer Zerlegung eines multidimensionalen Anfangssignals (SIM), das eine Anzahl (NDI) von Dimensionen hat, in eine Anzahl (NSD) von Elementarsignalen (SLM), von denen mindestens 1 eine Dimension 1 hat, resultiert/resultieren.

**14.** Vorrichtung zur Analyse eines Signals (SI) und zur Detektion mehrerer (NFA) analysierter Frequenzen (FA) in dem eventuell signifikant verrauschten, mit einer konstanten Abtastfrequenz (FE) abgetasteten Anfangssignal (SI), wobei die Vorrichtung eine Rechenplattform (PC) aufweist, die ein Anfangssignal (SI) empfängt, das eine Welle repräsentiert, die sich in einem physikalischen Medium ausbreitet, und wobei die Vorrichtung eingerichtet ist, das Verfahren nach einem oder mehreren der vorstehenden Ansprüche zu implementieren.

**15.** Vorrichtung nach Anspruch 14, aufweisend ferner einen Sensor (CA), der aus der Welle das Anfangssignal (SI) erzeugt.

**16.** Vorrichtung nach Anspruch 14 oder Anspruch 15, in welchem die Plattform (PC) für Festkommarechnungen eingerichtet ist.

**Claims**

**1. Analysis method** of an initial signal (SI) using a plurality (NFA) of analysed frequencies (FA) in the said initial signal (SI), comprising a useful signal (SU) comprising a sum of elementary signals (SEL), representative of a wave that propagates in a physical medium, to which added noise (BRA) can be added, in order to provide parameters indicating presence and a description of the modulations of each of the analysed frequencies (FA) of the plurality (NFA) of analysed frequencies,

said method being implemented on a sequence of samples (SE), sampled at a constant sampling frequency (FE), obtained from an initial signal (SI),

said method comprising following sequence of steps:

1.1) A frequency selective analysis (ASF) step providing starting from the initial signal (SI) a plurality of wideband analysis signals (SAL), each wideband analysis signals (SAL) corresponding to one of the analysed frequencies (FA), said step (ASF) of frequency selective analysis being implemented by the following sub-steps:

- AS1) a serie of undersampling operations, each made of a lowpass or bandpass frequency filtering and a corresponding suppression of samples
- AS2) at least one lowpass or bandpass frequency filtering operation not followed by a corresponding suppression of samples
- AS3) zero or more complex Frequency Translation which brings the analysed frequency to a first operating frequency (FTA) adapted to compute the instantaneous Amplitude and to a second operating frequency (FTP) adapted to compute the instantaneous Phase and the instantaneous Frequency of the analysis signal

1.2) A plurality (NFA) of operations (EXP) of extraction of parameters (PAS) of the wideband analysis signals (SAL) for each sample (EAA) of the plurality (NFA) of wideband analysis signals (SAL), these parameters comprising at least the following signals:

a) Instantaneous Amplitude (AIS) of the wideband analysis signal (SAL)
b) Instantaneous Phase (PIS) of the wideband analysis signal (SAL)

1.3) A plurality (NFA) of operations for estimation of the modulation of the signal (EMS) which each one determine for each sample (EAA) of the plurality (NFA) of wideband analysis signals (SAL), and for a duration of (DOB) samples of wideband analysis signal (SAL):

a) an indicator of non significant signal (INS), which is false by default and true if at least one of the three conditions is satisfied:

a.1) if the Instantaneous Amplitude (AIS) of the wideband analysis signal (SAL) is, during the observation duration of (DOB) samples of the wideband analysis signal (SAL) an average value lower than a first limit (AS1) defined in advance or an instantaneous value lower than a second limit (AS2) defined in advance

a.2) if at least three other indicators (INC), directly comparable for both possible values and speed of variation, show a bad temporal concordance regarding the apparition of significant events, such as maximum, minimum or fast transitions, said temporal concordance being defined as

11.1) the number of samples that separate the apparition of events, without taking into account possible systematic differences of durations for computation of the corresponding indicators

11.2) A concordance of 0 or 1 sample is considered as good, a concordance of 2 samples is considered as average, and beyond two samples, it is considered as bad 11.3) When the concordance is relative to more than 2 indicators, a concordance indicator (ICO) will be computed from significant events identified in a window of 5 to 7 consecutive samples,

a.3) if at least an indicator (IPX) of useful signal presence and signal to noise ratio estimation indicates a signal absence or a noise

2. Method according to claim 1, in which during the plurality (NFA) of operations for estimation of the modulation of the signal (EMS), each one further determines:
b) at least two other indicators (INC), directly comparable for both possible values and speed of variation, such as:

ic.1) at least one of the directly comparable indicators (INC) comes from instantaneous amplitude information
ic.2) at least one of the directly comparable indicators (INC) comes from instantaneous phase or frequency information.

3. Method according to claim 1, in which operations (EXP) of extraction of parameters (PAS) for each sample (EAA) of the plurality (NFA) of wideband analysis signals (SAL), provide in addition at least two among the six following signals:

c) Instantaneous Phase (PID) of the derivative signal (SAD) equal to the time derivative of a wideband analysis signal (SAL),
d) Instantaneous Frequency (FID) of the derivative signal, equal to the time derivative of said instantaneous Phase (PID) of the derivative signal (SAD)
e) Instantaneous Phase (PIP) of signal (SAP) time integral of a wideband analysis signal (SAL),
f) Instantaneous Frequency (FIP) time derivative of said instantaneous Phase (PIP) of the time integral signal (SAP)
g) Instantaneous Amplitude (AID) of the derivative signal (SAD),
h) Instantaneous Amplitude (AIP) of the time integral signal (SAP).

4. Method according to claim 2, in which the at least the at least two directly comparable indicators (INC) are such as:
ic.3) at least one of the directly comparable indicators (INC) is made out of information from the time derivative signal (SAD) or the time integral signal (SAP) of the wideband analysis signal (SAL).

5. Method according to one of the claims 2 to 4, in which the at least two directly comparable indicators (INC) are at least three and such as:

ic.4) at least one of the directly comparable indicators (INC) comes from information of the wideband analysis signal (SAL)
ic.5) at least one of the directly comparable indicators (INC) comes from information of the time derivative (SAD) of the wideband analysis signal (SAL)
ic.6) at least one of the directly comparable indicators (INC) comes from information of the time integral (SAP) of the wideband analysis signal (SAL)

6. Method according to one of the claims 1 to 5, in which the directly comparable indicators (INC) comprise at least one of the following indicators:

b1) a sinusoidal amplitude modulation indicator (IAS) which indicates to what extent the first time derivative (ADS) of instantaneous Amplitude (AIS) on one side and on the other side the second time derivative of instantaneous Amplitude (AIS) are in quadrature

b2) an exponential amplitude modulation indicator (IAE) which indicates to what extent the first time derivative (ADL) of the logarithm of the instantaneous Amplitude (AIS) is constant

b3) a detection of peaks of amplitude modulation indicator (IPA) which indicates to what extent the second time derivative (AEL) of the logarithm of the instantaneous Amplitude (AIS) of the wideband analysis signal (SAL) has a limited in time peak

b4) a frequency modulation indicator (IFM) which indicates to what extent the first time derivative (FDS) of the instantaneous Frequency (FIS) of the wideband analysis signal (SAL), which itself is the first time derivative of the instantaneous Phase (PIS) of the wideband analysis signal (SAL), is constant

b5) a first noise indicator (IBA) computed as the instantaneous amplitude (AIP) of the time integral (SAP) of a wideband analysis signal (SAL), which presents fast oscillations when noise is present

b6) a second noise indicator (IBP) computed as the instantaneous phase (PIP) of the time integral (SAP) of a wideband analysis signal (SAL), which presents fast oscillations when noise is present

b7) a third noise indicator (IBF) computed as the instantaneous frequency (FIP) of the time integral (SAP) of a wideband analysis signal (SAL), which presents fast oscillations when noise is present.

7. Method according to one of the claims 1 to 3, in which the indicators (IPX) of useful signal presence and signal to noise ratio (SNR) estimation comprise at least one of the following indicators:

b8) A first indicator of signal presence and signal to noise ratio estimation (ISP), equal to the variance during the observation duration of (DOB) samples of the wideband analysis signal (SAL) of the difference of instantaneous phase (PIQ) between, on one side, the instantaneous phase (PIP) of the time integral of the signal and, on the other side, the instantaneous phase of the signal (PIS)

b9) A second indicator of signal presence and signal to noise ratio estimation (ISF), equal to the variance during the observation duration of (DOB) samples of the wideband analysis signal (SAL) of the difference of instantaneous frequency between, on one side, the instantaneous frequency (FIP) of the time integral of the signal (FIP) and, on the other side, the instantaneous frequency of the signal (FIS)

b.10) A third indicator of signal presence and signal to noise ratio estimation (ISA), computed as the quotient (QQA) of the following amplitude quotients:

> Quotient (QAD) of instantaneous amplitudes of the time derivative of the signal (AID) and of the signal (AIS)
> Quotient (QAP) of instantaneous amplitudes of the time integral of the signal (AIP) and of the signal (AIS)

And for which the degree of temporal correlation with the two following signals:

b.10.a) the instantaneous frequency (FIP) of the time integral signal (SAP) of the wideband analysis signal (SAL),
b.10.b) one of the two following signals:

> the instantaneous frequency (FIS) of a wideband analysis signal (SAL)
> the instantaneous frequency (FID) of the time derivative (SAD) of a wideband analysis signal (SAL)

provides an indication of detectable signal presence and signal to noise ratio (SNR) of a wideband analysis signal (SAL) thanks to its following properties:

b.10.1) in the absence of a detectable signal, the quotient (QQA) of the amplitude quotients is not correlated to any of the instantaneous frequency signals previously mentioned in b.10.a) or b.10.b)
b.10.2) in the presence of a detectable signal, and in the absence of significant noise, the quotient (QQA) of the amplitude quotients is correlated with the three instantaneous frequency signals previously mentioned in b.10.a) or b.10.b)
b.10.3) in the presence of a detectable signal, and in the presence of significant noise, the quotient (QQA) of the amplitude quotients is correlated to the instantaneous frequency (FIP) of the time integral (SAP) of the wideband analysis signal (SAL), but not to the other two instantaneous frequency signals previously mentioned in b.10.a) or b.10.b).

8. Method according to claim 1, in which steps AS2) and AS3) are the following AS21) and AS31) steps:

- AS21) zero or more lowpass or bandpass frequency filtering operations,
- AS31) at least one complex Frequency Translation which brings the analysed frequency to an operating frequency adapted to compute the instantaneous Amplitude and to an operating frequency adapted to compute the instantaneous Phase and the instantaneous Frequency of the analysis signal.

9. Method according to claim 1 or 8, in which steps AS1), AS2) and AS3) (or AS11), AS21 and AS31), are implemented respectively by the following AS10), AS20) and AS30) steps:

- AS10) a serie of undersampling operations, each made of a frequency filtering lowpass around null frequency (F0) or bandpass around frequency (F4) equal to one quarter of sampling frequency (FE), and a corresponding suppression of samples
- AS20) at least one frequency filtering operation lowpass around null frequency (F0) or bandpass around frequency (F4) equal to one quarter of sampling frequency (FE), not followed by a corresponding suppression of samples, implemented with a frequency filter whose useful duration (DUF) expressed as a number of samples is less than or equal to 12, and advantageously equal to 8, and whose bandwidth fills at least 30% of the spectrum of the output signal of step AS1)
- AS30) zero or more complex Frequency Translation which brings the analysed frequency to a frequency (F4) equal to the quarter of the sampling frequency (FE), adapted to compute the instantaneous Amplitude, the instantaneous Phase and the instantaneous Frequency of the analysis signal.

10. Method according to claim 9, in which step AS20) is implemented by the following AS200) step:
AS200) A bandpass frequency filtering operation with center frequency the frequency (F4) equal to one quarter of the sampling frequency (FE), not followed by a corresponding sample suppression, implemented by a Sliding Fourier Transform of length 12 with a Hann window, restricted to the frequency channel centered on the frequency (F4) equal to one quarter of the sampling frequency (FE)

11. Method according to any of the previous claims, in which duration of observation of (DOB) samples of the wideband analysis signal (SAL) is on the order of 10 to 20 samples of the wideband analysis signal (SAL).

12. Method according to claim 6, used for processing voice signals, allowing to detect the fundamental frequency (FFV) of the signal by detecting the following elements:

> VA) significant amplitude peaks of at least one of the following indicators:

V1) the indicator (IPA) of detection of peaks of amplitude modulation
V2) the indicator (IPX) of signal presence probability
V3) indicator (IFM) of the frequency modulation

> VB) the time concordance for the appearance of amplitude peaks of previous indicators

13. Method according to any of the previous claims, applied to each of the at least one elementary signals (SLM) of dimension 1, resulting from the decomposition of a multi dimensional initial signal (SIM), with a number (NDI) of dimensions, into a number (NSD) of elementary signals (SLM) out of which at least one has dimension 1.

14. **Device for analysis** of a signal (SI) and for detecting a plurality (NFA) of analysed frequencies (FA) within said initial signal (SI) possibly significantly noisy, sampled at a constant sampling frequency (FE), said device comprising a computing platform (PC) receiving an initial signal (SI) representative of a wave that propagates in a physical medium, and being adapted to implement one of the previously mentioned methods.

15. Device according to claim 14, the device further comprising a sensor generating said initial signal (SI) from said wave.

16. Device according to claim 14 or claim 15, in which the platform (PC) is adapted to fixed point computations.

**FIG. 1**

FIG. 2

# FIG. 3

## FIG. 4

## FIG. 5

**FIG. 6**

**FIG. 7**

FIG. 8

FIG. 9

FIG. 10

**FIG. 11**

(AIS)  (FDS)  (AEL) (FDD)

X: 494
Y: 141.5

X: 434
Y: 17.79

X: 309
Y: 171.6

X: 307
Y: -49.97

X: 209
Y: 7.856

X: 137
Y: 140.8

**FIG. 12** (AIS) (FDS) (AEL) (FDD)

FIG. 13 (AIS) (FDS) (AEL) (FDD)

**FIG. 14** (AIS) (FDS) (AEL) (FDD)

FIG. 15

## FIG. 16

Magnitude (dB) and Phase Responses

## FIG. 17

Magnitude (dB) and Phase Responses

## FIG. 18

## FIG. 19

## FIG. 20

## FIG. 21

## FIG. 22

## FIG. 23

## FIG. 24

**FIG. 25**

**FIG. 26**

**FIG. 27**

**FIG. 28**

**FIG. 29**

**FIG. 30**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- BE 2011000052 W

**Littérature non-brevet citée dans la description**

- **RICHARD G. LYONS.** Understanding Digital Signal Processing. Prentice Hall, 2011
- Short Time Fourier Transform. **NAWAB ; QUATIERI.** Advanced Topics in Signal Processing. Prentice Hall, 1988
- **BOUALEM BOASHASH.** Estimating and Interpreting the Instantaneous Frequency of a Signal---Part 1: Fundamentals. *Proceedings of the IEEE,* Avril 1992, vol. 80 (4), 520-538
- **SYLVAIN MARCHAND ; PHILIPPE DEPAILLE.** Generalization of the derivative analysis method to non stationary sinusoidal modeling. *Proceedings of the 11th conférence of Digital Audio Effects (DAFx-08),* Septembre 2008
- **SYLVAIN MARCHAND.** The simplest analysis method for non stationary sinusoidal modeling. *Proceedings of the 15th conférence of Digital Audio Effects (DAFx-12),* Septembre 2012
- **FRANÇOIS AUGER ; ERIC CHASSANDE MOTIN ; PATRICK FLANDRIN.** On Phase Magnitude Relationships in the Short Time Fourier Transform. *IEEE Signal Processing Letters,* Janvier 2012, vol. 6 (1
- **LAWRENCE RABINER ; RONALD CROCHIERE.** A novel implementation for Narrow band FIR digital filters. *IEEE Transactions on Acoustics, Speech and Signal Processing,* Octobre 1975, vol. ASSP-23 (5
- *Pitch Détection Algorithm,* 24 Février 2014

- **THOMAS F. QUATIERI.** Discrete Time Speech Signal Processing. 2002
- **FREDERIC J. HARRIS.** On the use of Windows for Harmonic Analysis with the Discrète Fourier Transform. *Proceedings of the IEEE,* Janvier 1978, vol. 66 (1), 51-83
- **BOUALEM BOASHASH.** Estimating and Interpreting the Instantaneous Frequency of a Signal---Part 2: Algorithns and Applications. *Proceedings of the IEEE,* Avril 1992, vol. 80 (4), 540-568
- **JAMES B. TSUI.** Digital techniques for wideband receivers. 2004
- **BOUALEM BOASHASH.** *Estimating and Interpreting the Instantaneous Frequency of a Signal---Part 1: Fundamentals*
- **RICHARD G. LYONS.** Understanding Digital Signal Processing. 2011
- **FREDERIC J. HARRIS.** On the use of Windows for Harmonic Analysis with the Discrète Fourier Transform
- Short Time Fourier Transform. Advanced Topics in Signal Processing
- **LAWRENCE RABINER ; RONALD CROCHIERE.** *A novel implementation for Narrow band FIR digital filters*
- **SYLVAIN MARCHAND.** *The simplest analysis method for non stationary sinusoidal modeling*
- **BOUALEM BOASHASH.** *Estimating and Interpreting the Instantaneous Frequency of a Signal---Part 2: Algorithns and Applications*